(19) Europäisches Patentamt
European Patent Office
Office européen des brevets

(11) EP 2 984 152 B2

(12) NEUE EUROPÄISCHE PATENTSCHRIFT
Nach dem Einspruchsverfahren

(45) Veröffentlichungstag und Bekanntmachung des Hinweises auf die Entscheidung über den Einspruch:
**05.01.2022 Patentblatt 2022/01**

(45) Hinweis auf die Patenterteilung:
**25.04.2018 Patentblatt 2018/17**

(21) Anmeldenummer: **14711162.9**

(22) Anmeldetag: **18.03.2014**

(51) Int Cl.:
***C09K 11/06*** (2006.01) ***H01L 51/00*** (2006.01)
***H01L 27/32*** (2006.01) ***H01L 33/00*** (2010.01)
***H01L 51/50*** (2006.01) ***H01L 51/56*** (2006.01)

(86) Internationale Anmeldenummer:
**PCT/EP2014/000742**

(87) Internationale Veröffentlichungsnummer:
**WO 2014/166586 (16.10.2014 Gazette 2014/42)**

# (54) ORGANISCHE ELEKTROLUMINESZENZVORRICHTUNG

ORGANIC ELECTROLUMINESCENT DEVICE

DISPOSITIF ÉLECTROLUMINESCENT ORGANIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.04.2013 EP 13001796**

(43) Veröffentlichungstag der Anmeldung:
**17.02.2016 Patentblatt 2016/07**

(73) Patentinhaber: **Merck Patent GmbH**
**64293 Darmstadt (DE)**

(72) Erfinder:
- **STOESSEL, Philipp**
  **60487 Frankfurt am Main (DE)**
- **PFLUMM, Christof**
  **64291 Darmstadt (DE)**
- **PARHAM, Amir Hossain**
  **60486 Frankfurt am Main (DE)**
- **JATSCH, Anja**
  **60489 Frankfurt am Main (DE)**
- **KAISER, Joachim**
  **64289 Darmstadt (DE)**

(56) Entgegenhaltungen:
**EP-A1- 1 956 022** **EP-A1- 2 080 762**
**WO-A1-2011/073149** **WO-A1-2013/011954**
**DE-A1-102009 009 277** **DE-A1-102009 023 155**

- **HIROKI UOYAMA ET AL: "Highly efficient organic light-emitting diodes from delayed fluorescence", NATURE, Bd. 492, Nr. 7428, 12. Dezember 2012 (2012-12-12), Seiten 234-238, XP055048388, ISSN: 0028-0836, DOI: 10.1038/nature11687**

Bemerkungen:
Die Akte enthält technische Angaben, die nach dem Eingang der Anmeldung eingereicht wurden und die nicht in dieser Patentschrift enthalten sind.

EP 2 984 152 B2

## Beschreibung

Die vorliegende Erfindung betrifft organische Elektrolumineszenzvorrichtungen, welche in der emittierenden Schicht ein lumineszentes Material mit einem geringen Singulett-Triplett-Abstand und in der Elektronentransportschicht ein Material mit einem LUMO ≤ -2.55 eV enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei insbesondere auch metallorganische Iridium- und Platinkomplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Trotz der guten Ergebisse, die mit metallorganischen Iridum- und Platinkomplexen erzielt werden, weisen diese jedoch auch eine Reihe von Nachteilen auf: So handelt es sich bei Iridium und Platin um seltene und teure Metalle. Es wäre daher zur Ressourcenschonung wünschenswert, die Verwendung dieser seltenen Metalle vermeiden zu können. Weiterhin weisen derartige Metallkomplexe teilweise eine geringere thermische Stabilität auf als rein organische Verbindungen, insbesondere bei der Sublimation, so dass auch aus diesem Grund die Verwendung rein organischer Verbindungen vorteilhaft wäre, sofern diese zu vergleichbar guten Effizienzen führen. Weiterhin sind blau, insbesondere tiefblau phosphoreszierende Iridium- bzw. Platinemitter mit hoher Effizienz und Lebensdauer technisch nur schwierig zu verwirklichen, so dass es auch hier Verbesserungsbedarf gibt. Weiterhin gibt es insbesondere bei der Lebensdauer phosphoreszierender OLEDs, welche Ir- oder Pt-Emitter enthalten, Verbesserungsbedarf, wenn die OLED bei höherer Temperatur betrieben wird, wie dies für einige Anwendungen erforderlich ist.

Eine alternative Entwicklung ist die Verwendung von Emittern, die thermisch aktivierte verzögerte Fluoreszenz (thermally activated delayed fluorescence, TADF) zeigen (z. B. H. Uoyama et al., Nature 2012, Vol. 492, 234 und WO2013/011954 A1 & EP2 733762 A1). Hier handelt es sich um organische Materialien, bei denen der energetische Abstand zwischen dem niedrigsten Triplettzustand $T_1$ und dem ersten angeregten Singulettzustand $S_1$ so klein ist, dass dieser Energieabstand kleiner oder im Bereich der thermischen Energie liegt. Aus quantenstatistischen Gründen entstehen bei elektronischer Anregung in der OLED die angeregten Zustände zu 75 % im Triplettzustand und zu 25 % im Singulettzustand. Da rein organische Moleküle üblicherweise nicht aus dem Triplettzustand emittieren können, können 75 % der angeregten Zustände nicht für die Emission genutzt werden, wodurch prinzipiell nur 25 % der Anregungsenergie in Licht umgewandelt werden können. Ist nun jedoch der energetische Abstand zwischen dem niedrigsten Triplettzustand und dem niedrigsten angeregten Singulettzustand nicht oder nicht wesentlich größer als die thermische Energie, die durch kT beschrieben wird, so ist aus dem Triplettzustand durch thermische Anregung der erste angeregte Singulettzustand des Moleküls zugänglich und kann thermisch besetzt werden. Da dieser Singulettzustand ein emissiver Zustand ist, aus dem Fluoreszenz möglich ist, kann dieser Zustand zur Erzeugung von Licht verwendet werden. Somit ist prinzipiell die Umwandlung von bis zu 100 % der elektrischen Energie in Licht möglich bei der Verwendung rein organischer Materialien als Emitter. So wird im Stand der Technik eine externe Quanteneffizienz von mehr als 19 % beschrieben, was in derselben Größenordnung wie für phosphoreszierende OLEDs liegt. Somit ist es mit derartigen rein organischen Materialien möglich, sehr gute Effizienzen zu erreichen und gleichzeitig die Verwendung seltener Metalle wie Iridium oder Platin zu vermeiden. Weiterhin ist es mit solchen Materialien auch möglich, hocheffiziente blau emittierende OLEDs zu erzielen.

Im Stand der Technik wird angrenzend an die emittierende Schicht, die thermisch aktivierte verzögerte Fluoreszenz zeigt, die Verwendung verschiedener elektronenleitender Verbindungen beschrieben, beispielsweise Benzimidazolderivate, wie TPBi (H. Uoyama et al., Nature 2012, 492, 234), Pyridinderivate (Mehes et al., Angew. Chem. Int. Ed. 2012, 51, 11311; Endo et al., Appl. Phys. Lett. 2011, 98, 083302/1 oder WO 2013/011954) oder Phenanthrolinderivate (Nakagawa et al., Chem. Commun. 2012, 48, 9580 oder WO 2011/070963). Diesen elektronenleitenden Materialien ist gemeinsam, dass alle ein LUMO von -2.51 eV oder höher aufweisen.

Generell gibt es bei organischen Elektrolumineszenzvorrichtungen, die Emission nach dem TADF-Mechanismus zeigen, noch weiteren Verbesserungsbedarf, insbesondere im Hinblick auf Effizienz, Spannung und Lebensdauer. Die der vorliegenden Erfindung zugrunde liegende technische Aufgabe ist somit die Bereitstellung von OLEDs, deren Emission auf TADF basiert und die verbesserte Eigenschaften aufweisen, insbesondere in Bezug auf eine oder mehrere der oben genannten Eigenschaften.

Überraschend wurde gefunden, dass organische Elektrolumineszenzvorrichtungen gemäss Anspruch 1, die in der emittierenden Schicht ein organisches TADF-Molekül aufweisen und auf Kathodenseite angrenzend an diese Schicht eine oder mehrere Schichten aufweisen, die ein elektronenleitenden Material mit einem LUMO von ≤ -2.55 eV enthalten, diese Aufgabe lösen und zu Verbesserungen der organischen Elektrolumineszenzvorrichtung führen. Derartige organische Elektrolumineszenzvorrichtungen sind daher der Gegenstand der vorliegenden Erfindung.

Gegenstand der vorliegenden Erfindung ist eine organische Elektrolumineszenzvorrichtung gemäss Anspruch 1, enthaltend Kathode, Anode und emittierende Schicht, die mindestens eine lumineszente organische Verbindung

enthält, die einen Abstand zwischen dem niedrigsten Triplettzustand $T_1$ und dem ersten angeregten Singulettzustand $S_1$ von ≤ 0.15 eV aufweist, dadurch gekennzeichnet, dass die Elektrolumineszenzvorrichtung kathodenseitig der emittierenden Schicht eine oder mehrere Elektronentransportschichten enthält, wobei alle Elektronentransportschichte mindestens eine Verbindung mit einem LUMO ≤ -2.55 eV enthalten.

Eine organische Elektrolumineszenzvorrichtung im Sinne der vorliegenden Erfindung enthält Anode, Kathode, emittierende Schicht, die zwischen Anode und Kathode angeordnet ist, und mindestens eine Elektronentransportschicht. Eine Elektronentransportschicht im Sinne der vorliegenden Erfindung ist eine Schicht, die zwischen der Kathode oder der Elektroneninjektionsschicht und der emittierenden Schicht angeordnet ist. Eine Elektroneninjektionsschicht im Sinne der vorliegenden Erfindung ist eine Schicht, die direkt an die Kathode angrenzt und die eine Schichtdicke von nicht mehr als 5 nm, bevorzugt 0.5 bis 5 nm, aufweist.

Dabei enthalten erfindungsgemäß alle Elektronentransportschichten, also alle Schichten, die zwischen der Kathode bzw., wenn vorhanden, der Elektroneninjektionsschicht und der emittierenden Schicht vorliegen, mindestens eine Verbindung mit einem LUMO ≤ -2.55 eV.

Im Folgenden wird die lumineszente organische Verbindung, die einen Abstand zwischen dem niedrigsten Triplettzustand $T_1$ und dem ersten angeregten Singulettzustand $S_1$ von ≤ 0.15 eV aufweist, näher beschrieben. Hierbei handelt es sich um eine Verbindung, die TADF (thermally activated delayed fluorescence) zeigt. Diese Verbindung wird in der folgenden Beschreibung mit "TADF-Verbindung" abgekürzt.

Eine organische Verbindung im Sinne der vorliegenden Erfindung ist eine kohlenstoffhaltige Verbindung, die keine Metalle enthält. Insbesondere ist die organische Verbindung aus den Elementen C, H, D, B, Si, N, P, O, S, F, Cl, Br und I aufgebaut.

Eine lumineszente Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren. Dabei weist die Verbindung bevorzugt eine Lumineszenzquanteneffizienz von mindestens 40 % auf, besonders bevorzugt von mindestens 50 %, ganz besonders bevorzugt von mindestens 60 % und insbesondere bevorzugt von mindestens 70 %. Dabei wird die Lumineszenzquanteneffizienz bestimmt in einer Schicht in Mischung mit dem Matrixmaterial, wie sie in der organischen Elektrolumineszenzvorrichtung verwendet werden soll. Wie die Bestimmung der Lumineszenzquantenausbeute im Sinne der vorliegenden Erfindung durchgeführt wird, ist im Beispielteil ausführlich allgemein beschrieben.

Weiterhin ist es bevorzugt, wenn die TADF-Verbindung eine kurze Abklingzeit aufweist. Dabei ist die Abklingzeit bevorzugt ≤ 50 μs. Wie die Bestimmung der Abklingzeit im Sinne der vorliegenden Erfindung durchgeführt wird, ist im Beispielteil ausführlich allgemein beschrieben.

Die Energie des niedrigsten angeregten Singulettzustands ($S_1$) und des niedrigsten Triplettzustands ($T_1$) werden durch quantenchemische Rechnung bestimmt. Wie diese Bestimmung im Sinne der vorliegenden Erfindung durchgeführt wird, ist im Beispielteil ausführlich allgemein beschrieben.

Wie oben beschrieben, darf der Abstand zwischen $S_1$ und $T_1$ maximal 0.15 eV betragen, damit es sich bei der Verbindung um eine TADF-Verbindung im Sinne der vorliegenden Erfindung handelt. Bevorzugt ist der Abstand zwischen $S_1$ und $T_1$ ≤ 0.10 eV, besonders bevorzugt ≤ 0.08 eV, ganz besonders bevorzugt ≤ 0.05 eV.

Bei der TADF-Verbindung handelt es sich bevorzugt um eine aromatische Verbindung, die sowohl Donor- wie auch Akzeptorsubstituenten aufweist, wobei das LUMO und das HOMO der Verbindung räumlich nur schwach überlappen. Was unter Donor- bzw. Akzeptorsubstituenten verstanden wird, ist dem Fachmann prinzipiell bekannt. Geeignete Donorsubstituenten sind insbesondere Diaryl- bzw. -heteroarylaminogruppen sowie Carbazolgruppen bzw. Carbazolderivate, die jeweils bevorzugt über N an die aromatische Verbindung gebunden sind. Dabei können diese Gruppen auch weiter substituiert sein. Geeignete Akzeptorsubstituenten sind insbesondere Cyanogruppen, aber auch beispielsweise elektronenarme Heteroarylgruppen, die auch weiter substituiert sein können.

Beispiele für geeignete Moleküle, die TADF zeigen, sind die in der folgenden Tabelle aufgeführten Strukturen.

| | | |
|---|---|---|
| 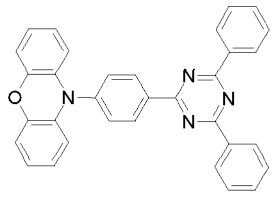 | 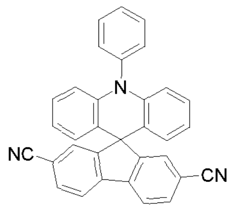 | 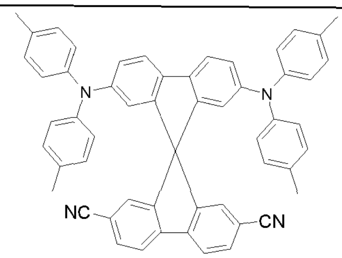 |
| 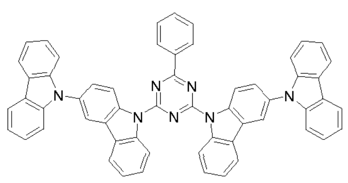 | 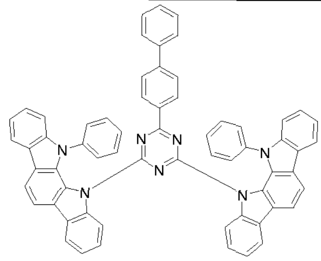 | 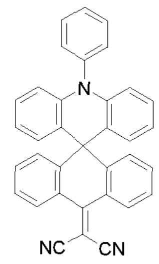 |
| 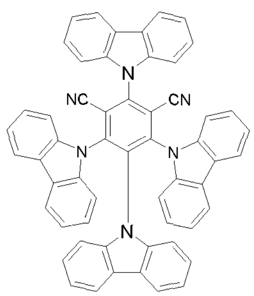 | 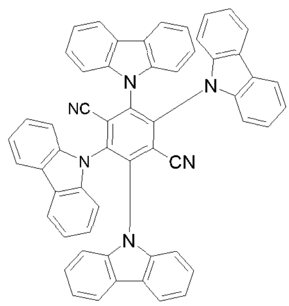 | 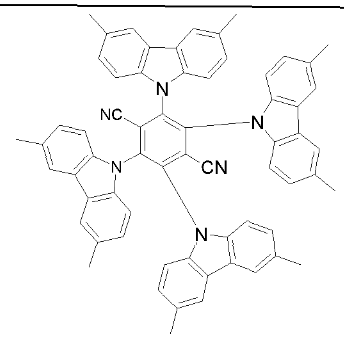 |
| 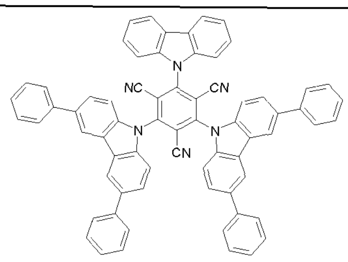 | 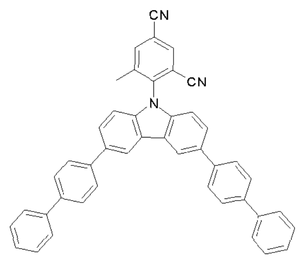 | 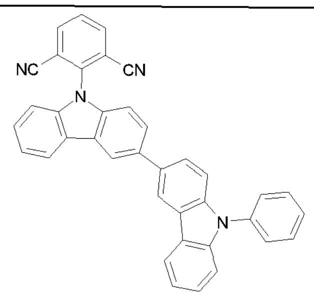 |
| 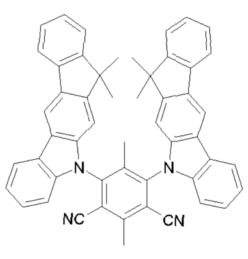 | 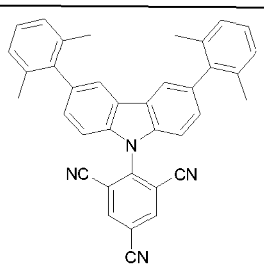 | 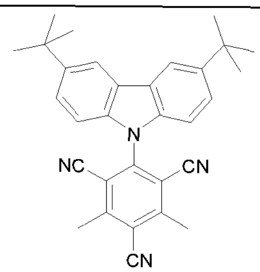 |
| 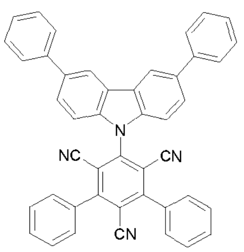 | 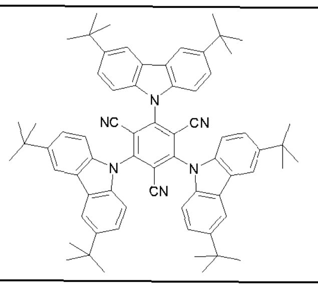 | 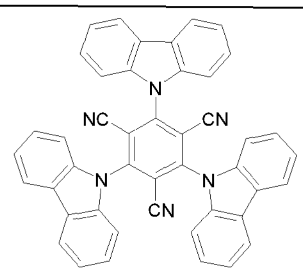 |

Die TADF-Verbindung liegt in der emittierenden Schicht bevorzugt in einer Matrix vor. Dabei trägt das Matrixmaterial nicht oder nicht wesentlich zur Emission der Mischung bei.

Um Exziplexbildung in der emittierenden Schicht zu vermeiden, ist es bevorzugt, wenn für LUMO(TADF), also das LUMO der TADF-Verbindung, und das HOMO(Matrix) gilt:

$$LUMO(TADF) - HOMO(Matrix) > S_1(TADF) - 0.4\ eV;$$

besonders bevorzugt:

$$LUMO(TADF) - HOMO(Matrix) > S_1(TADF) - 0.3\ eV;$$

und ganz besonders bevorzugt:

$$LUMO(TADF) - HOMO(Matrix) > S_1(TADF) - 0.2\ eV.$$

Dabei ist $S_1$(TADF) der erste angeregte Singulettzustand $S_1$ der TADF-Verbindung.

Damit die TADF-Verbindung die emittierende Verbindung in der Mischung der emittierenden Schicht ist, ist es bevorzugt, dass die niedrigste Triplettenergie der Matrix maximal 0.1 eV niedriger ist als die Triplettenergie des Moleküls, welches TADF zeigt. Insbesondere bevozugt ist $T_1$ (Matrix) $\geq$ $T_1$ (TADF). Besonders bevorzugt gilt: $T_1$ (Matrix) - $T_1$ (TADF) $\geq$ 0.1 eV, ganz besonders bevorzugt $T_1$ (Matrix) - $T_1$ (TADF) $\geq$ 0.2 eV. Dabei steht $T_1$ (Matrix) für die niedrigste Triplettenergie der Matrixverbindung und $T_1$ (TADF) für die niedrigste Triplettenergie der Verbindung, die TADF zeigt. Dabei wird die Triplettenergie der Matrix durch quantenchemische Rechnung bestimmt, so wie das hinten im Beispielteil allgemein für die Verbindungen, die TADF zeigen, beschrieben ist.

Beispiele für geeignete Matrixmaterialien sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarbazolylbiphenyl), m-CBP oder die in WO 2005/039246, US 2005/0069729, JP 2004/288381, EP 1205527, WO 2008/086851 oder US 2009/0134784 offenbarten Carbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, oder verbrückte Carbazolderivate, z. B. gemäß US 2009/0136779, WO 2010/050778, WO 2011/042107 oder WO 2011/088877.

Im Folgenden wird die erfindungsgemäße Elektronentransportschicht genauer beschrieben.

Wie oben bereits beschrieben, liegen eine oder mehrere Elektronentransportschichten vor, wobei jede dieser Schichten mindestens ein Material mit einem LUMO $\leq$ -2.55 eV enthält.

In einer bevorzugten Ausführungsform der Erfindung liegen eine, zwei oder drei solcher Elektronentransportschichten vor, besonders bevorzugt eine oder zwei Elektronentransportschichten.

Dabei beträgt die Schichtdicke der Elektronentransportschichten bevorzugt insgesamt zwischen 10 und 100 nm, besonders bevorzugt zwischen 15 und 90 nm, ganz besonders bevorzugt zwischen 20 und 70 nm.

Wie oben beschrieben, enthält die Elektronentransportschicht mindestens eine elektronentransportierende Verbindung, die ein LUMO $\leq$ -2.55 eV aufweist. Bevorzugt ist das LUMO $\leq$ -2.60 eV, besonders bevorzugt $\leq$ -2.65 eV, ganz besonders bevorzugt $\leq$ -2.70 eV. Dabei ist das LUMO das niedrigste unbesetzte Molekülorbital (lowest unoccupied molecular orbital). Der Wert des LUMO der Verbindung wird durch quantenchemische Rechnung bestimmt, wie hinten im Beispielteil allgemein beschrieben.

Damit die Emission der TADF-Verbindung nicht an der direkt angrenzenden Elektronentransportschicht gelöscht wird, ist es bevorzugt, dass die niedrigste Triplettenergie dieser Elektronentransportschicht maximal 0.1 eV niedriger ist als die Triplettenergie des Moleküls, welches TADF zeigt. Insbesondere bevozugt ist $T_1$(ETL) $\geq$ $T_1$(TADF). Besonders bevorzugt gilt: $T_1$(ETL) - $T_1$(TADF) $\geq$ 0.1 eV, ganz besonders bevorzugt $T_1$(ETL) - $T_1$(TADF) $\geq$ 0.2 eV. Dabei steht $T_1$(ETL) für die niedrigste Triplettenergie der Elektronentransportschicht, die direkt an die emittierende Schicht angrenzt, und $T_1$(TADF) für die niedrigste Triplettenergie der TADF-Verbindung. Dabei wird die Triplettenergie der Materialien der Elektronentransportschicht durch quantenchemische Rechnung bestimmt, so wie das hinten im Beispielteil allgemein beschrieben ist. Wenn die Elektronentransportschicht mehr als eine Verbindung enthält, gilt die Bedingung für die Triplettenergie bevorzugt für jede der Verbindungen.

Die oben genannten Bedingungen für die Triplettenergie sind nur für die direkt an die emittierende Schicht

angrenzende Elektronentransportschicht bevorzugt. Sind weitere Elektronentransportschichten vorhanden, die kathodenseitig der direkt an die emittierende Schicht angrenzende Elektronentransportschicht angeordnet sind, so ist für diese weiteren Elektronentransportschichten die Triplettenergie nicht von Bedeutung, so dass hier auch Elektronentransportmaterialien mit einer geringeren Triplettenergie gewählt werden können, beispielsweise Anthracenderivate.

Die erfindungsgemäße auf Kathodenseite direkt an die emittierende Schicht angrenzende Elektronentransportschicht kann auch als Lochblockierschicht wirken, kann also außer elektronentransportierenden Eigenschaften auch gleichzeitig lochblockierende Eigenschaften aufweisen. Dies ist abhängig von der Lage des HOMO-Niveaus der Schicht. Insbesondere wirkt die Schicht dann als Lochblockierschicht, wenn für das HOMO der Schicht gilt: HOMO(EML) - HOMO(ETL) > 0.2 eV, bevorzugt HOMO(EML) - HOMO(ETL) > 0.3 eV. HOMO(ETL) ist das HOMO des Materials der Elektronentransportschicht. Besteht diese Schicht aus mehreren Materialien, so ist HOMO(ETL) das am höchsten liegende HOMO dieser Materialien. HOMO(EML) ist das HOMO des Materials der emittierenden Schicht. Besteht diese Schicht aus mehreren Materialien, so ist HOMO(EML) das am höchsten liegende HOMO dieser Materialien. Dabei wird das HOMO (highest occupied molecular orbital) jeweils durch quantenchemische Rechnungen bestimmt, wie hinten im Beispielteil allgemein erläutert.

Zur Klarstellung wird hier nochmals betont, dass es sich bei den Werten für HOMO und LUMO definitionsgemäß um negative Zahlenwerte handelt. Bei dem am höchsten liegenden HOMO bzw. dem höchsten HOMO handelt es sich daher um das betragsmäßig kleinste HOMO, und bei dem am tiefsten liegenden LUMO bzw. dem tiefsten LUMO handelt es sich um das betragsmäßig größte LUMO.

Die erfindungsgemäße Elektronentransportschicht kann als Reinschicht vorliegen, d. h. nur aus einer Verbindung bestehen, die dann ein LUMO ≤ -2.55 eV aufweist. Die Schicht kann auch als Mischung vorliegen, wobei dann mindestens eine der Verbindungen ein LUMO ≤ -2.55 eV aufweist. Diese Verbindung liegt in der Schicht in einem Anteil von bevorzugt mindestens 30 Vol.-%, besonders bevorzugt mindestens 50 Vol.-%, ganz besonders bevorzugt mindestens 70 Vol.-% vor. Insbesondere bevorzugt liegt die Schicht als Reinschicht vor, d. h. sie besteht nur aus einer Verbindung, die ein LUMO ≤ -2.55 eV aufweist. Wenn die Elektronentransportschicht eine Mischung aus zwei oder mehr Materialien enthält, ist es bevorzugt, wenn jedes dieser Materialien ein LUMO ≤ -2.55 eV aufweist.

Geeignete Elektronentransportmaterialien zur Verwendung in der erfindungsgemäßen Elektronentransportschicht sind ausgewählt aus den Stoffklassen der Triazine, der Pyrimidine, der Lactame, der Metallkomplexe, insbesondere der Be-, Zn- bzw. Al-Komplexe, der aromatischen Ketone, der aromatischen Phosphinoxide, der Azaphosphole, der Azaborole, welche mit mindestens einem elektronenleitenden Substituenten substituiert sind, der Benzimidazole und der Chinoxaline. Dabei ist es erfindungswesentlich, dass diese Materialien ein LUMO von ≤ -2.55 eV aufweisen. Viele Derivate der oben genannten Stoffklassen weisen ein solches LUMO auf, so dass diese Stoffklassen generell als geeignet gelten können, auch wenn einzelne Verbindungen dieser Stoffklassen möglicherweise ein LUMO > -2.55 eV aufweisen. Erfindungsgemäß werden jedoch nur solche elektronenleitenden Materialien eingesetzt, die ein LUMO ≤ -2.55 eV aufweisen. Es ist dem Fachmann ohne erfinderisches Zutun möglich, geeignete Materialien für die erfindungsgemäße Elektronentransportschicht auszuwählen.

Wenn das Elektronentransportmaterial in der erfindungsgemäßen Elektronentransportschicht eine Triazin- oder Pyrimidinverbindung ist, dann ist diese Verbindung bevorzugt ausgewählt aus den Verbindungen der folgenden Formeln (1) bzw. (2),

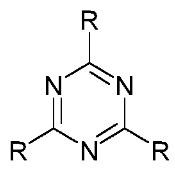

Formel (1)

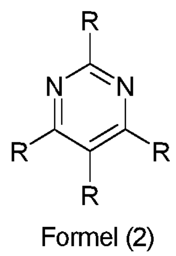

Formel (2)

wobei für die verwendeten Symbole gilt:

R ist bei jedem Auftreten gleich oder verschieden ausgewählt aus der Gruppe bestehend aus H, D, F, Cl, Br, I, CN, $NO_2$, $N(Ar)_2$, $N(R^1)_2$, C(=O)Ar, $C(=O)R^1$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen

Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, C≡C, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können.

Benachbarte Substituenten im Sinne der vorliegenden Anmeldung sind Substituenten, die entweder an dasselbe Kohlenstoffatom gebunden sind oder die an Kohlenstoffatome gebunden sind, die wiederum direkt aneinander gebunden sind.

Eine Arylgruppe im Sinne dieser Erfindung enthält 6 bis 60 C-Atome; eine Heteroarylgruppe im Sinne dieser Erfindung enthält 2 bis 60 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte (anellierte) Aryl- oder Heteroarylgruppe, beispielsweise Naphthalin, Anthracen, Phenanthren, Chinolin, Isochinolin, etc., verstanden. Miteinander durch Einfachbindung verknüpfte Aromaten, wie zum Beispiel Biphenyl, werden dagegen nicht als Aryl- oder Heteroarylgruppe, sondern als aromatisches Ringsystem bezeichnet.

Ein aromatisches Ringsystem im Sinne dieser Erfindung enthält 6 bis 80 C-Atome im Ringsystem. Ein heteroaromatisches Ringsystem im Sinne dieser Erfindung enthält 2 bis 60 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit, wie z. B. ein C-, N- oder O-Atom, verbunden sein können. So sollen beispielsweise auch Systeme wie Fluoren, 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine kurze Alkylgruppe verbunden sind.

Im Rahmen der vorliegenden Erfindung werden unter einem aliphatischen Kohlenwasserstoffrest bzw. einer Alkylgruppe bzw. einer Alkenyl- oder Alkinylgruppe, die 1 bis 40 C-Atome enthalten kann, und in der auch einzelne H-Atome oder $CH_2$-Gruppen durch die oben genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl, Heptinyl oder Octinyl verstanden. Unter einer Alkoxygruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy und 2,2,2-Trifluorethoxy verstanden. Unter einer Thioalkylgruppe mit 1 bis 40 C-Atomen werden insbesondere Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden. Allgemein können Alkyl-, Alkoxy- oder Thioalkylgruppen gemäß der vorliegenden Erfindung geradkettig, verzweigt oder cyclisch sein, wobei eine oder mehrere nicht-benachbarte $CH_2$-Gruppen durch die oben genannten Gruppen ersetzt sein können; weiterhin können auch ein oder mehrere H-Atome durch D, F, Cl, Br, I, CN oder $NO_2$, bevorzugt F, Cl oder CN, weiter bevorzugt F oder CN, besonders bevorzugt CN ersetzt sein.

Unter einem aromatischen oder heteroaromatischen Ringsystem mit 5 - 30 bzw. 5 - 60 aromatischen Ringatomen, welches noch jeweils mit den oben genannten Resten R, $R^1$ oder $R^2$ substituiert sein kann, werden insbesondere Gruppen verstanden, die abgeleitet sind von Benzol, Naphthalin, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Gruppen, die abgeleitet sind von Kombinationen dieser Systeme.

In einer bevorzugten Ausführungsform der Verbindungen gemäß Formel (1) bzw. Formel (2) steht mindestens einer der Substituenten R für ein aromatisches oder heteroaromatisches Ringsystem. In Formel (1) stehen besonders bevorzugt alle drei Substituenten R für ein aromatisches oder heteroaromatisches Ringsystem, das jeweils durch einen oder mehrere Reste $R^1$ substituiert sein kann. In Formel (2) stehen besonders bevorzugt ein, zwei oder drei Substituenten R für ein aromatisches oder heteroaromatisches Ringsystem, das jeweils durch einen oder mehrere Reste $R^1$ substituiert sein kann, und die anderen Substituenten R stehen für H. Besonders bevorzugte Ausführungsformen sind somit die Verbindungen der folgenden Formeln (1a) bzw. (2a) bis (2d),

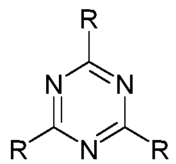
Formel (1a)

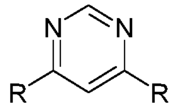
Formel (2a)

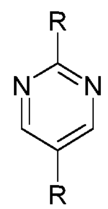
Formel (2b)

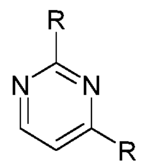
Formel (2c)

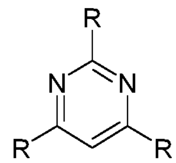
Formel (2d)

wobei R gleich oder verschieden für eine aromatisches oder heteroaromatisches Ringsystem mit 5 bis 60 aromatischen Ringatomen steht, das jeweils mit einem oder mehreren Resten $R^1$ substituiert sein kann, und $R^1$ die oben genannte Bedeutung aufweist.

Dabei sind bei Pyrimidin-Verbindungen die Verbindungen der Formeln (2a) und (2d) bevorzugt, insbesondere Verbindungen der Formel (2d).

Bevorzugte aromatische oder heteroaromatische Ringsysteme enthalten 5 bis 30 aromatische Ringatome, insbesondere 6 bis 24 aromatische Ringatome, und können durch einen oder mehrere Reste $R^1$ substituiert sein. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Diese Bevorzugung ist mit der höheren Triplettenergie derartiger Substituenten zu begründen. So ist es bevorzugt, wenn R beispielsweise keine Naphthylgruppen oder höhere kondensierte Arylgruppen aufweist und ebenso keine Chinolingruppen, Acridingruppen, etc.. Dagegen ist es möglich, dass R beispielsweise Carbazolgruppen, Dibenzofurangruppen, etc. aufweist, weil in diesen Strukturen keine 6-Ring-Aromaten bzw. -Heteroaromaten direkt aneinander ankondensiert sind.

Bevorzugte Substituenten R sind ausgewählt aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Anthracen, Phenanthren, Triphenylen, Pyren, Benzanthracen oder Kombinationen aus zwei oder drei dieser Gruppen, welche jeweils mit einem oder mehreren Resten $R^1$ substituiert sein können.

Insbesondere bevorzugt ist es, wenn mindestens eine Gruppe R ausgewählt ist aus den Strukturen der folgenden Formeln (3) bis (44),

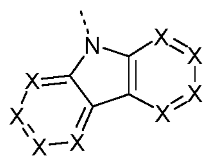
Formel (3)

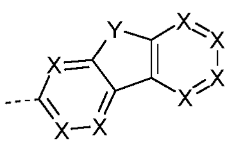
Formel (4)

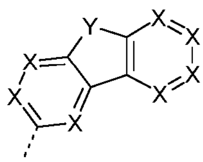
Formel (5)

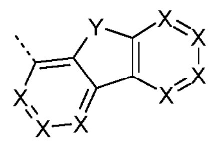
Formel (6)

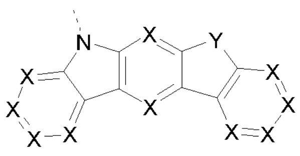
Formel (7)

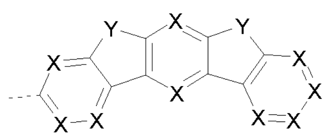
Formel (8)

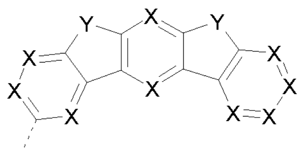
Formel (9)

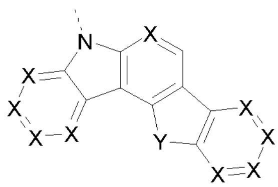
Formel (10)

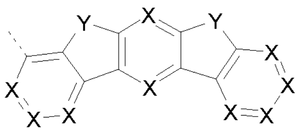
Formel (11)

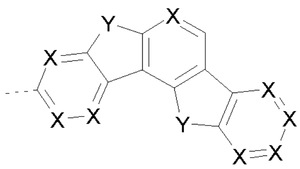
Formel (12)

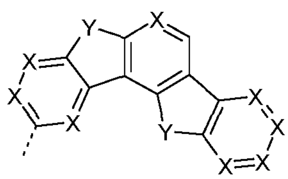
Formel (13)

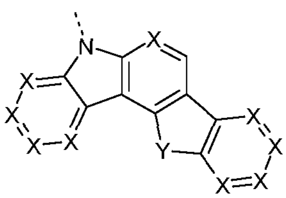
Formel (14)

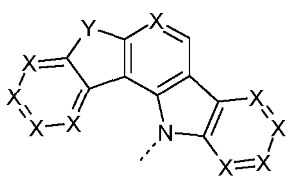
Formel (15)

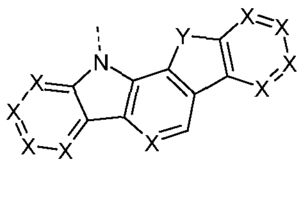
Formel (16)

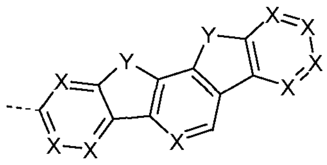
Formel (17)

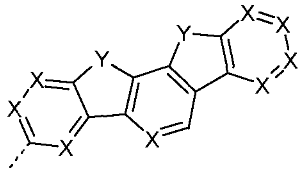
Formel (18)

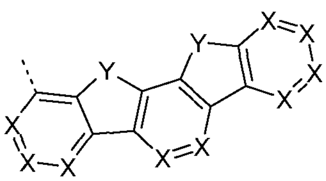
Formel (19)

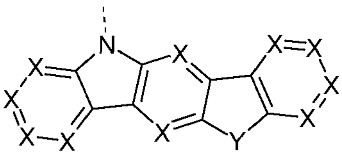
Formel (20)

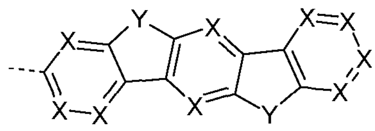
Formel (21)

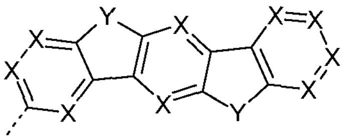
Formel (22)

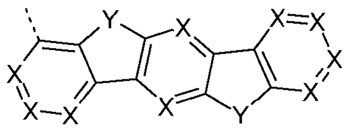
Formel (23)

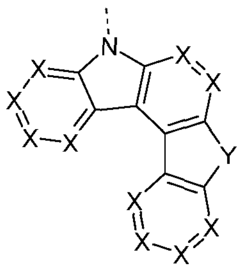
Formel (24)

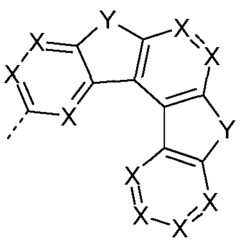
Formel (25)

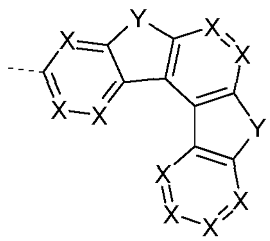
Formel (26)

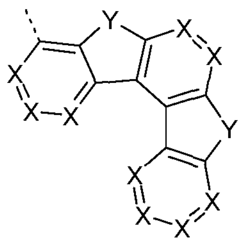
Formel (27)

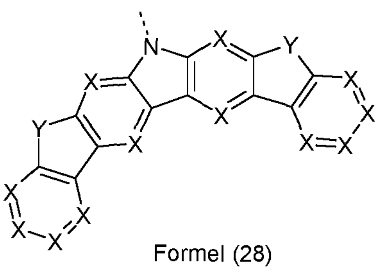
Formel (28)

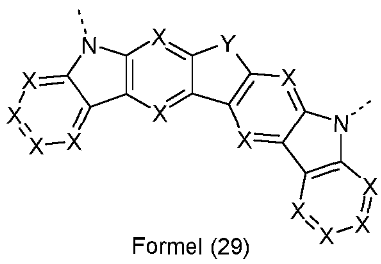
Formel (29)

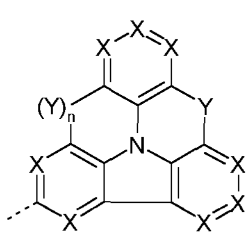

Formel (30)

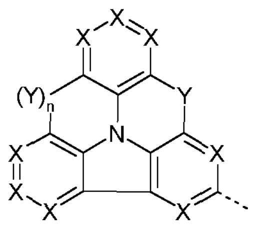

Formel (31)

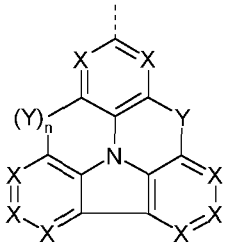

Formel (32)

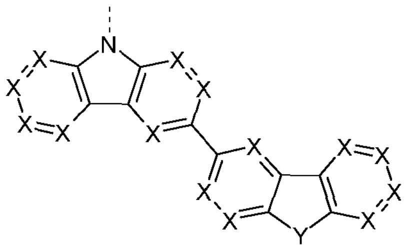

Formel (33)

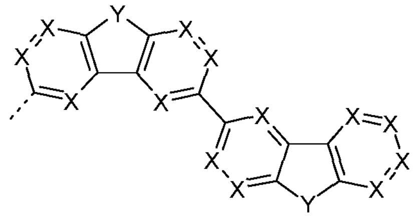

Formel (34)

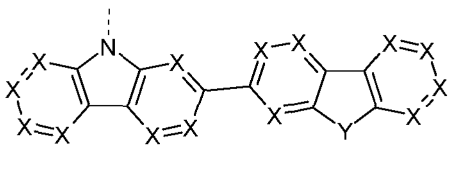

Formel (35)

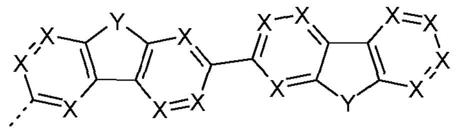

Formel (36)

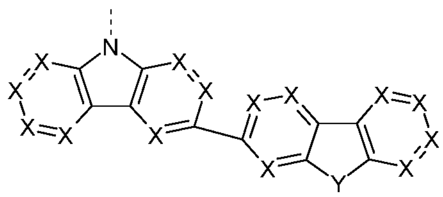

Formel (37)

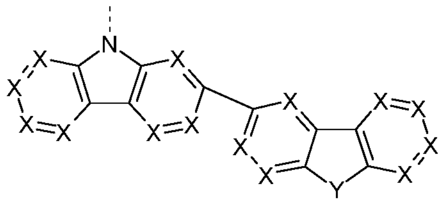

Formel (38)

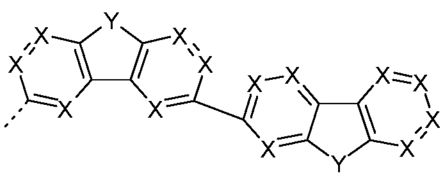

Formel (39)

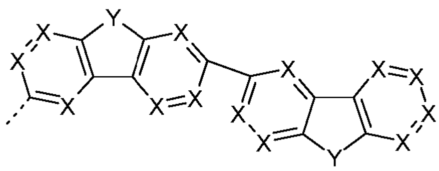

Formel (40)

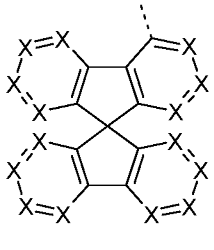

Formel (41)

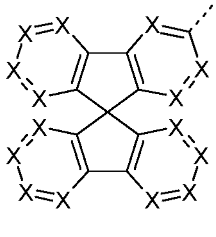

Formel (42)

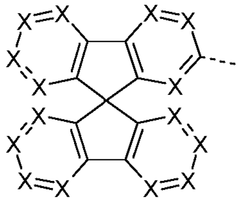

Formel (43)

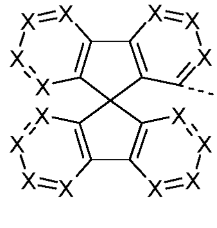

Formel (44)

wobei $R^1$ und $R^2$ die oben genannten Bedeutungen aufweisen, die gestrichelte Bindung die Bindung an die Gruppe der Formel (1) bzw. (2) darstellt und weiterhin gilt:

X ist bei jedem Auftreten gleich oder verschieden $CR^1$ oder N, wobei bevorzugt maximal 2 Symbole X pro Cyclus für N stehen;

Y ist bei jedem Auftreten gleich oder verschieden $C(R^1)_2$, $NR^1$, O oder S;

n ist 0 oder 1, wobei n gleich 0 bedeutet, dass an dieser Position keine Gruppe Y gebunden ist und an den entsprechenden Kohlenstoffatomen statt dessen Reste $R^1$ gebunden sind.

Der oben genannte und auch im Folgenden verwendete Begriff "pro Cyclus" bezieht sich im Sinne der vorliegenden Anmeldung auf jeden einzelnen in der Verbindung enthaltenen Ring, also auf jeden einzelnen 5-bzw. 6-Ring.

In bevorzugten Gruppen der oben genannten Formeln (3) bis (44) steht maximal ein Symbol X pro Cyclus für N. Besonders bevorzugt steht das Symbol X gleich oder verschieden bei jedem Auftreten für $CR^1$, insbesondere für CH.

Wenn die Gruppen der Formeln (3) bis (44) mehrere Gruppen Y aufweisen, so kommen hierfür alle Kombinationen aus der Definition von Y in Frage. Bevorzugt sind Gruppen der Formeln (3) bis (44), in denen eine Gruppe Y für $NR^1$ und die andere Gruppe Y für $C(R^1)_2$ steht oder in denen beide Gruppen Y für $NR^1$ stehen oder in denen beide Gruppen Y für O stehen.

In einer weiteren bevorzugten Ausführungsform der Erfindung steht mindestens eine Gruppe Y in den Formeln (3) bis (44) gleich oder verschieden bei jedem Auftreten für $C(R^1)_2$ oder für $NR^1$.

Weiterhin bevorzugt steht in diesen Gruppen der Substituent $R^1$, der direkt an ein Stickstoffatom gebunden ist, für ein aromatisches oder heteroaromatisches Ringsystem mit 5 bis 24 aromatischen Ringatomen, welches auch durch einen oder mehrere Reste $R^2$ substituiert sein kann. In einer besonders bevorzugten Ausführungsform steht dieser Substituent $R^1$ gleich oder verschieden bei jedem Auftreten für ein aromatisches oder heteroaromatisches Ringsystem mit 6 bis 24 aromatischen Ringatomen, welches keine kondensierten Arylgruppen aufweist und welches keine kondensierten Heteroarylgruppen, in welchen zwei oder mehr aromatische bzw. heteroaromatische 6-Ring-Gruppen direkt aneinander ankondensiert sind, aufweist und welches jeweils auch durch einen oder mehrere Reste $R^2$ substituiert sein kann.

Wenn Y für $C(R^1)_2$ steht, steht $R^1$ bevorzugt gleich oder verschieden bei jedem Auftreten für eine lineare Alkylgruppe mit 1 bis 10 C-Atomen oder für eine verzweigte oder cyclische Alkylgruppe mit 3 bis 10 C-Atomen oder für ein aromatisches oder heteroaromatisches Ringsystem mit 5 bis 24 aromatischen Ringatomen, welches auch durch einen oder mehrere Reste $R^2$ substituiert sein kann. Ganz besonders bevorzugt steht $R^1$ für eine Methylgruppe oder für eine Phenylgruppe.

Weiterhin kann es bevorzugt sein, wenn die Gruppe der oben genannten Formeln (3) bis (44) nicht direkt an das Triazin in Formel (1) bzw. das Pyrimidin in Formel (2) binden, sondern über eine verbrückende Gruppe. Diese verbrückende Gruppe ist dann bevorzugt ausgewählt aus einem aromatischen oder heteroaromatischen Ringsystem mit 5 bis 24 aromatischen Ringatomen, insbesondere mit 6 bis 12 aromatischen Ringatomen, welches jeweils mit einem oder mehreren Resten $R^1$ substituiert sein kann.

Beispiele für bevorzugte Verbindungen gemäß Formel (1) bzw. (2) sind die folgenden Verbindungen.

| | | |
|---|---|---|
| 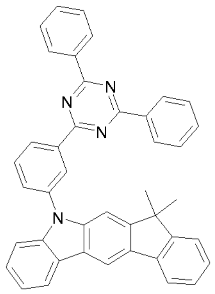 | 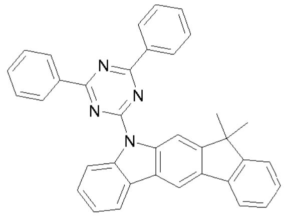 | 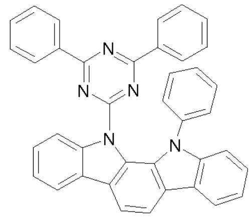 |
| 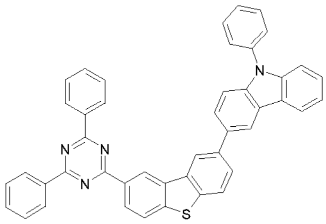 | 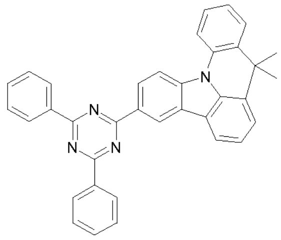 | 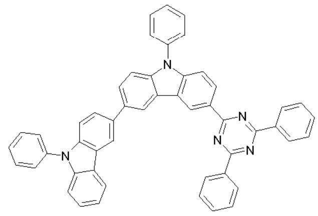 |
| 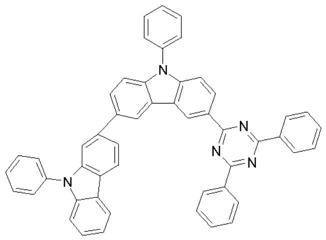 | 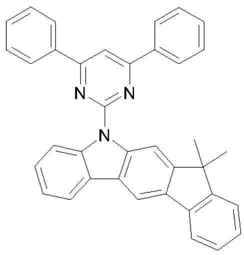 | 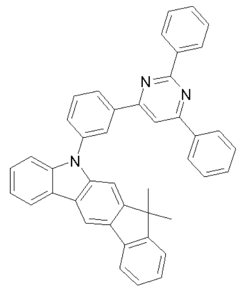 |

| | | |
|---|---|---|
| 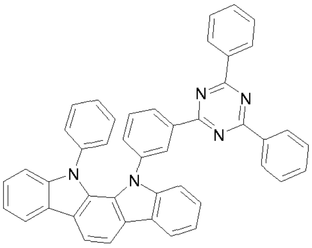 | 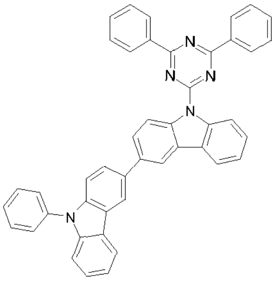 | 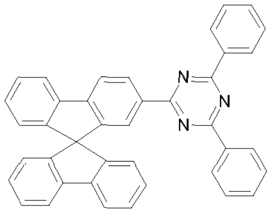 |
| 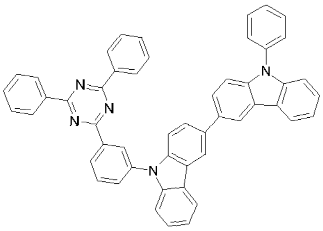 | 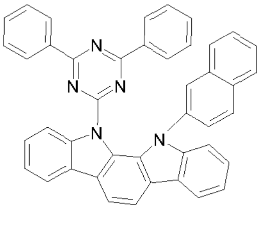 | 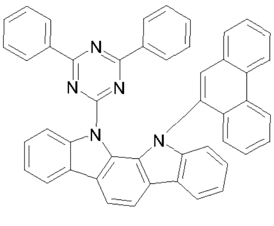 |
| 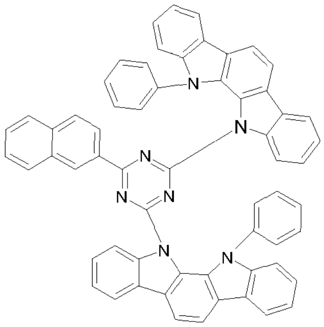 | 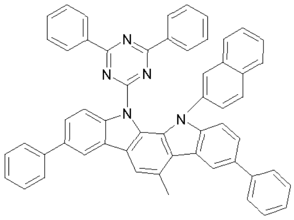 | 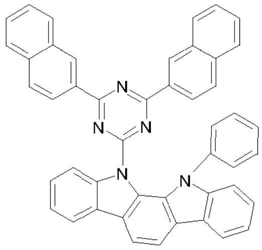 |
| 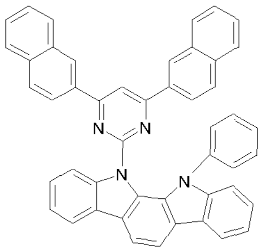 | 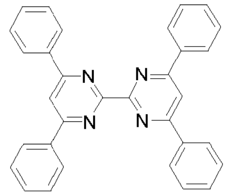 | 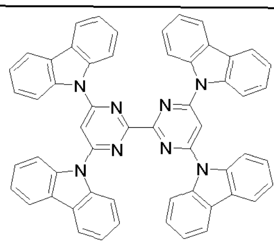 |
| 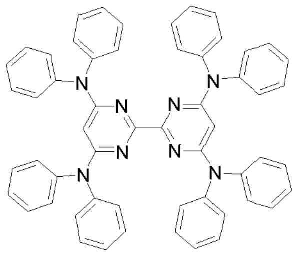 | 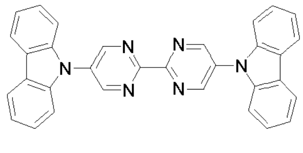 | 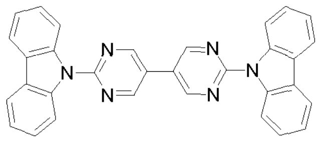 |

| | | |
|---|---|---|
| 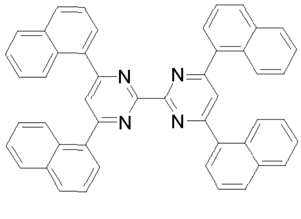 | 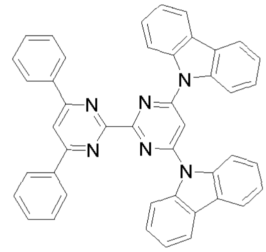 | 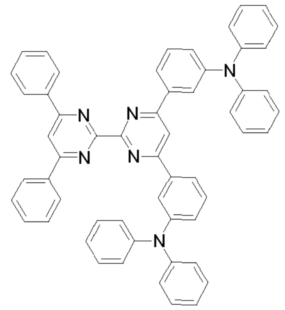 |
| 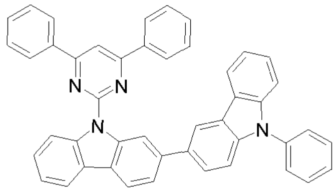 | 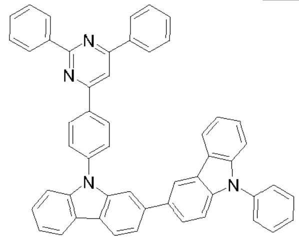 | 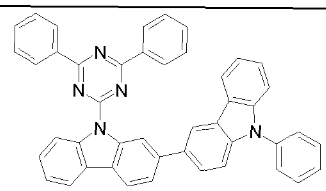 |
| 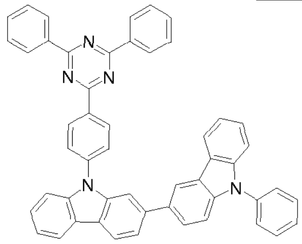 | 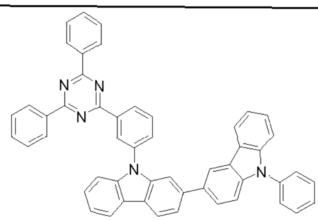 | 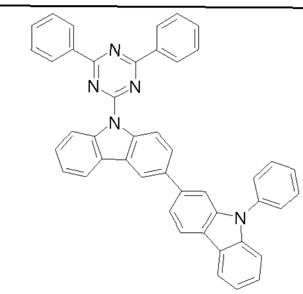 |
| 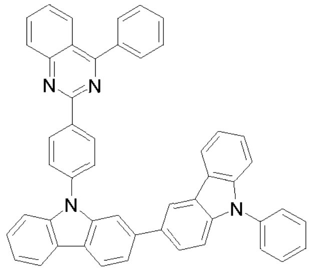 | 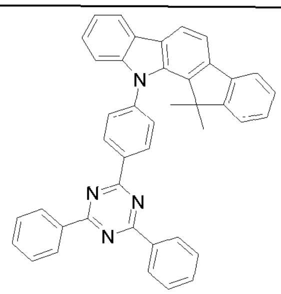 | 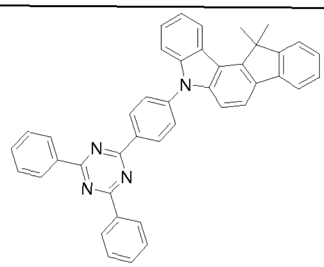 |
| 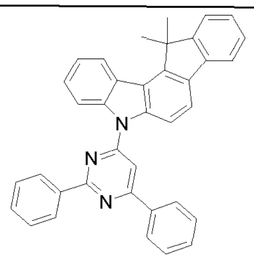 | 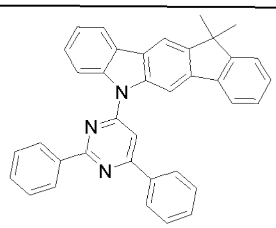 | 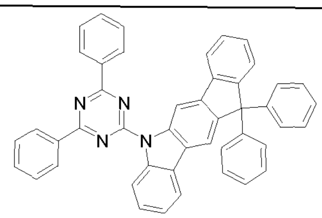 |
| 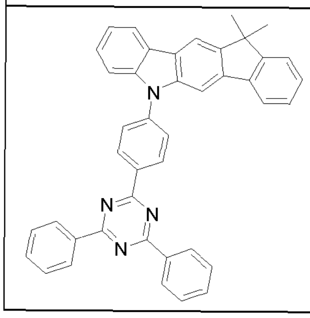 | 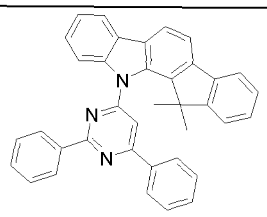 | 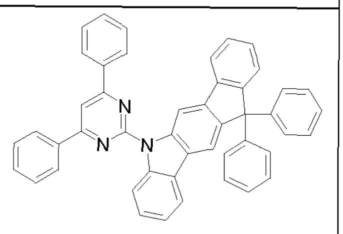 |

| | | |
|---|---|---|
| 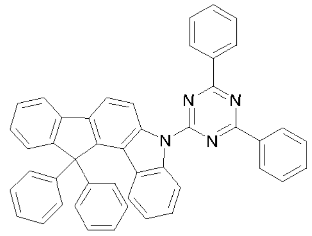 | 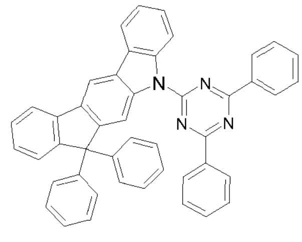 | 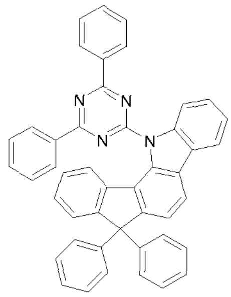 |
| 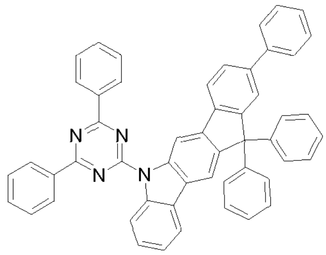 | 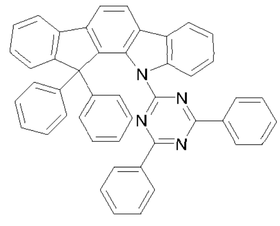 | 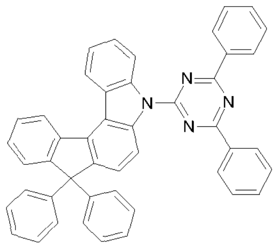 |
| 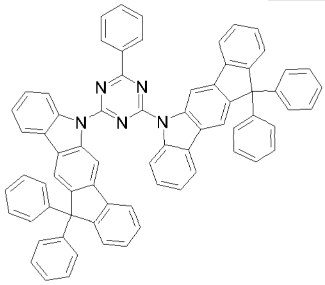 | 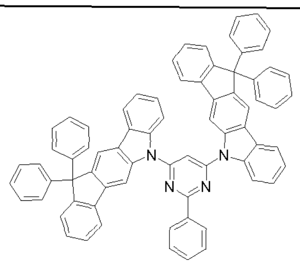 | 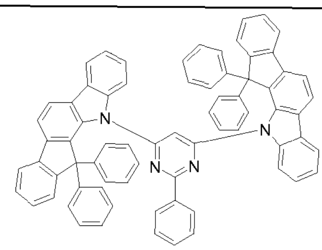 |
| 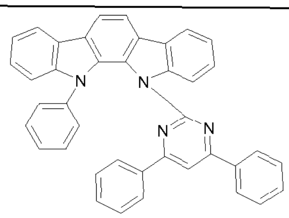 | 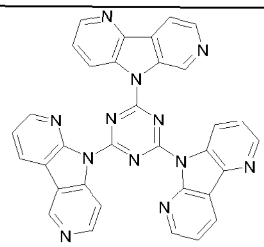 | 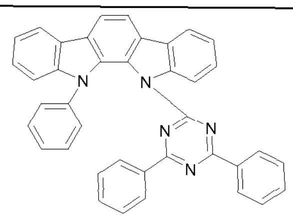 |
| 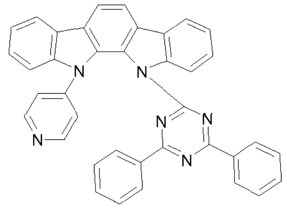 | 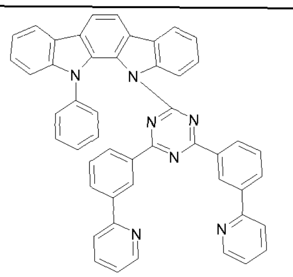 | 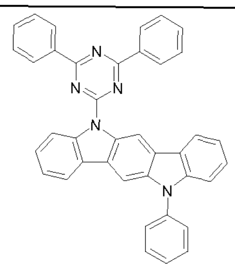 |
| 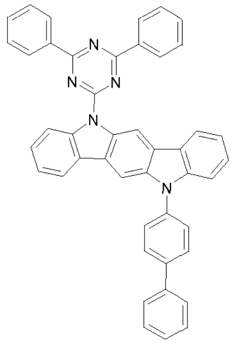 | 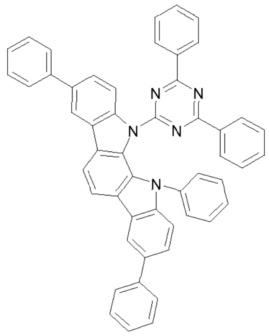 | 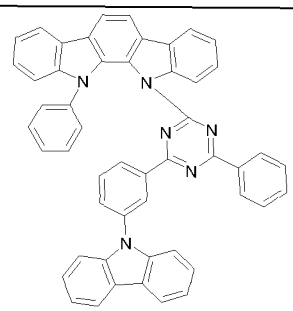 |

| | | |
|---|---|---|
| 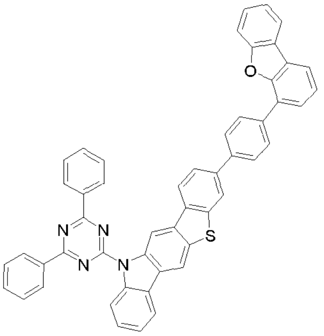 | 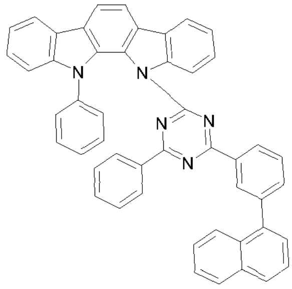 | 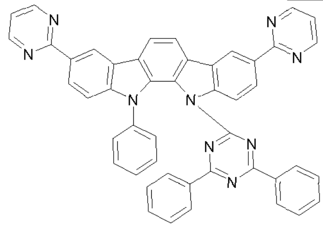 |
| 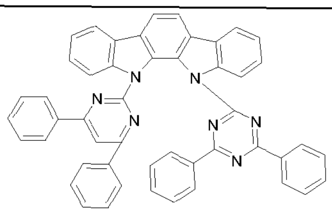 | 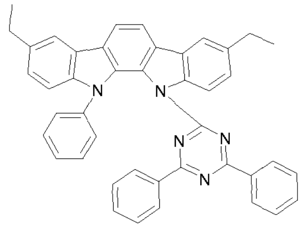 | 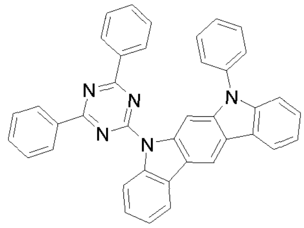 |
| 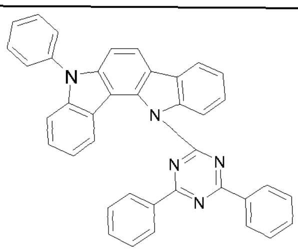 | 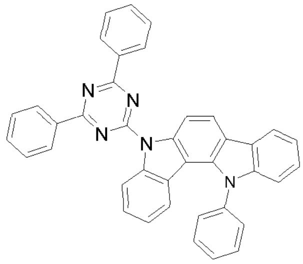 | 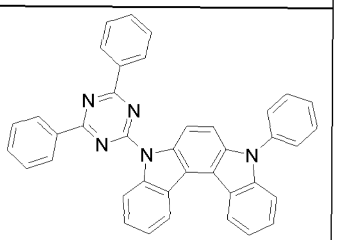 |
| 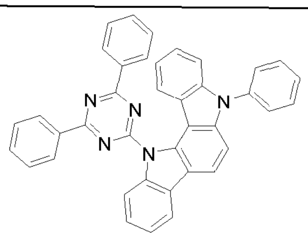 | 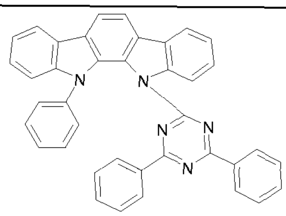 | 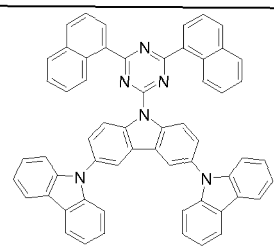 |
| 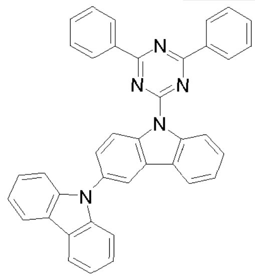 | 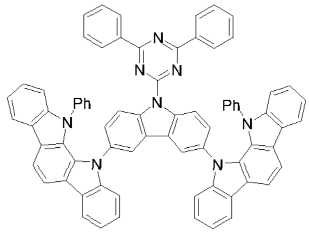 | 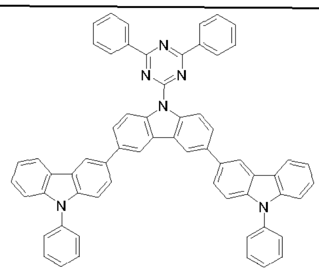 |
| 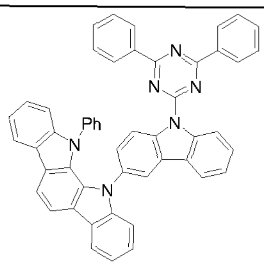 | 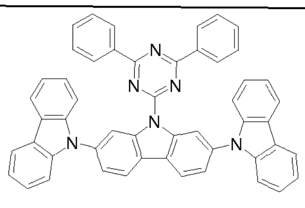 | 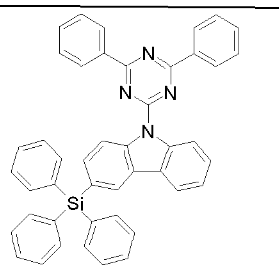 |

| | | |
|---|---|---|
| 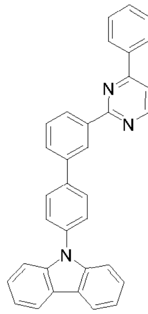 | 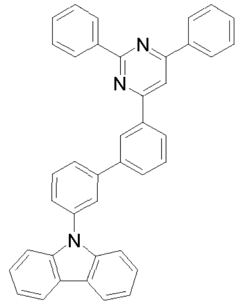 | 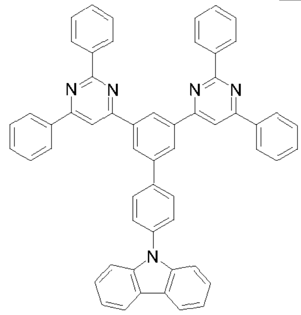 |
| 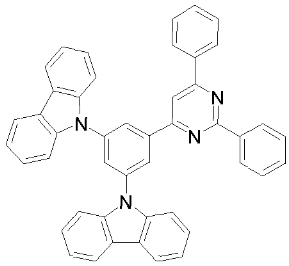 | 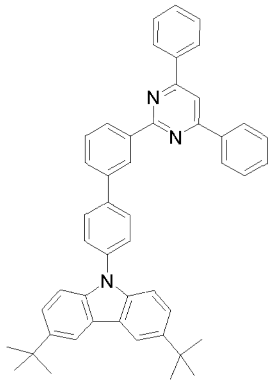 | 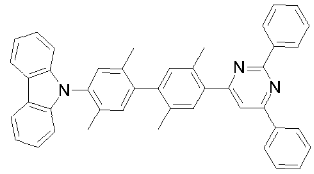 |
| 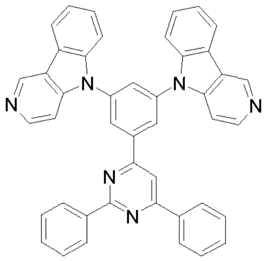 | 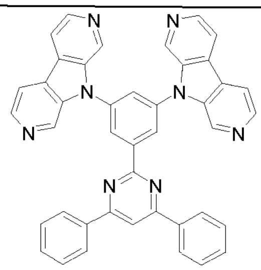 | 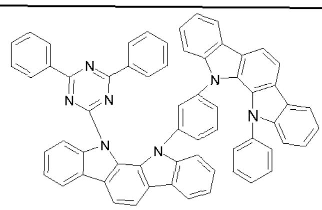 |
| 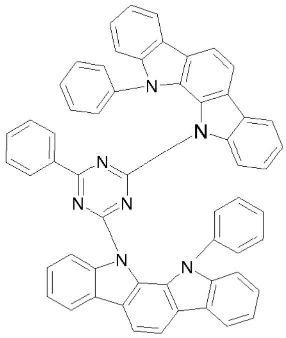 | 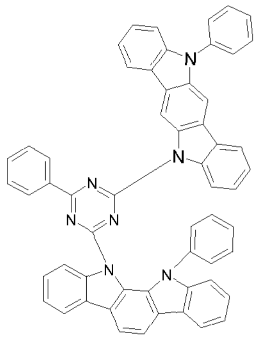 | 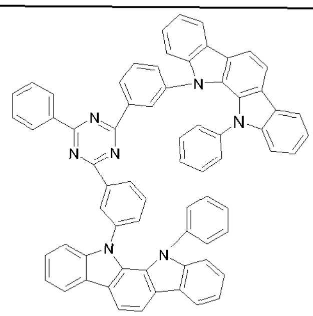 |
| 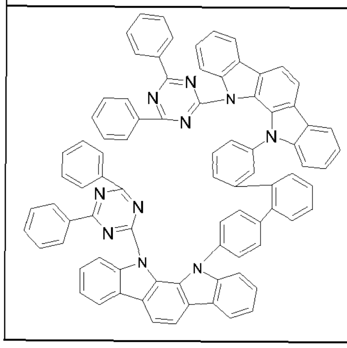 | 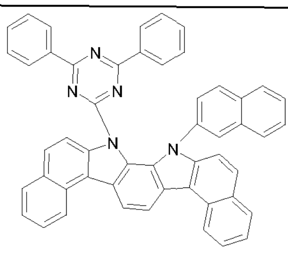 | 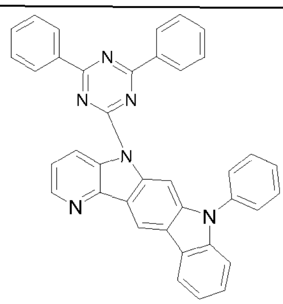 |

| | | |
|---|---|---|
| 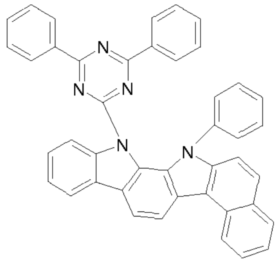 | 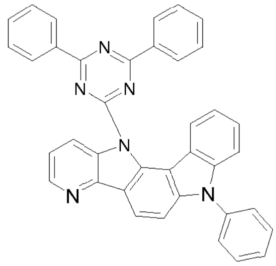 | 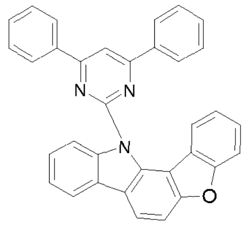 |
| 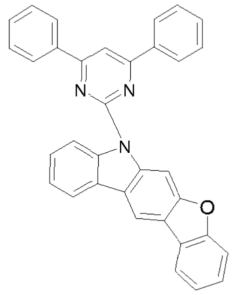 | 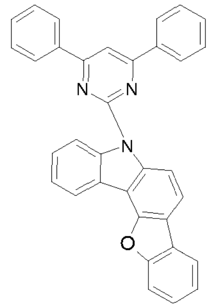 | 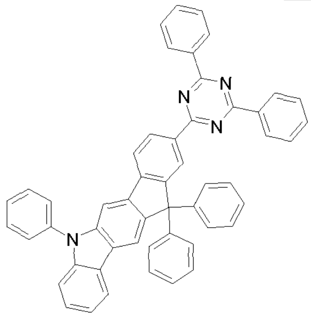 |
| 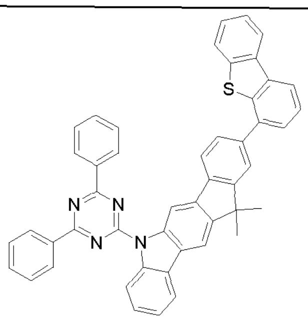 | 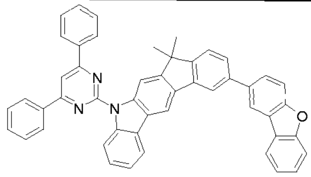 | 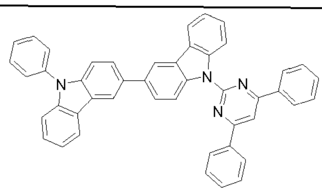 |
| 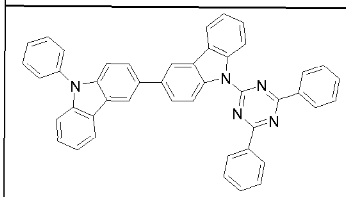 | 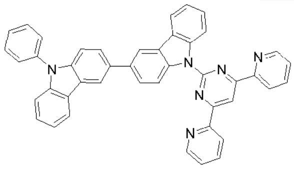 | 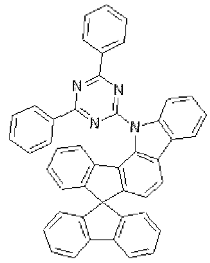 |
| 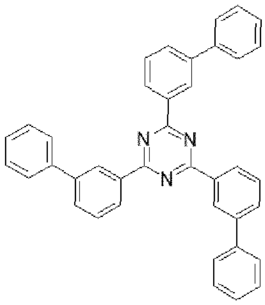 | | |

| | |
|---|---|
| 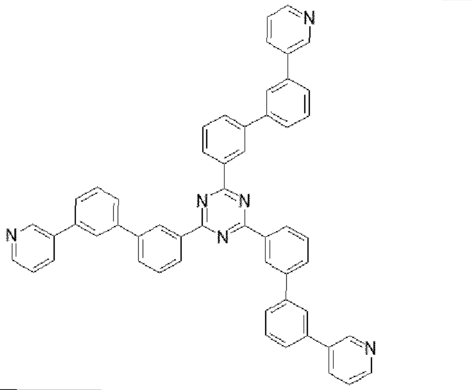 | 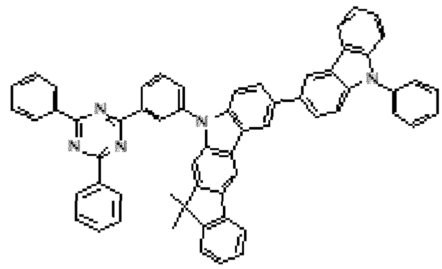 |
| 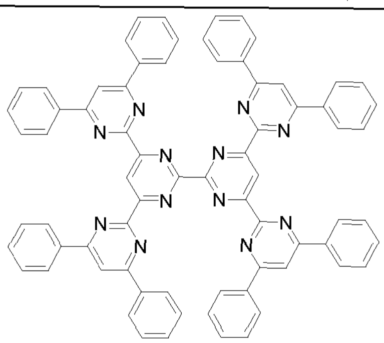 | 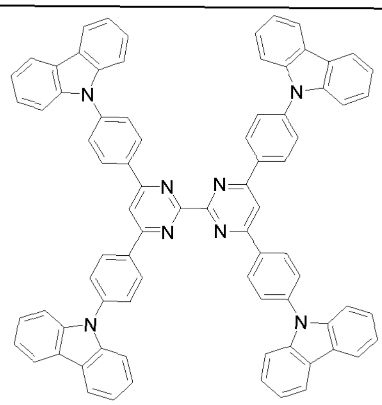 |
| 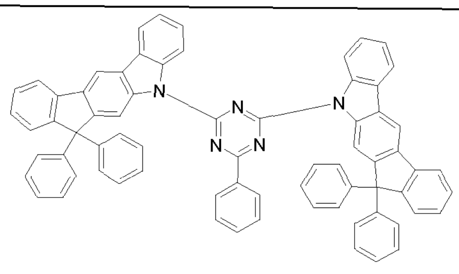 | 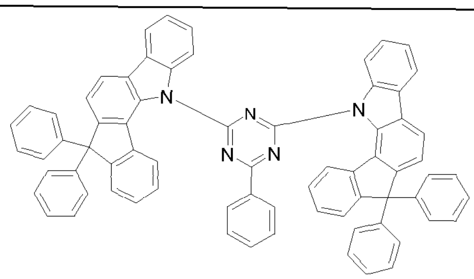 |
| 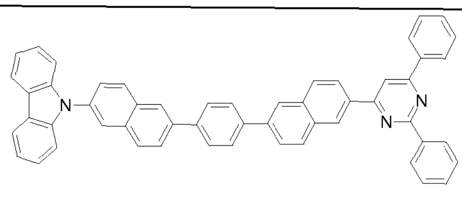 | 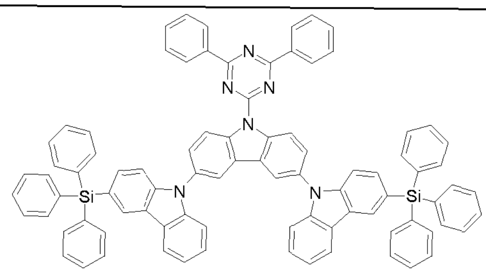 |
| 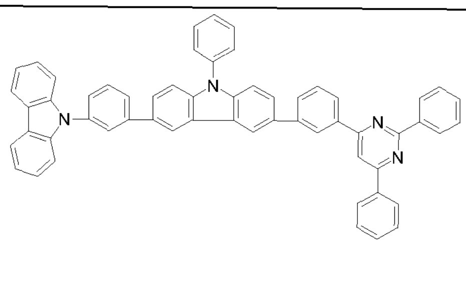 | 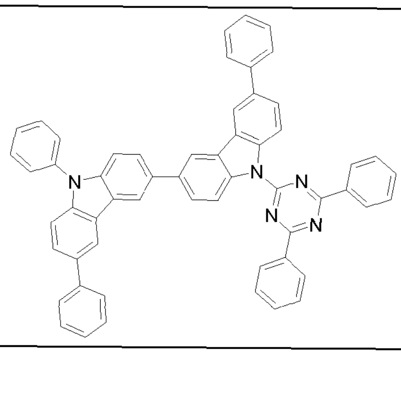 |

| | |
|---|---|
| 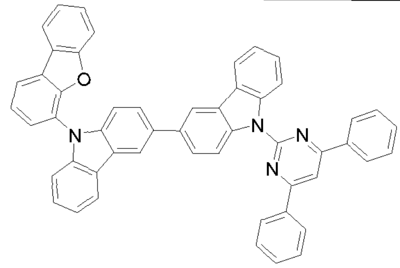 | 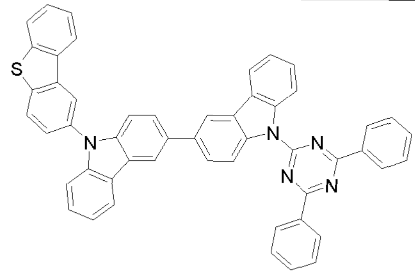 |
| 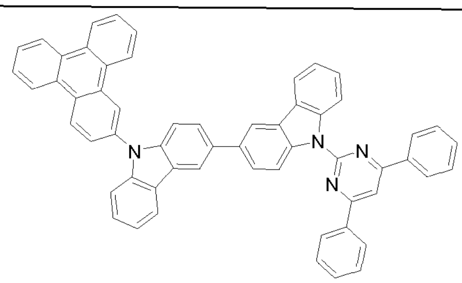 | 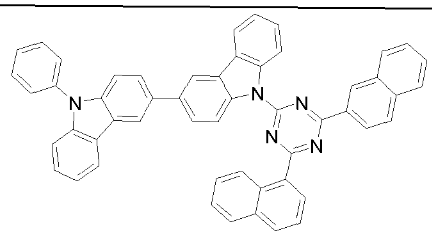 |

| | | |
|---|---|---|
| 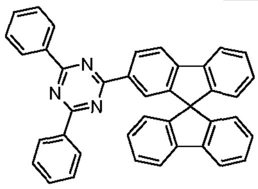 | 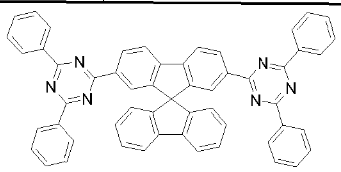 | 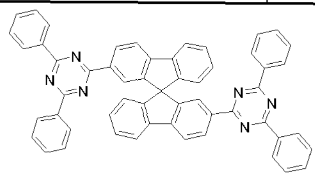 |
| 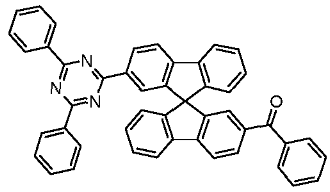 | 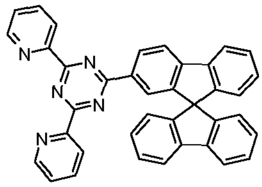 | 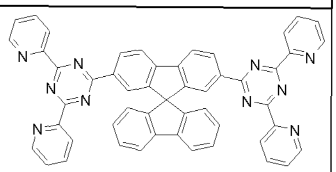 |
| 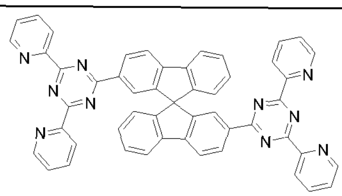 | 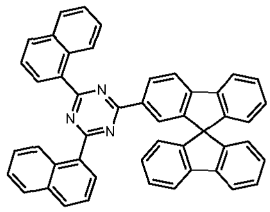 | 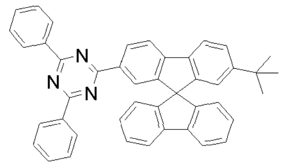 |
| 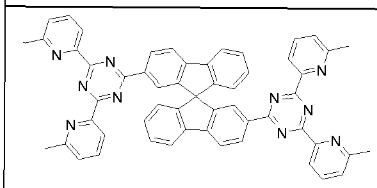 | 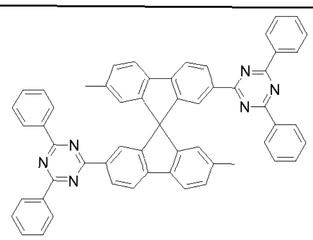 | 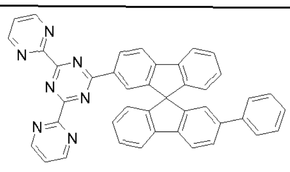 |

| | | |
|---|---|---|
| 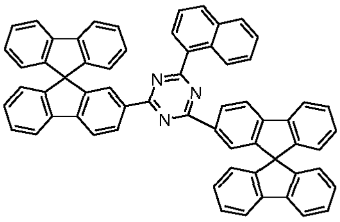 | 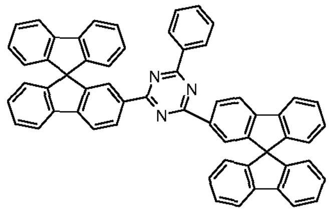 | 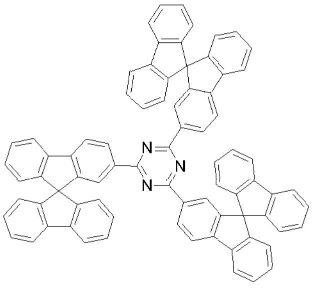 |
| 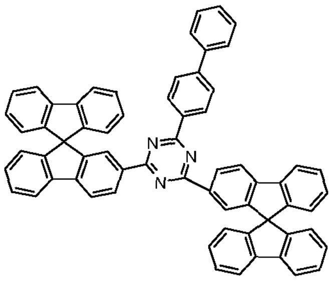 | 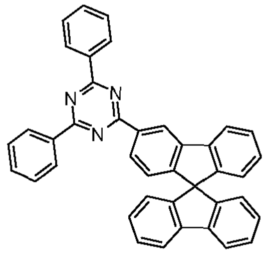 | 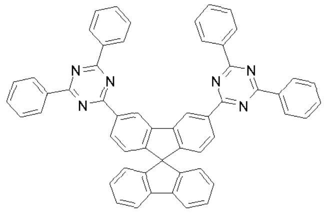 |
| 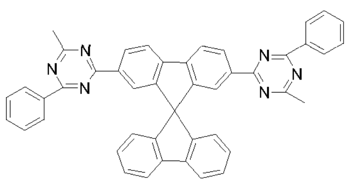 | 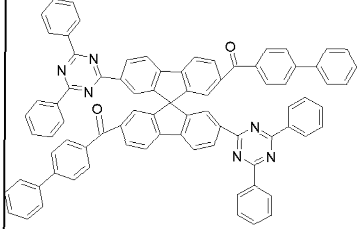 | 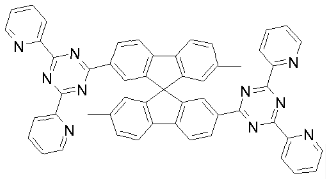 |
| 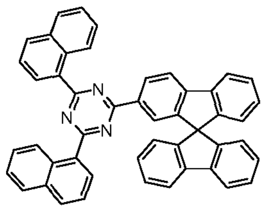 | 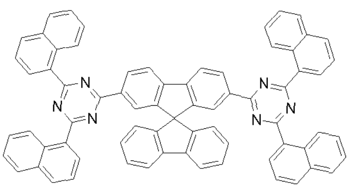 | 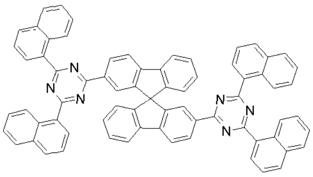 |
| 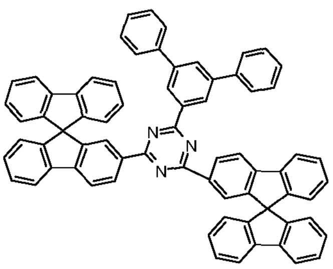 | 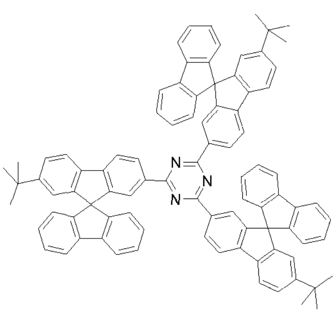 | 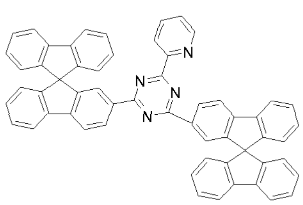 |

| | | |
|---|---|---|
| 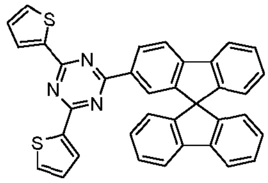 | 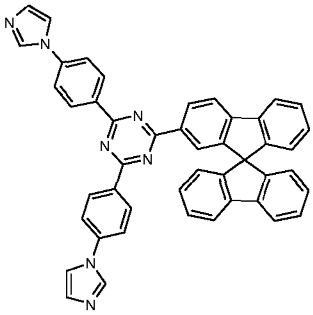 | 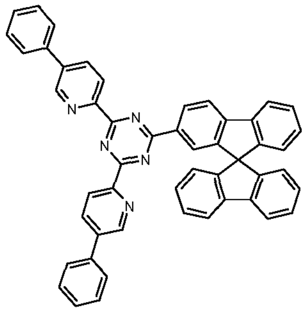 |
| 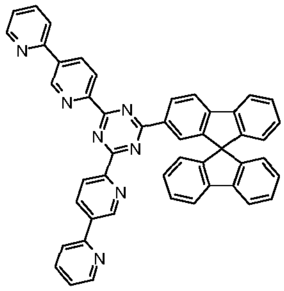 | 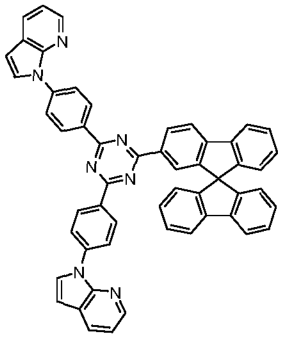 | 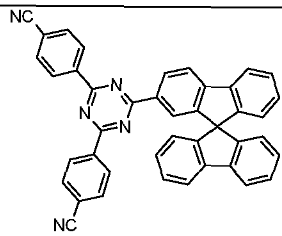 |
| 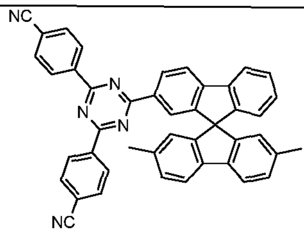 | 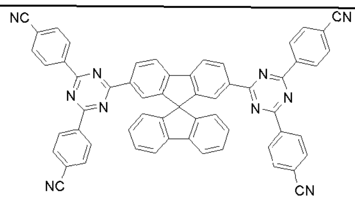 | 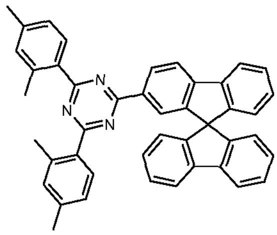 |
| 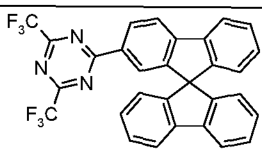 | 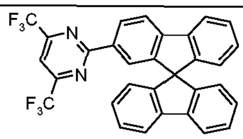 | 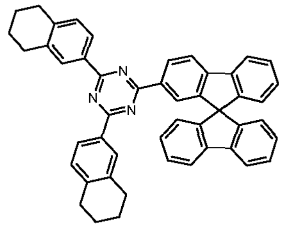 |
| 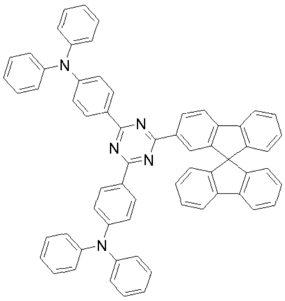 | 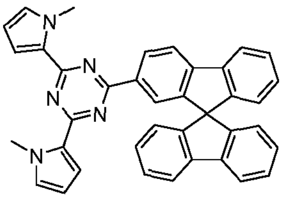 | 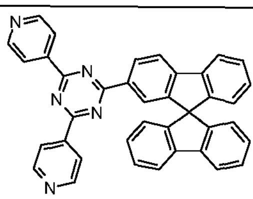 |

| | | |
|---|---|---|
| 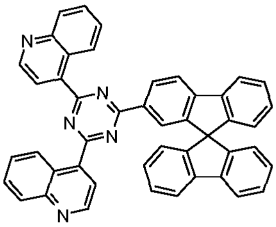 | 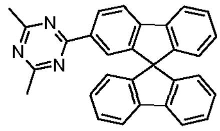 | 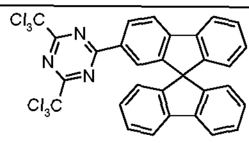 |
| 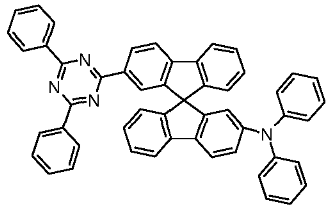 | 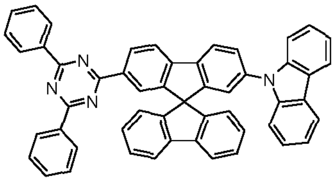 | 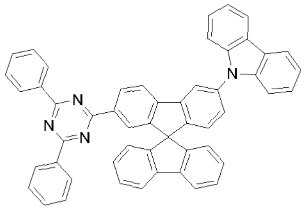 |
| 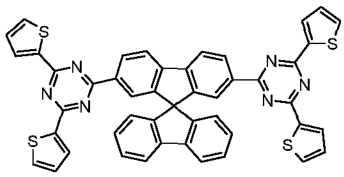 | 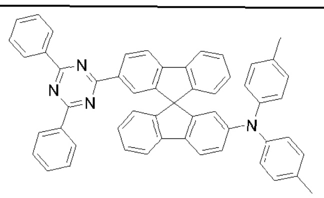 | 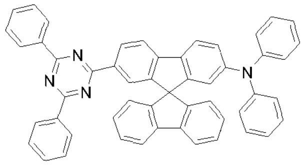 |
| 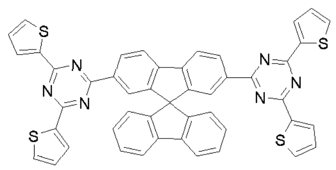 | 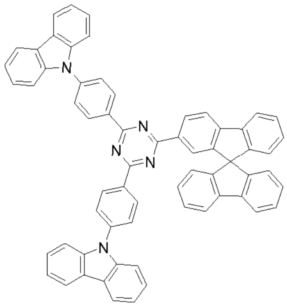 | 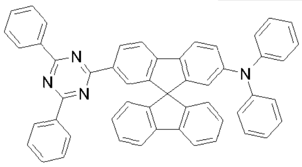 |
| 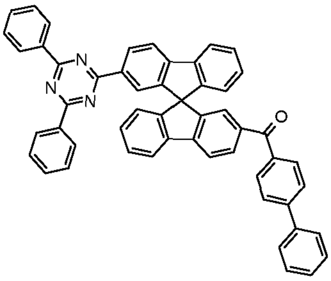 | 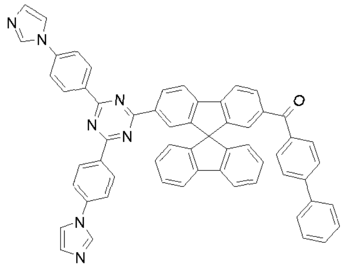 | 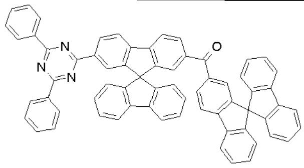 |
| 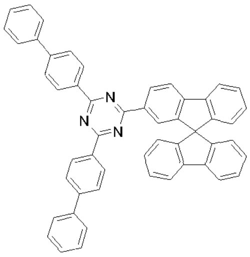 | 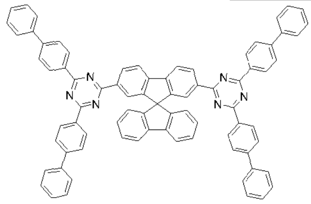 | 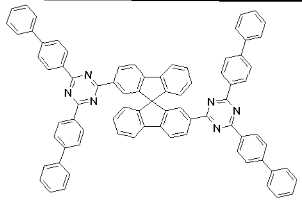 |

| | | |
|---|---|---|
| 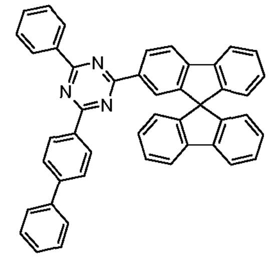 | 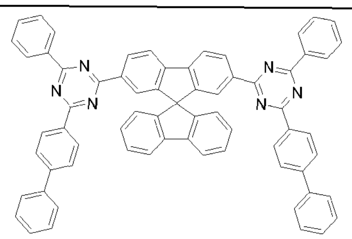 | 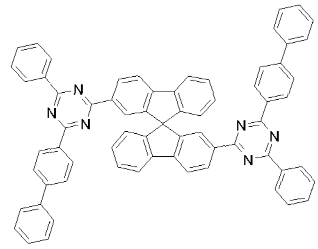 |
| 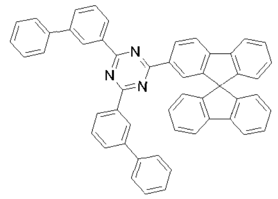 | 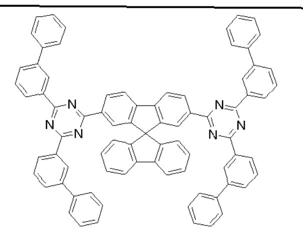 | 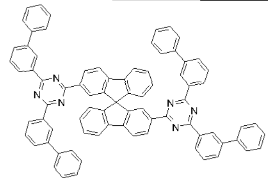 |
| 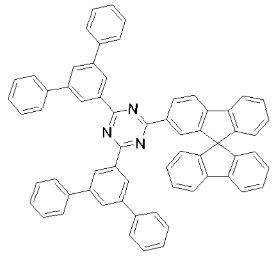 | 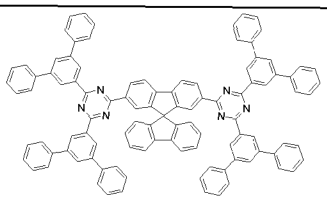 | 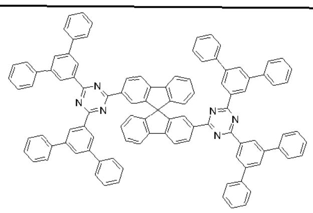 |
| 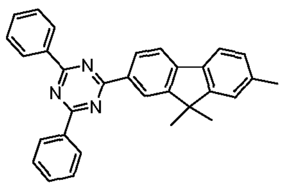 | 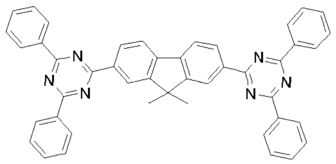 | 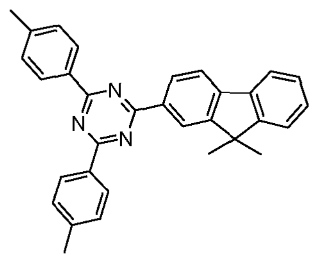 |
| 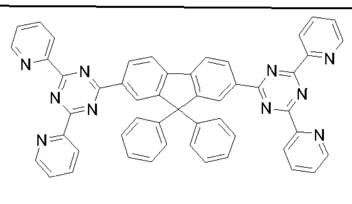 | 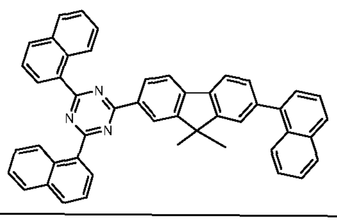 | 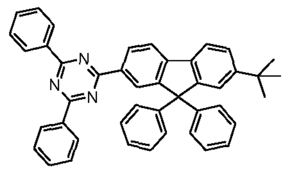 |
| 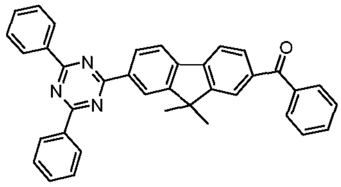 | 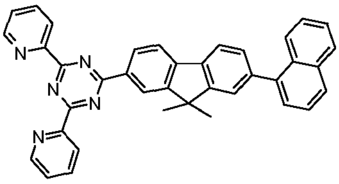 | 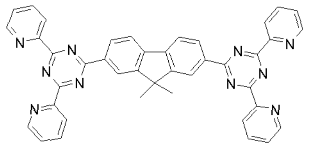 |

| | | |
|---|---|---|
| 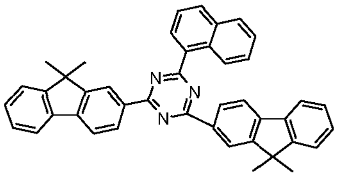 | 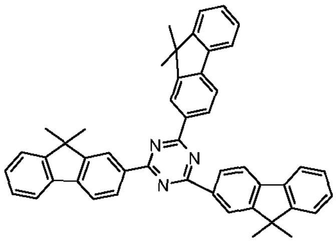 | 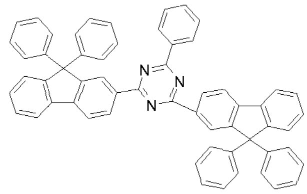 |
| 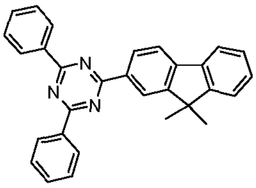 | 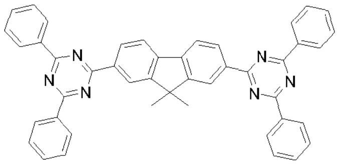 | 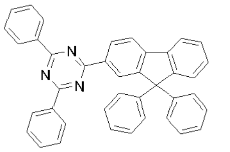 |
| 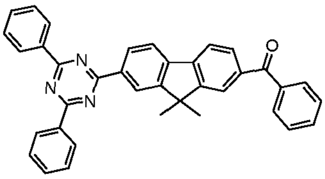 | 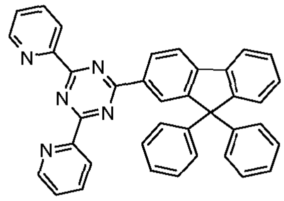 | 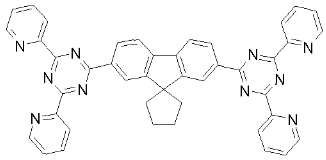 |
| 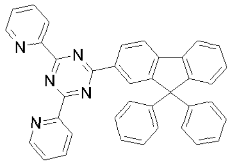 | 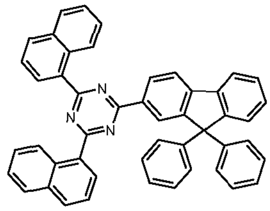 | 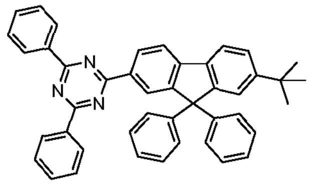 |
| 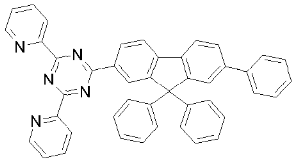 | 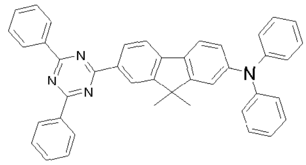 | 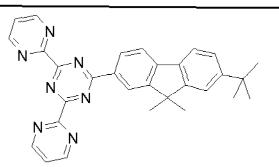 |
| 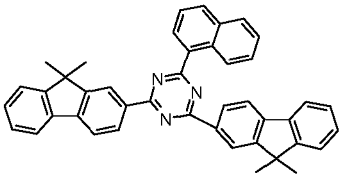 | 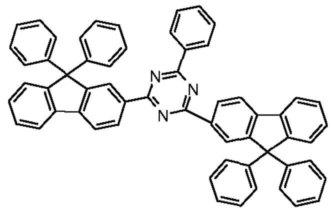 | 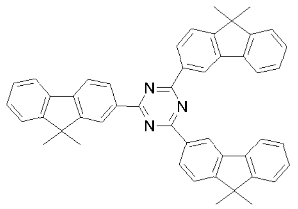 |
| 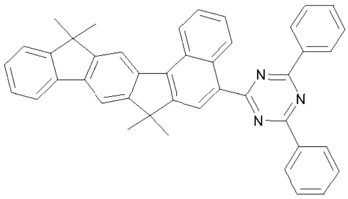 | 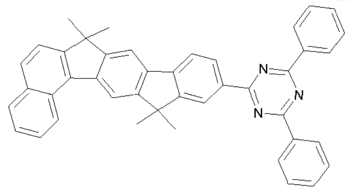 | 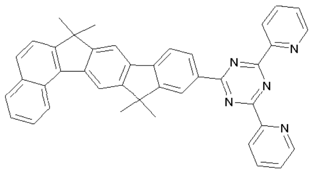 |
| 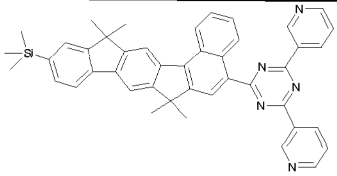 | 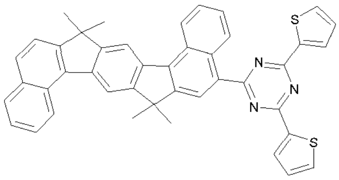 | 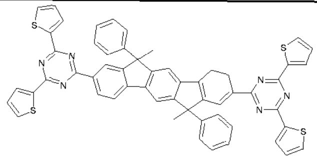 |

| | | |
|---|---|---|
| 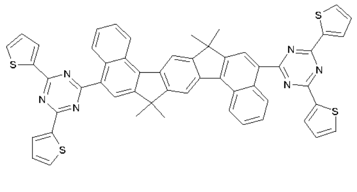 | 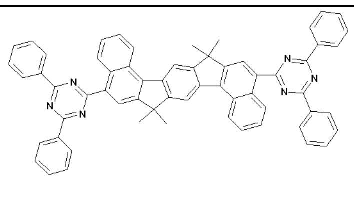 | 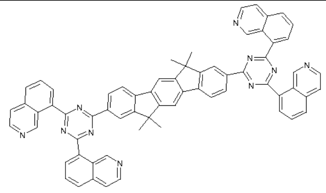 |
| 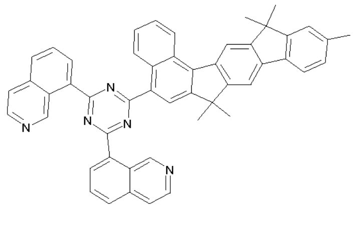 | 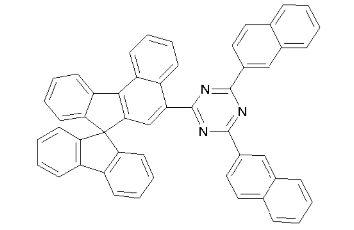 | 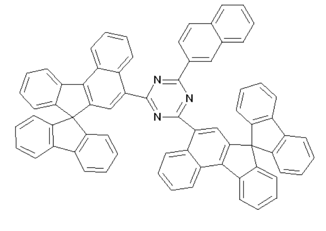 |
| 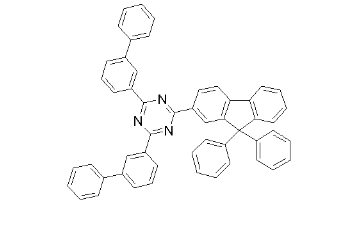 | 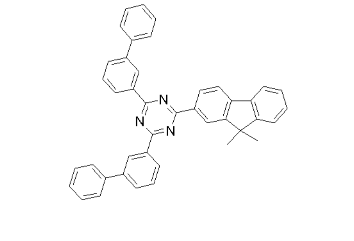 | 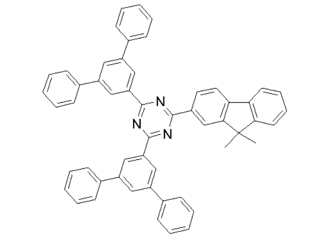 |
| 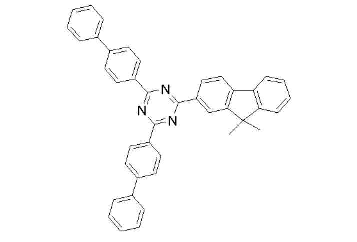 | 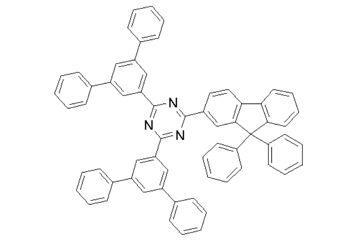 | 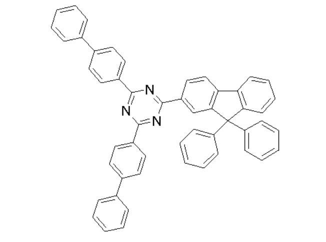 |
| 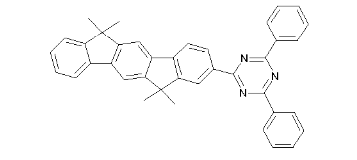 | 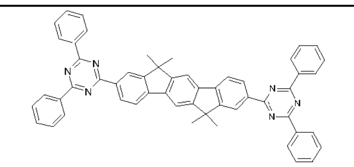 | 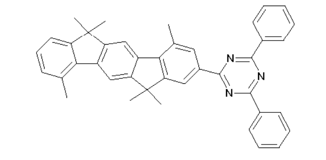 |
| 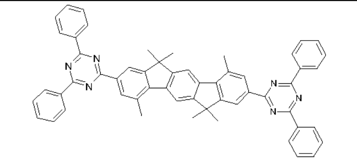 | | |

Wenn das Elektronentransportmaterial in der erfindungsgemäßen Elektronentransportschicht ein Lactam ist, dann ist diese Verbindung bevorzugt ausgewählt aus den Verbindungen der folgenden Formeln (45) bzw. (46),

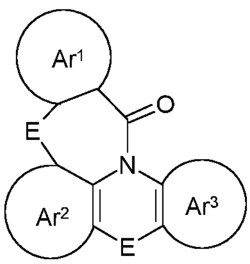

Formel (45)

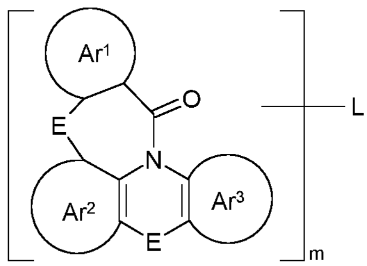

Formel (46)

wobei R, $R^1$, $R^2$ und Ar die oben genannten Bedeutungen aufweisen und für die weiteren verwendeten Symbole und

Indizes gilt:

E ist gleich oder verschieden bei jedem Auftreten eine Einfachbindung, NR, $CR_2$, O oder S;

$Ar^1$ ist zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;

$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;

L ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$ oder $Ar^3$ oder statt einer Gruppe R an E gebunden ist;

m ist 2, 3 oder 4.

In einer bevorzugten Ausführungsform der Verbindung gemäß Formel (45) bzw. (46) steht die Gruppe $Ar^1$ für eine Gruppe der folgenden Formel (47), (48), (49) oder (50),

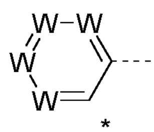
Formel (47)

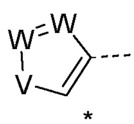
Formel (48)

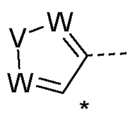
Formel (49)

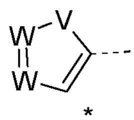
Formel (50)

wobei die gestrichelte Bindung die Verknüpfung mit der Carbonylgruppe andeutet, * die Position der Verknüpfung mit E bzw. $Ar^2$ andeutet und weiterhin gilt:

W ist gleich oder verschieden bei jedem Auftreten CR oder N; oder zwei benachbarte Gruppen W stehen für eine Gruppe der folgenden Formel (51) oder (52),

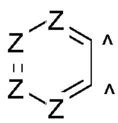
Formel (51)

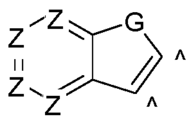
Formel (52)

wobei G für $CR_2$, NR, O oder S steht, Z gleich oder verschieden bei jedem Auftreten für CR oder N steht und ^ die entsprechenden benachbarten Gruppen W in der Formel (47) bis (50) andeuten;

V ist NR, O oder S.

In einer weiteren bevorzugten Ausführungsform der Erfindung steht die Gruppe $Ar^2$ für eine Gruppe gemäß einer der folgenden Formeln (53), (54) oder (55),

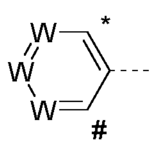
Formel (53)

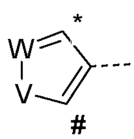
Formel (54)

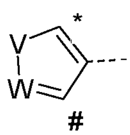
Formel (55)

wobei die gestrichelte Bindung die Verknüpfung mit N andeutet, # die Position der Verknüpfung mit E bzw. $Ar^3$ andeutet, * die Verknüpfung mit E bzw. $Ar^1$ andeutet und W und V die oben genannten Bedeutungen aufweisen.

In einer weiteren bevorzugten Ausführungsform der Erfindung steht die Gruppe $Ar^3$ für eine Gruppe gemäß einer der folgenden Formeln (56), (57), (58) oder (59),

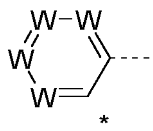
Formel (56)

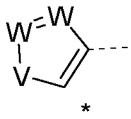
Formel (57)

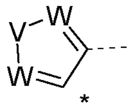
Formel (58)

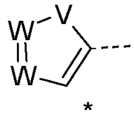
Formel (59)

wobei die gestrichelte Bindung die Verknüpfung mit N andeutet, * die Verknüpfung mit E bzw. $Ar^2$ andeutet und W und V die oben genannten Bedeutungen aufweisen.

Dabei können die oben genannten bevorzugten Gruppen $Ar^1$, $Ar^2$ und $Ar^3$ beliebig miteinander kombiniert werden.

In einer weiteren bevorzugten Ausführungsform der Erfindung steht mindestens eine Gruppe E für eine Einfachbindung.

In einer bevorzugten Ausführungsform der Erfindung treten die oben genannten Bevorzugungen gleichzeitig auf. Besonders bevorzugt sind daher Verbindungen gemäß Formel (45) bzw. (46), für die gilt:

$Ar^1$ ist ausgewählt aus den Gruppen der oben genannten Formeln (47), (48), (49) oder (50);
$Ar^2$ ist ausgewählt aus den Gruppen der oben genannten Formeln (53), (54) oder (55);
$Ar^3$ ist ausgewählt aus den Gruppen der oben genannten Formeln (56), (57), (58) oder (59).

Besonders bevorzugt stehen mindestens zwei der Gruppen $Ar^1$, $Ar^2$ und $Ar^3$ für eine 6-Ring-Aryl- oder eine 6-Ring-Heteroarylgruppe. Besonders bevorzugt steht also $Ar^1$ für eine Gruppe der Formel (47) und gleichzeitig steht $Ar^2$ für eine Gruppe der Formel (53), oder $Ar^1$ steht für eine Gruppe der Formel (47) und gleichzeitig steht $Ar^3$ für eine Gruppe der Formel (56), oder $Ar^2$ steht für eine Gruppe der Formel (53) und gleichzeitig steht $Ar^3$ für eine Gruppe der Formel (59).

Besonders bevorzugte Ausführungsformen der Formel (45) sind daher die Verbindungen der folgenden Formeln (60) bis (69),

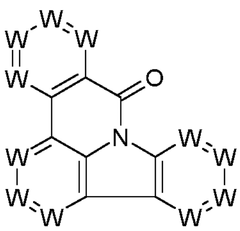
Formel (60)

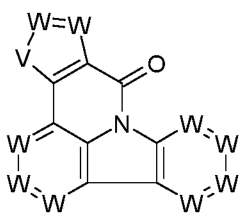
Formel (61)

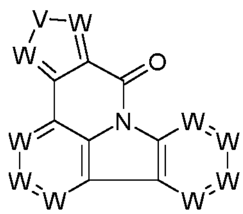
Formel (62)

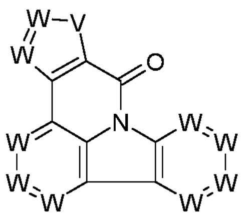
Formel (63)

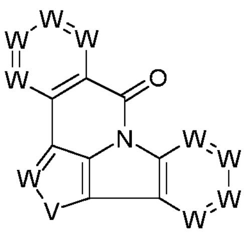
Formel (64)

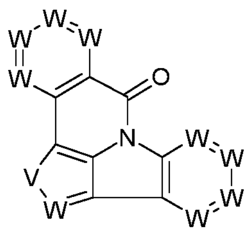
Formel (65)

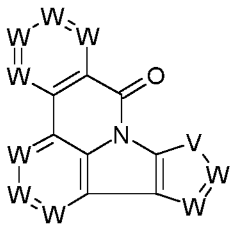

Formel (66)

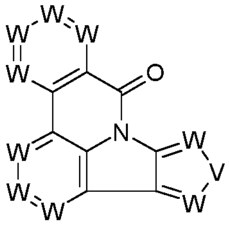

Formel (67)

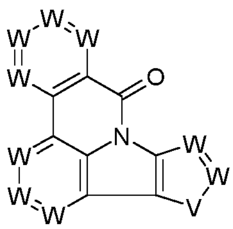

Formel (68)

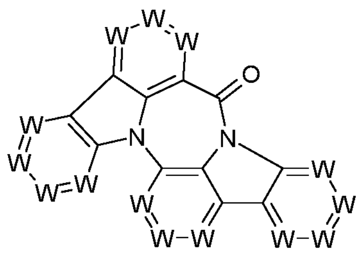

Formel (69)

wobei die verwendeten Symbole die oben genannten Bedeutungen aufweisen.

Es ist weiterhin bevorzugt, wenn W für CR oder N steht und nicht für eine Gruppe der Formel (51) oder (52). In einer bevorzugten Ausführungsform der Verbindungen gemäß Formel (60) bis (69) steht pro Cyclus insgesamt maximal ein Symbol W für N, und die verbleibenden Symbole W stehen für CR. In einer besonders bevorzugten Ausführungsform der Erfindung stehen alle Symbole W für CR. Besonders bevorzugt sind daher die Verbindungen gemäß den folgenden Formeln (60a) bis (69a),

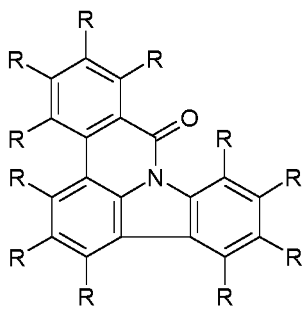

Formel (60a)

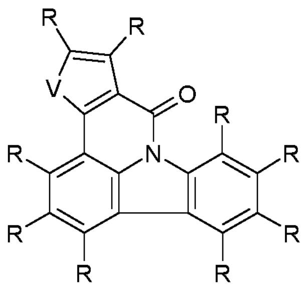

Formel (61a)

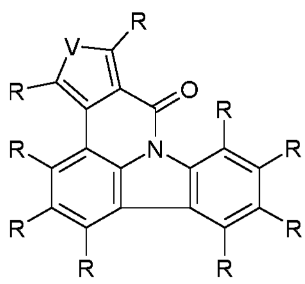

Formel (62a)

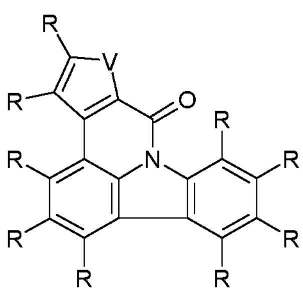

Formel (63a)

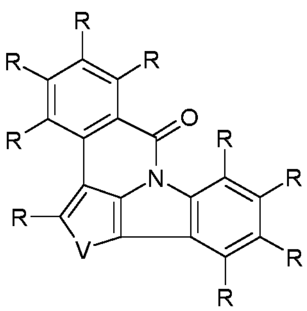

Formel (64a)

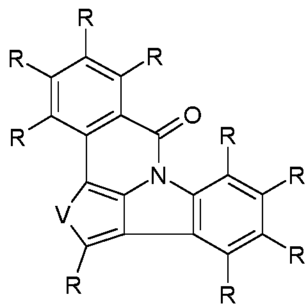

Formel (65a)

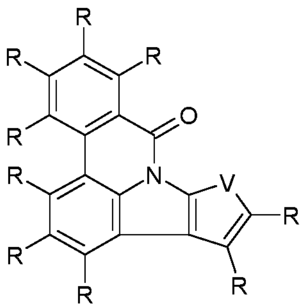
Formel (66a)

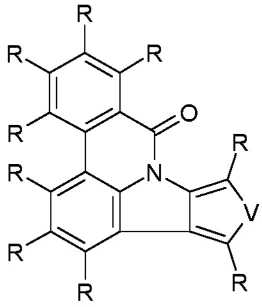
Formel (67a)

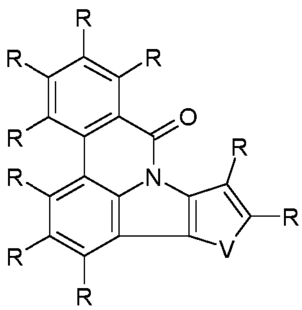
Formel (68a)

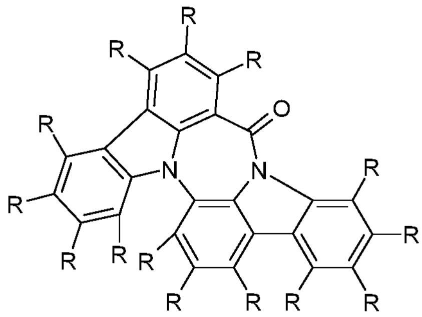
Formel (69a)

wobei die verwendeten Symbole die oben genannten Bedeutungen aufweisen.

Ganz besonders bevorzugt sind die Strukturen der Formeln (60b) bis (69b),

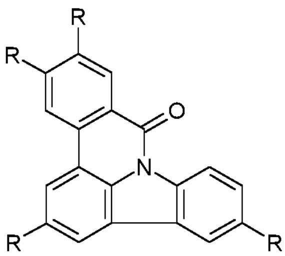
Formel (60b)

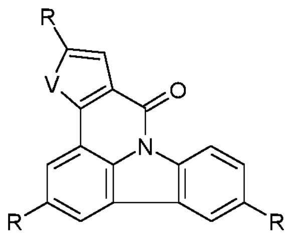
Formel (61b)

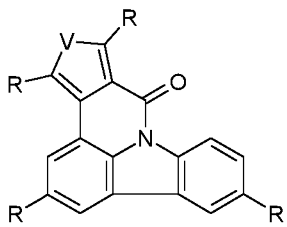
Formel (62b)

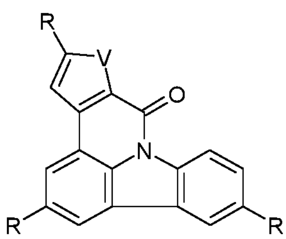
Formel (63b)

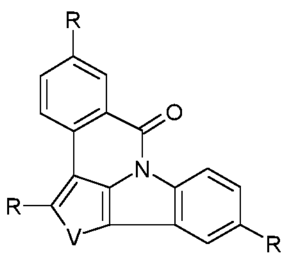
Formel (64b)

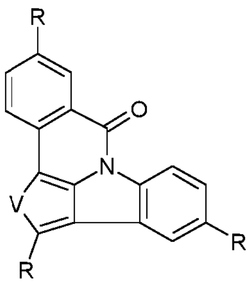
Formel (65b)

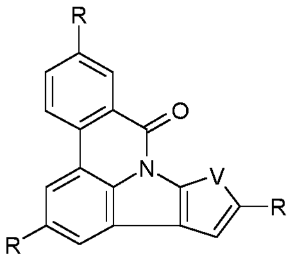

Formel (66b)

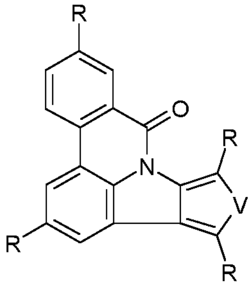

Formel (67b)

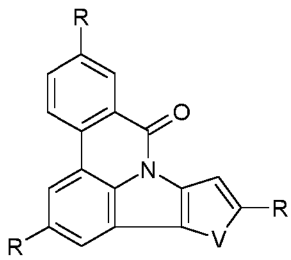

Formel (68b)

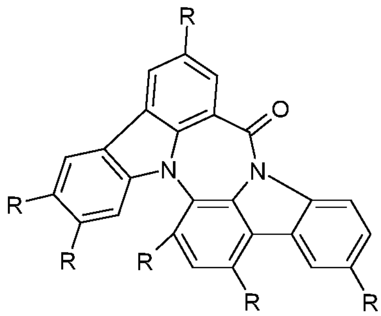

Formel (69b)

wobei die verwendeten Symbole die oben genannten Bedeutungen aufweisen.

Ganz besonders bevorzugt sind die Verbindungen der Formel (60) bzw. (60a) bzw. (60b).

Die verbrückende Gruppe L in den Verbindungen der Formeln (46a) ist bevorzugt ausgewählt aus einer Einfachbindung oder einem aromatischen oder heteroaromatischen Ringsystem mit 5 bis 30 aromatischen Ringatomen, welches durch einen oder mehrere Reste R substituiert sein kann. Dabei enthalten die aromatischen bzw. heteroaromatischen Ringsysteme bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind.

In einer weiteren bevorzugten Ausführungsform der Erfindung ist der Index m in Verbindungen der Formel (46) = 2 oder 3, insbesondere gleich 2.

In einer bevorzugten Ausführungsform der Erfindung ist R in den oben genannten Formeln gleich oder verschieden bei jedem Auftreten ausgewählt aus der Gruppe bestehend aus H, D, F, Cl, Br, CN, $N(Ar)_2$, C(=O)Ar, einer geradkettigen Alkyl- oder Alkoxygruppe mit 1 bis 10 C-Atomen oder einer verzweigten oder cyclischen Alkyl- oder Alkoxygruppe mit 3 bis 10 C-Atomen oder einer Alkenylgruppe mit 2 bis 10 C-Atomen, die jeweils mit einem oder mehreren Resten $R^1$ substituiert sein kann, wobei eine oder mehrere nicht-benachbarte $CH_2$-Gruppen durch O ersetzt sein können und wobei ein oder mehrere H-Atome durch D oder F ersetzt sein können, einem aromatischen oder heteroaromatischen Ringsystem mit 5 bis 30 aromatischen Ringatomen, das jeweils mit einem oder mehreren Resten $R^1$ substituiert sein kann, einer Aryloxy- oder Heteroaryloxygruppe mit 5 bis 30 aromatischen Ringatomen, die mit einem oder mehreren Resten $R^1$ substituiert sein kann, oder einer Kombination dieser Systeme.

In einer besonders bevorzugten Ausführungsform der Erfindung ist R in den oben genannten Formeln gleich oder verschieden bei jedem Auftreten ausgewählt aus der Gruppe bestehend aus H, D, F, Cl, Br, CN, einer geradkettigen Alkylgruppe mit 1 bis 10 C-Atomen oder einer verzweigten oder cyclischen Alkylgruppe mit 3 bis 10 C-Atomen, die jeweils mit einem oder mehreren Resten $R^1$ substituiert sein kann, wobei ein oder mehrere H-Atome durch D oder F ersetzt sein können, einem aromatischen oder heteroaromatischen Ringsystem mit 5 bis 18 aromatischen Ringatomen, das jeweils mit einem oder mehreren Resten $R^1$ substituiert sein kann, oder einer Kombination dieser Systeme.

Dabei enthalten die Reste R, wenn diese aromatische oder heteroaromatischen Ringsysteme enthalten, bevorzugt keine kondensierten Aryl- bzw. Heteroarylgruppen, in denen mehr als zwei aromatische Sechsringe direkt aneinander ankondensiert sind. Besonders bevorzugt enthalten sie überhaupt keine Aryl- bzw. Heteroarylgruppen, in denen aromatische Sechsringe direkt aneinander ankondensiert sind. Insbesondere bevorzugt sind hier Phenyl, Biphenyl, Terphenyl, Quaterphenyl, Carbazol, Dibenzothiophen, Dibenzofuran, Indenocarbazol, Indolocarbazol, Triazin oder Pyrimidin, welches jeweils auch durch einen oder mehrere Reste $R^1$ substituiert sein kann.

Dabei haben für Verbindungen, die durch Vakuumverdampfung verarbeitet werden, die Alkylgruppen bevorzugt nicht mehr als fünf C-Atome, besonders bevorzugt nicht mehr als 4 C-Atome, ganz besonders bevorzugt nicht mehr als

1 C-Atom. Für Verbindungen, die aus Lösung verarbeitet werden, eignen sich auch Verbindungen, die mit Alkylgruppen mit bis zu 10 C-Atomen substituiert sind oder die mit Oligoarylengruppen, beispielsweise ortho-, meta-, para- oder verzweigten Terphenylgruppen, substituiert sind.

Die Verbindungen der Formeln (45) und (46) sind prinzipiell bekannt. Die Synthese dieser Verbindungen kann gemäß den in der WO 2011/116865 und WO 2011/137951 beschriebenen Verfahren erfolgen.

Beispiele für bevorzugte Verbindungen gemäß den oben aufgeführten Ausführungsformen sind die in der folgenden Tabelle aufgeführten Verbindungen.

| | | |
|---|---|---|
| 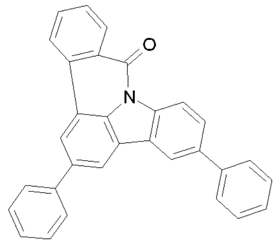 | 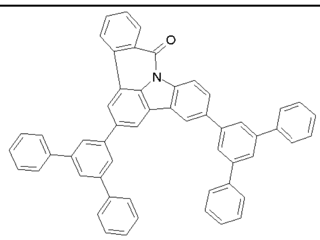 | 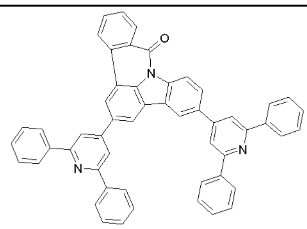 |
| 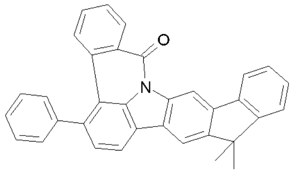 | 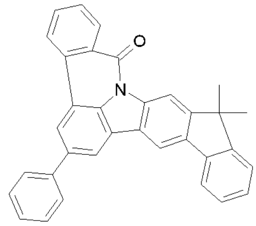 | 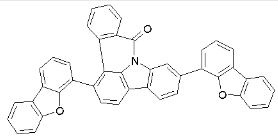 |
| 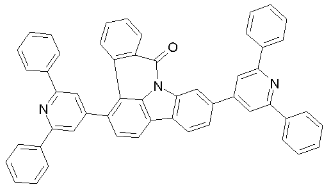 | 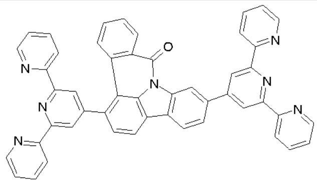 | 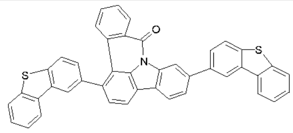 |
| 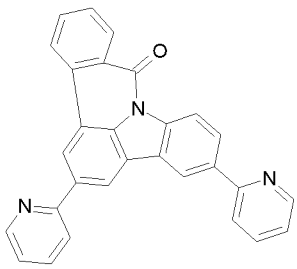 | 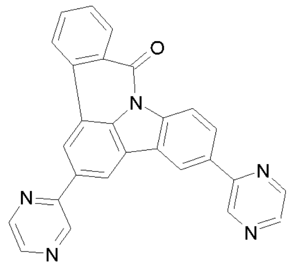 | 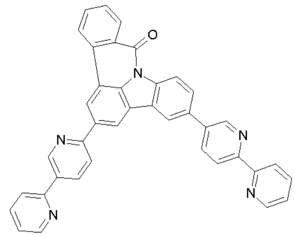 |

| | | |
|---|---|---|
| 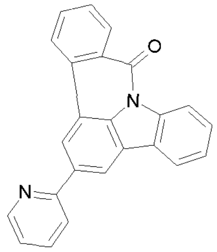 | 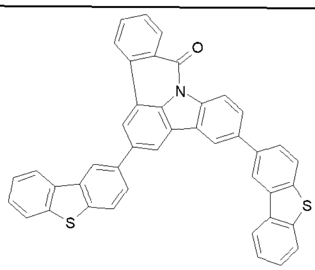 | 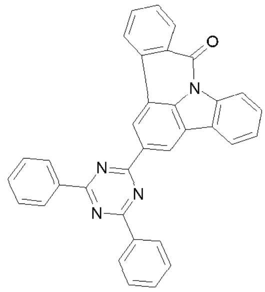 |
| 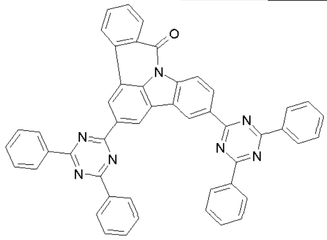 | 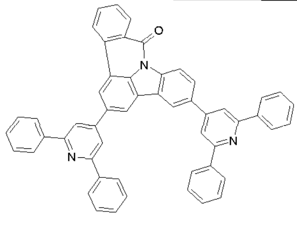 | 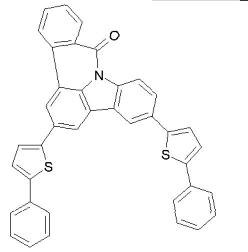 |
| 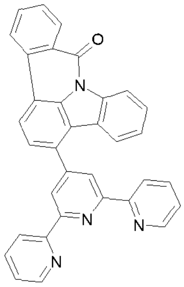 | 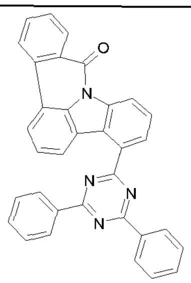 | 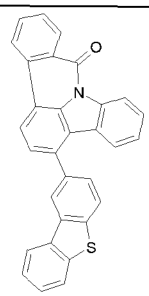 |
| 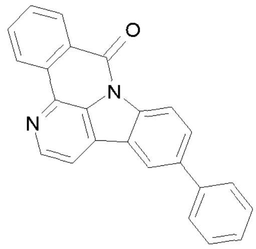 | 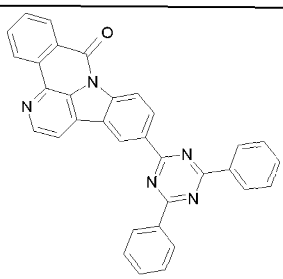 | 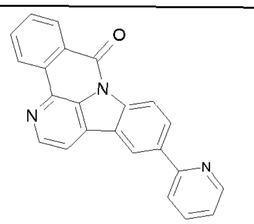 |
| 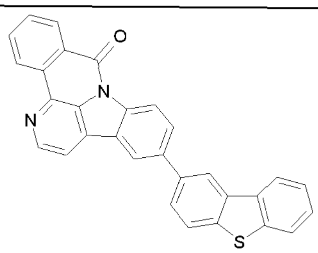 | 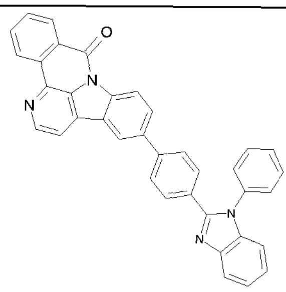 | 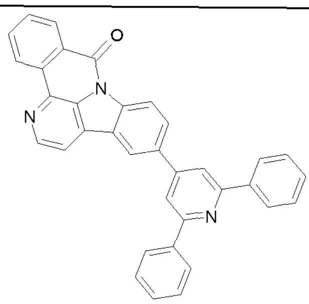 |

| | | |
|---|---|---|
| 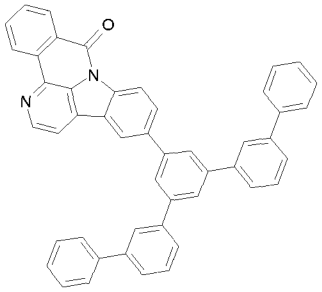 | 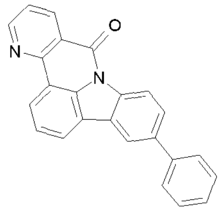 | 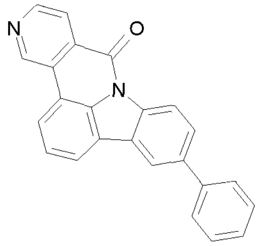 |
| 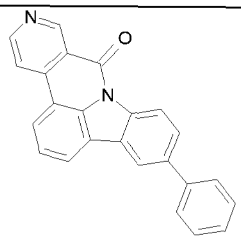 | 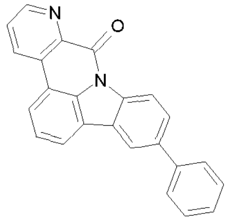 | 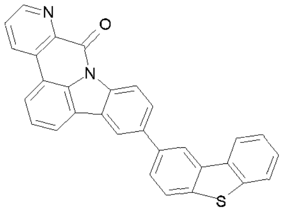 |
| 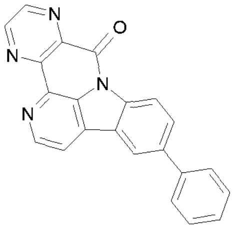 | 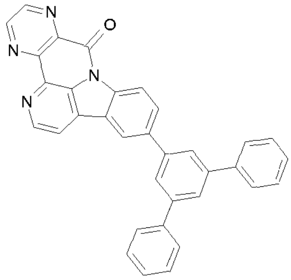 | 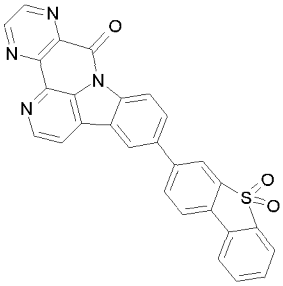 |
| 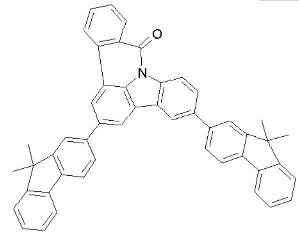 | 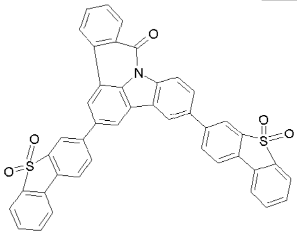 | 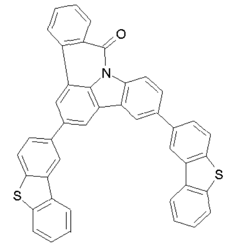 |
| 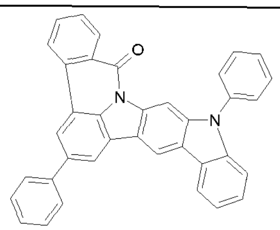 | 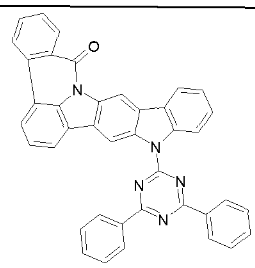 | 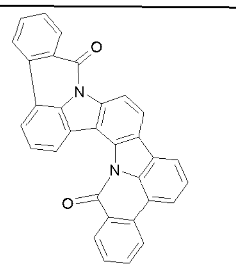 |
| 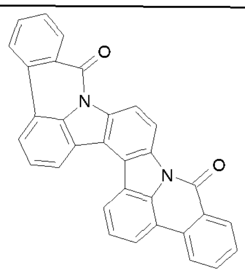 | 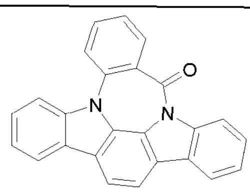 | 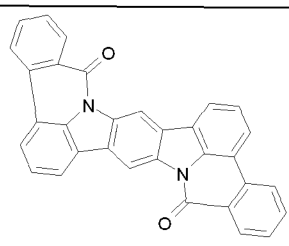 |

| | | |
|---|---|---|
| 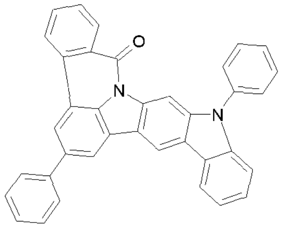 | 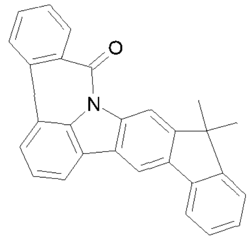 | 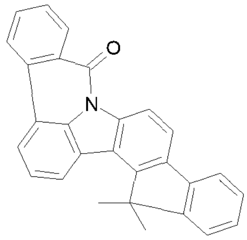 |
| 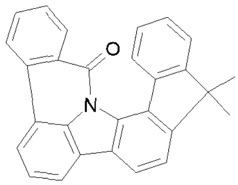 | 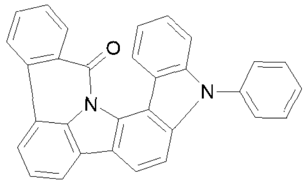 | 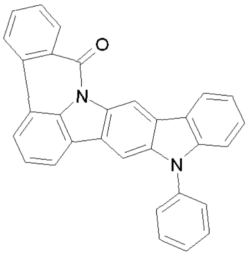 |
| 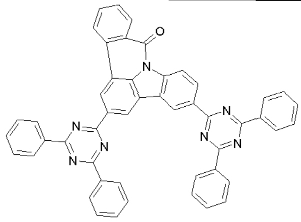 | 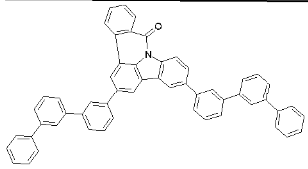 | 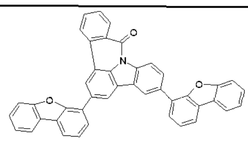 |
| 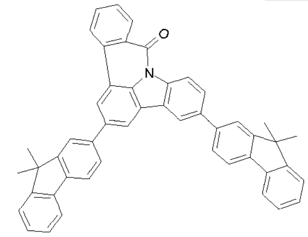 | 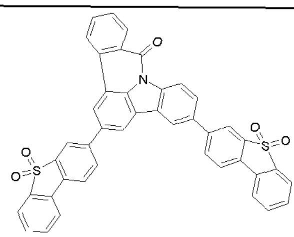 | 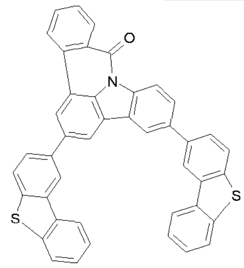 |
| 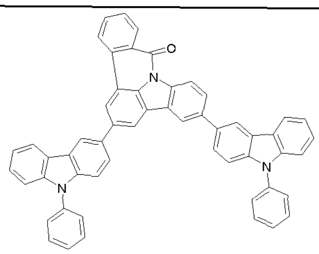 | 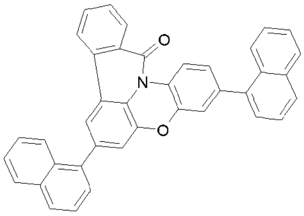 | 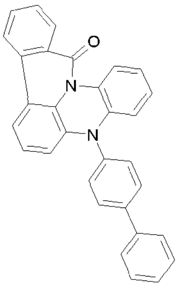 |
| 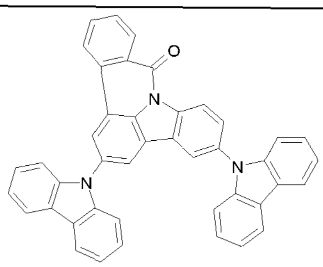 | 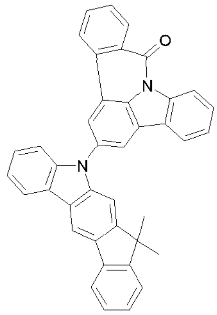 | 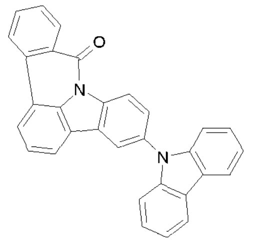 |

| | | |
|---|---|---|
| 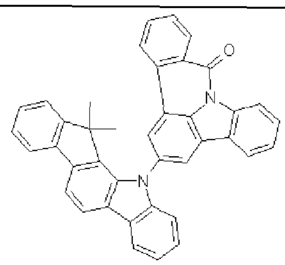 | 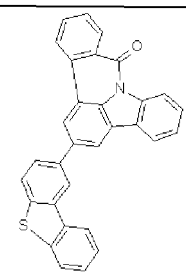 | 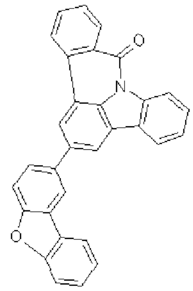 |
| 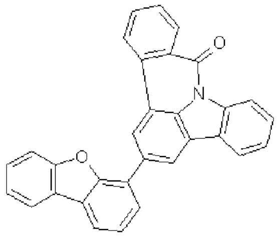 | 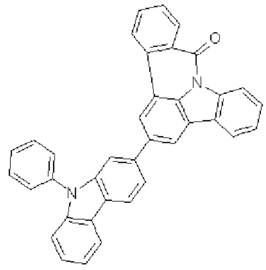 | 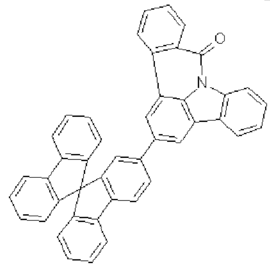 |
| 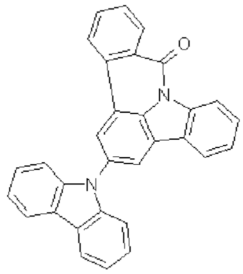 | 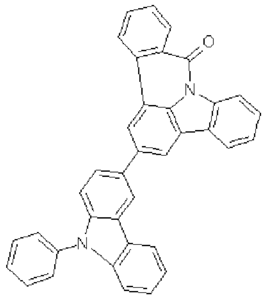 | 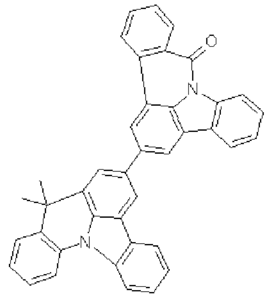 |
| 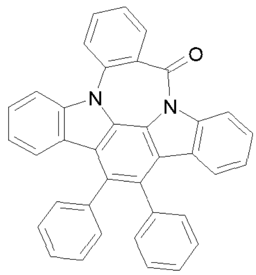 | 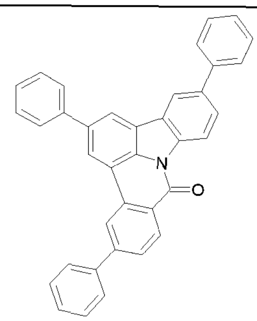 | 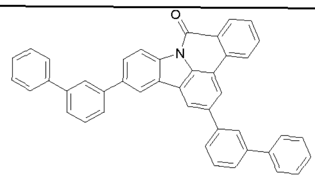 |
| 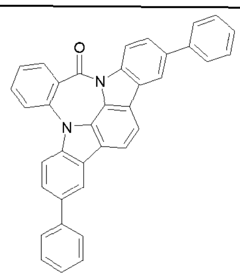 | 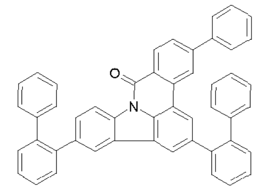 | 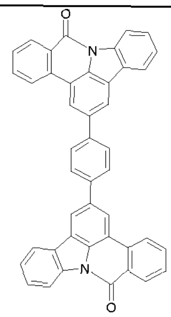 |

| | | |
|---|---|---|
| 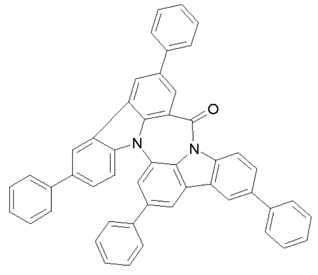 | 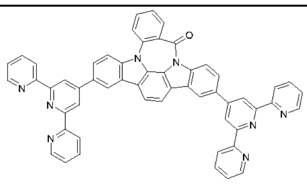 | 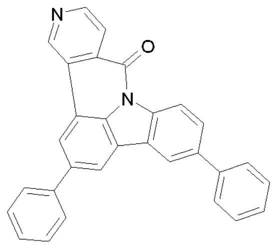 |
| 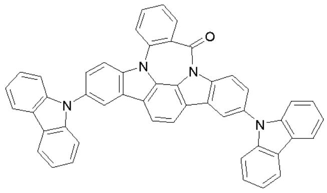 | 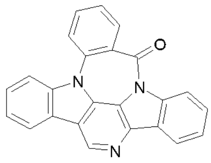 | 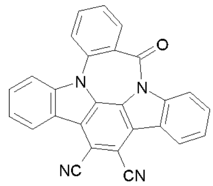 |
| 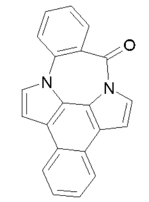 | 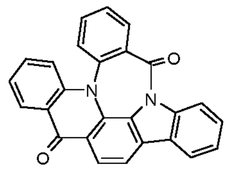 | 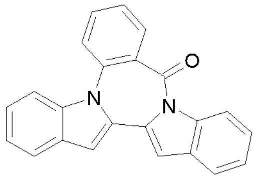 |
| 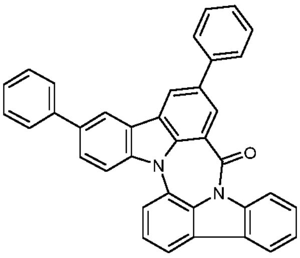 | 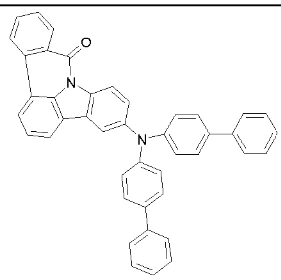 | 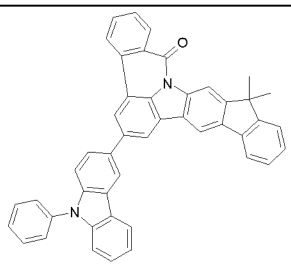 |
| 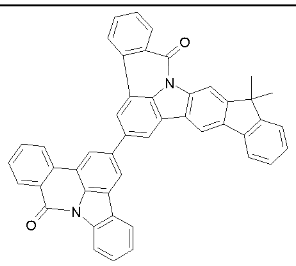 | 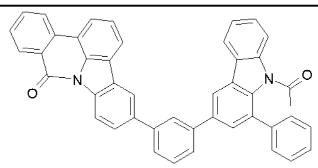 | 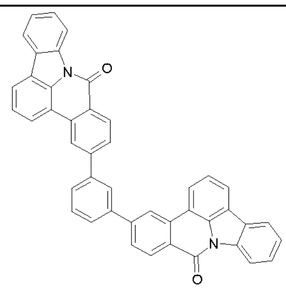 |

Weiterhin eignen sich aromatische Ketone oder aromatische Phosphinoxide als Elektronentransportmaterial in der erfindungsgemäßen Elektronentransportschicht. Unter einem aromatischen Keton im Sinne dieser Anmeldung wird eine Carbonylgruppe verstanden, an die zwei aromatische oder heteroaromatische Gruppen bzw. aromatische oder heteroaromatische Ringsysteme direkt gebunden sind. Unter einem aromatischen Phosphinoxid im Sinne dieser Anmeldung wird eine P=O Gruppe verstanden, an die drei aromatische oder heteroaromatische Gruppen bzw. aromatische oder heteroaromatische Ringsysteme direkt gebunden sind

Wenn das Elektronentransportmaterial in der erfindungsgemäßen Elektronentransportschicht ein aromatisches Keton oder ein aromatisches Phosphinoxid ist, dann ist diese Verbindung bevorzugt ausgewählt aus den Verbindungen der folgenden Formeln (70) bzw. (71),

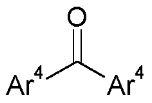

Formel (70)

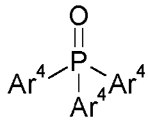

Formel (71)

wobei R, $R^1$, $R^2$ und Ar die oben aufgeführten Bedeutungen hat und für die weiteren verwendeten Symbole gilt:

$Ar^4$ ist bei jedem Auftreten gleich oder verschieden ein aromatisches oder heteroaromatisches Ringsystem mit 5 bis 80 aromatischen Ringatomen, bevorzugt bis 60 aromatischen Ringatomen, welches jeweils mit einer oder mehreren Gruppen R substituiert sein kann.

Geeignete Verbindungen gemäß Formel (70) und (71) sind insbesondere die in WO 2004/093207 und WO 2010/006680 offenbarten Ketone und die in WO 2005/003253 offenbarten Phosphinoxide. Diese sind via Zitat Bestandteil der vorliegenden Erfindung.

Aus der Definition der Verbindung gemäß Formel (70) und (70) geht hervor, dass diese nicht nur eine Carbonylgruppe bzw. Phosphinoxidgruppe enthalten muss, sondern auch mehrere dieser Gruppen enthalten kann.

Bevorzugt ist die Gruppe $Ar^4$ in Verbindungen gemäß Formel (70) bzw. (71) ein aromatisches Ringsystem mit 6 bis 40 aromatischen Ringatomen, d. h. sie enthält keine Heteroarylgruppen. Wie oben definiert, muss das aromatische Ringsystem nicht notwendigerweise nur aromatische Gruppen aufweisen, sondern es können auch zwei Arylgruppen durch eine nicht-aromatische Gruppe, beispielsweise durch eine weitere Carbonylgruppe bzw. Phosphinoxidgruppe unterbrochen sein.

In einer weiteren bevorzugten Ausführungsform der Erfindung weist die Gruppe $Ar^4$ nicht mehr als zwei kondensierte Ringe auf. Sie ist also bevorzugt nur aus Phenyl- und/oder Naphthylgruppen, besonders bevorzugt nur aus Phenylgruppen, aufgebaut, enthält aber keine größeren kondensierten Aromaten, wie beispielsweise Anthracen.

Bevorzugte Gruppen $Ar^4$, die an die Carbonylgruppe gebunden sind, sind Phenyl, 2-, 3- oder 4-Tolyl, 3- oder 4-o-Xylyl, 2- oder 4-m-Xylyl, 2-p-Xylyl, o-, m- oder p-tert-Butylphenyl, o-, m- oder p-Fluorphenyl, Benzophenon, 1-, 2- oder 3-Phenylmethanon, 2-, 3- oder 4-Biphenyl, 2-, 3- oder 4-o-Terphenyl, 2-, 3- oder 4-m-Terphenyl, 2-, 3- oder 4-p-Terphenyl, 2'-p-Terphenyl, 2'-, 4'- oder 5'-m-Terphenyl, 3'- oder 4'-o-Terphenyl, p-, m,p-, o,p-, m,m-, o,m- oder o,o-Quaterphenyl, Quinquephenyl, Sexiphenyl, 1-, 2-, 3- oder 4-Fluorenyl, 2-, 3- oder 4-Spiro-9,9'-bifluorenyl, 1-, 2-, 3- oder 4-(9,10-Dihydro)phenanthrenyl, 1- oder 2-Naphthyl, 2-, 3-, 4-, 5-, 6-, 7- oder 8-Chinolinyl, 1-, 3-, 4-, 5-, 6-, 7- oder 8-iso-Chinolinyl, 1- oder 2-(4-Methylnaphthyl), 1- oder 2-(4-Phenylnaphthyl), 1- oder 2-(4-Naphthyl-naphthyl), 1-, 2- oder 3-(4-naphthyl-phenyl), 2-, 3- oder 4-Pyridyl, 2-, 4- oder 5-Pyrimidinyl, 2- oder 3-Pyrazinyl, 3- oder 4-Pyridanzinyl, 2-(1,3,5-Triazin)yl-, 2-, 3- oder 4-(Phenylpyridyl), 3-, 4-, 5- oder 6-(2,2'-Bipyridyl), 2-, 4-, 5- oder 6-(3,3'-Bipyridyl), 2- oder 3-(4,4'-Bipyridyl) und Kombinationen eines oder mehrerer dieser Reste.

Die Gruppen $Ar^4$ können durch einen oder mehrere Reste R substituiert sein. Diese Reste $R^1$ sind bevorzugt gleich oder verschieden bei jedem Auftreten gewählt aus der Gruppe bestehend aus H, D, F, C(=O)Ar, $P(=O)(Ar)_2$, S(=O)Ar, $S(=O)_2Ar$, einer geradkettigen Alkylgruppe mit 1 bis 4 C-Atomen oder einer verzweigten oder cyclischen Alkylgruppe mit 3 bis 5 C-Atomen, die jeweils mit einem oder mehreren Resten $R^1$ substituiert sein kann, wobei ein oder mehrere H-Atome durch F ersetzt sein können, oder einem aromatischen Ringsystem mit 6 bis 24 aromatischen Ringatomen, das durch einen oder mehrere Reste $R^1$ substituiert sein kann, oder eine Kombination dieser Systeme; dabei können zwei oder mehrere benachbarte Substituenten R auch miteinander ein mono- oder polycyclisches, aliphatisches oder aromatisches Ringsystem bilden. Wenn die organische Elektrolumineszenzvorrichtung aus Lösung aufgebracht wird, sind auch geradkettige, verzweigte oder cyclische Alkylgruppen mit bis zu 10 C-Atomen als Substituenten R bevorzugt. Die Reste R sind besonders bevorzugt gleich oder verschieden bei jedem Auftreten gewählt aus der Gruppe bestehend aus H, C(=O)Ar oder einem aromatischen Ringsystem mit 6 bis 24 aromatischen Ringatomen, das durch einen oder mehrere Reste $R^1$ substituiert sein kann, bevorzugt aber unsubstituiert ist.

In nochmals einer bevorzugten Ausführungsform der Erfindung ist die Gruppe Ar gleich oder verschieden bei jedem Auftreten ein aromatisches Ringsystem mit 6 bis 24 aromatischen Ringatomen, das mit einem oder mehreren Resten $R^1$ substituiert sein kann. Besonders bevorzugt ist Ar gleich oder verschieden bei jedem Auftreten ein aromatisches Ringsystem mit 6 bis 12 aromatischen Ringatomen.

Besonders bevorzugt sind Benzophenon-Derivate, die jeweils an den 3,5,3',5'-Positionen durch ein aromatisches oder heteroaromatisches Ringsystem mit 5 bis 30 aromatischen Ringatomen substituiert sind, welche wiederum durch einen oder mehrere Reste R gemäß der obigen Definition substituiert sein kann. Weiterhin bevorzugt sind Ketone, welche mit mindestens einer Spirobifluorengruppe substituiert sind.

Bevorzugte aromatische Ketone und Phosphinoxide sind daher die Verbindungen der folgenden Formel (72) bis (75),

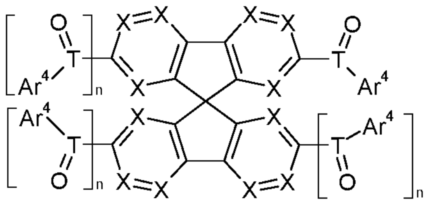

Formel (72)

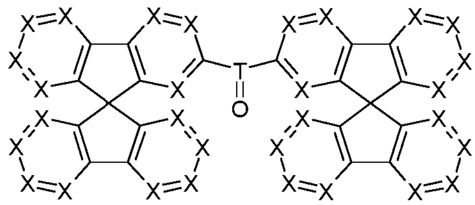

Formel (73)

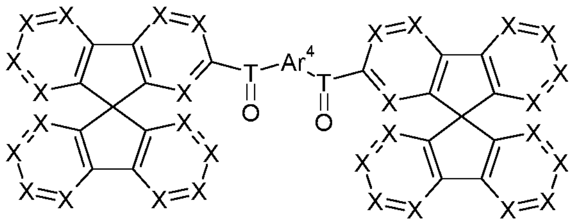

Formel (74)

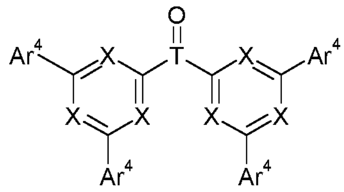

Formel (75)

wobei X, $Ar^4$, R, $R^1$ und $R^2$ dieselbe Bedeutung haben, wie oben beschrieben, und weiterhin gilt:

T ist gleich oder verschieden bei jedem Auftreten C oder $P(Ar^4)$;

n ist gleich oder verschieden bei jedem Auftreten 0 oder 1.

Bevorzugt steht $Ar^4$ in der oben genannten Formel (72) und (75) für ein aromatisches oder heteroaromatisches Ringsystem mit 5 bis 30 aromatischen Ringatomen, welches mit einem oder mehreren Resten $R^1$ substituiert sein kann. Besonders bevorzugt sind die oben genannten Gruppen Ar.

Beispiele für geeignete Verbindungen gemäß Formel (70) und (71) sind die in der folgenden Tabelle abgebildeten Verbindungen.

| | |
|---|---|
| 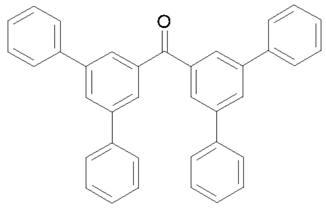 | 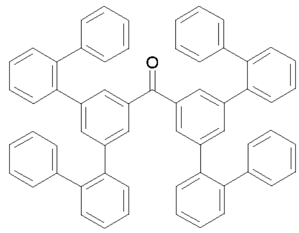 |
| 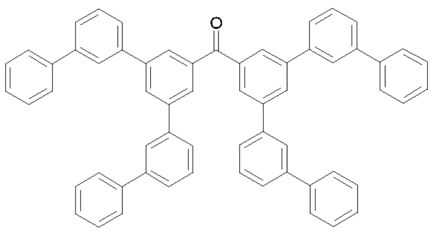 | 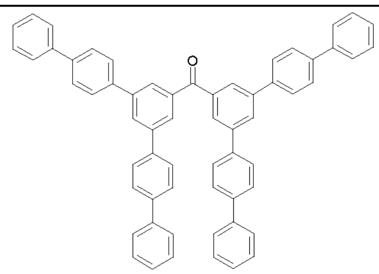 |

| | |
|---|---|
| 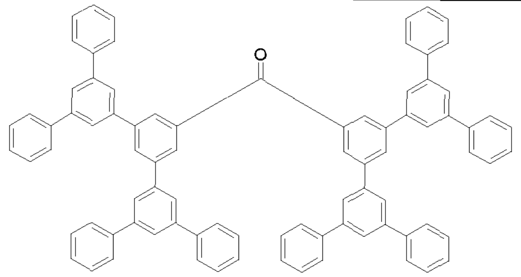 | 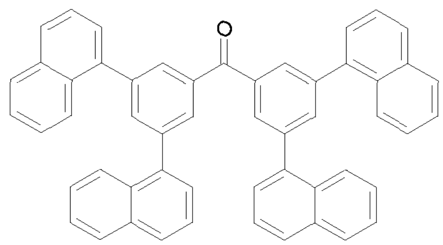 |
| 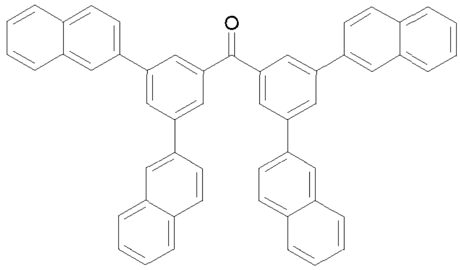 | 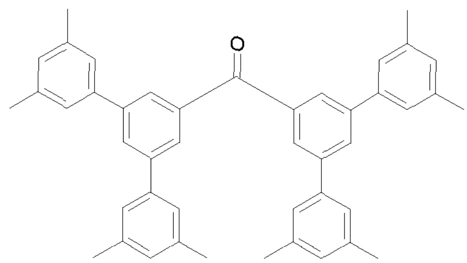 |
| 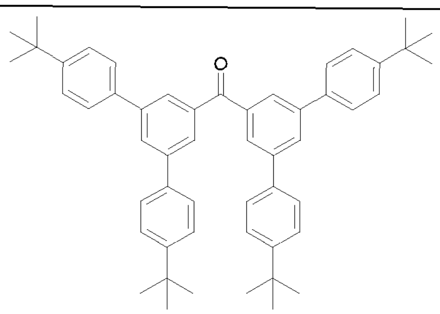 | 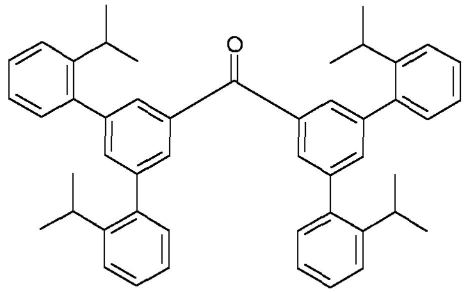 |
| 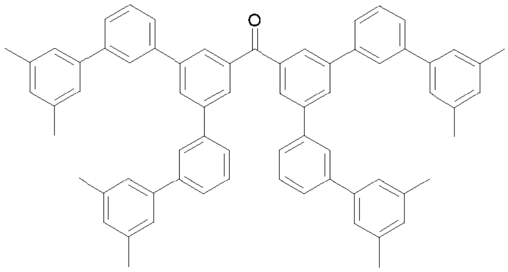 | 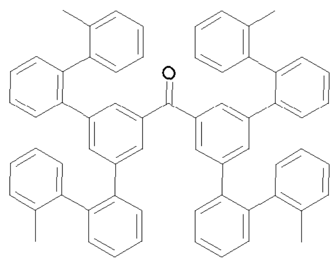 |
| 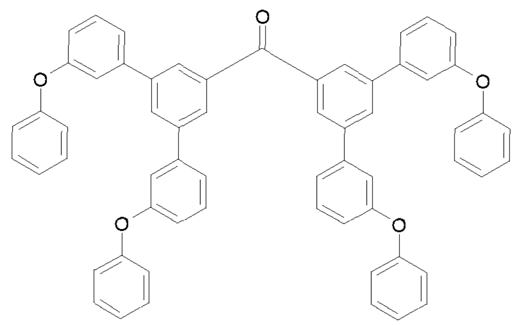 | 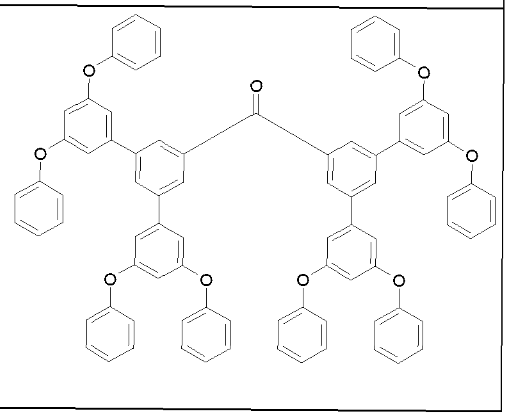 |

| | |
|---|---|
| 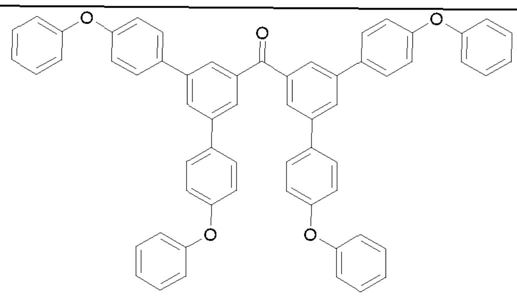 | 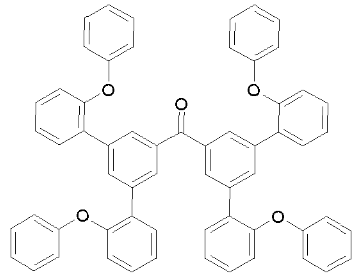 |
| 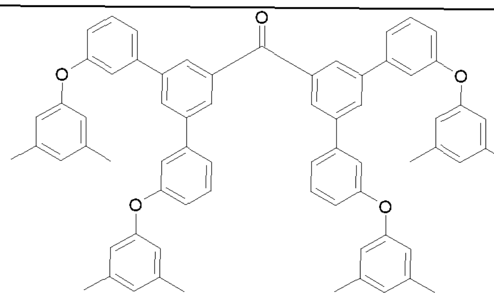 | 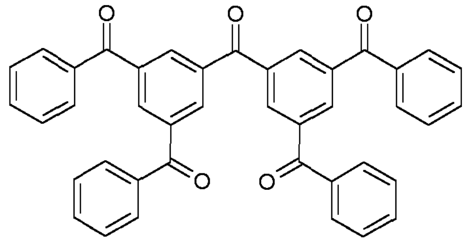 |
| 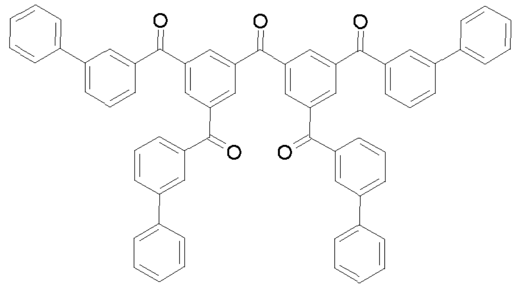 | 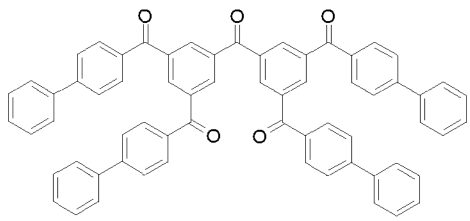 |
| 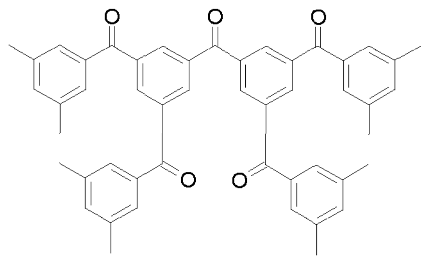 | 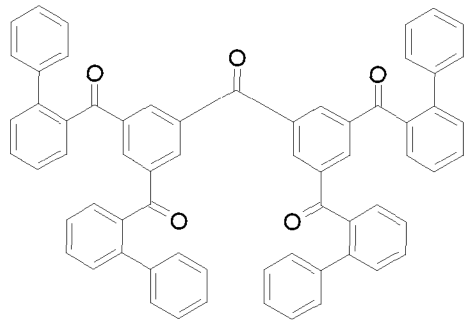 |
| 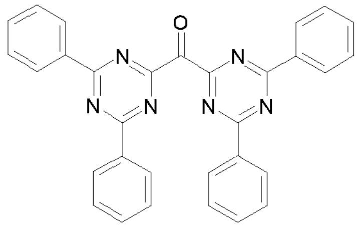 | 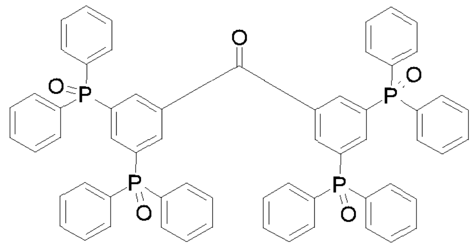 |
| 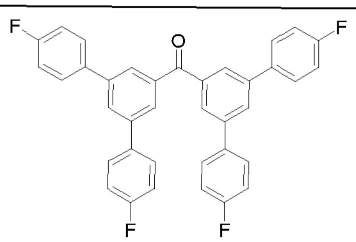 | 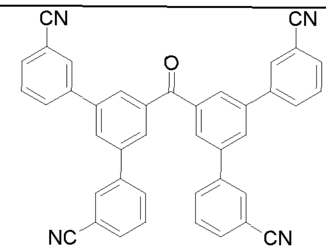 |

| | |
|---|---|
| 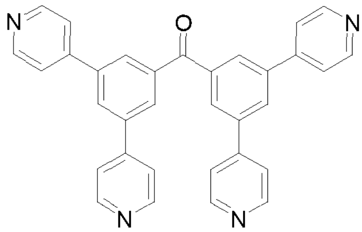 | 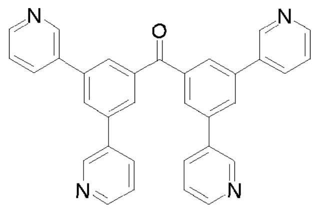 |
| 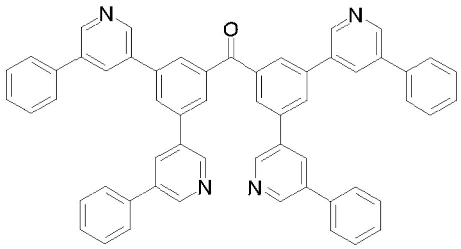 | 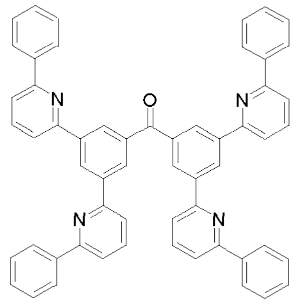 |
| 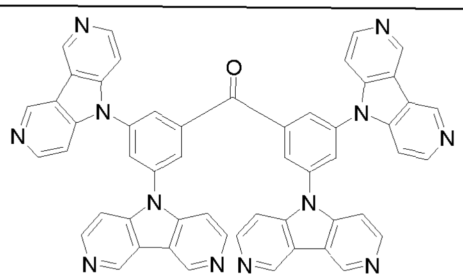 | 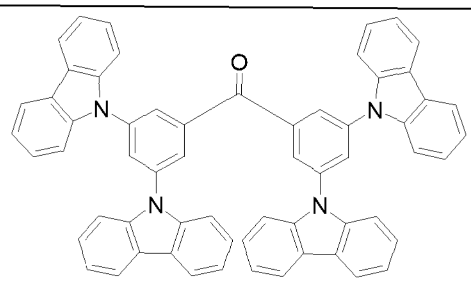 |
| 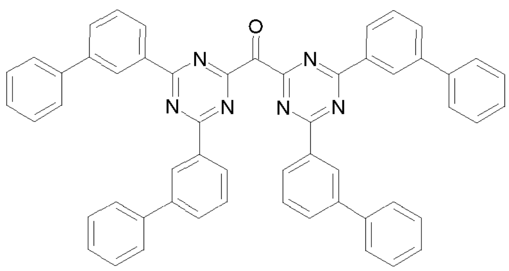 | 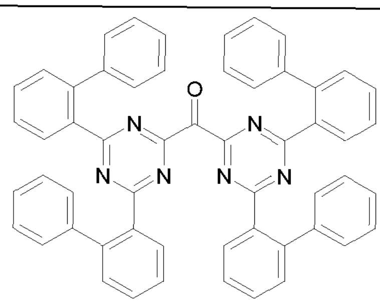 |
| 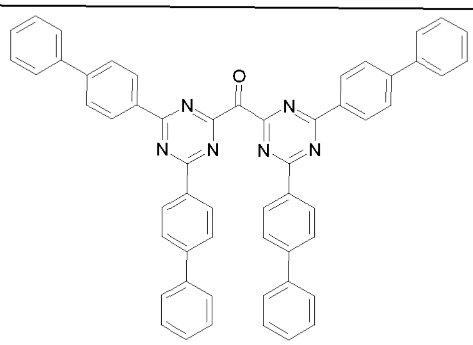 | 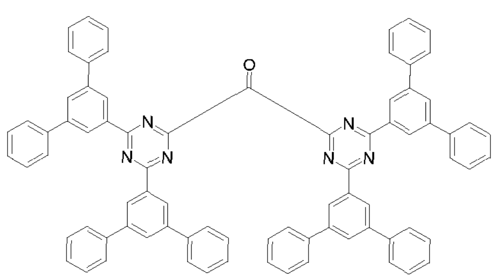 |

| | |
|---|---|
| 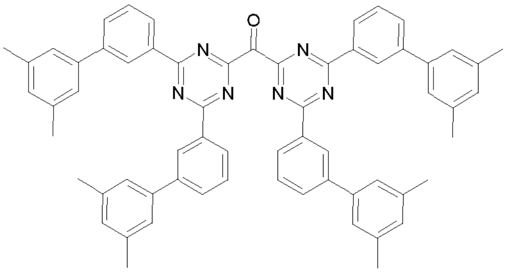 | 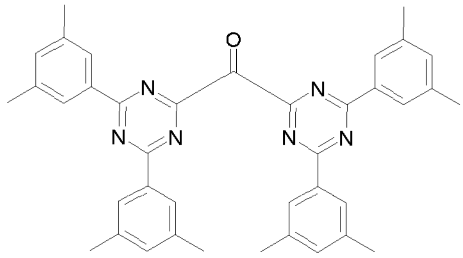 |
| 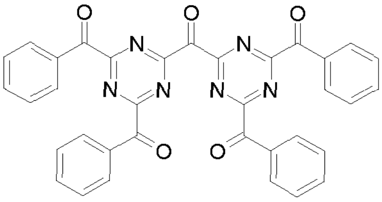 | 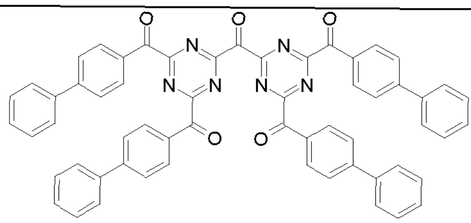 |
| 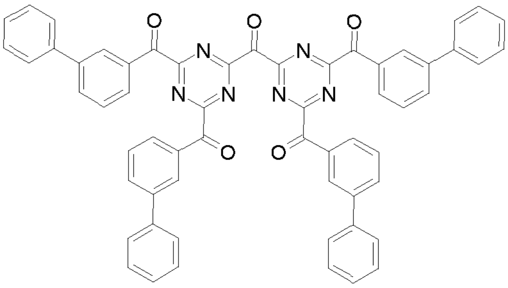 | 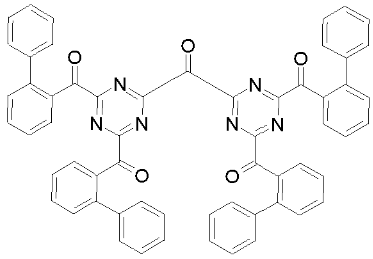 |
| 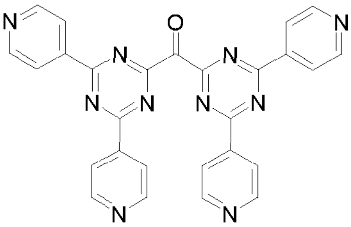 | 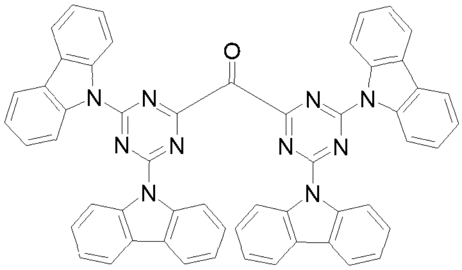 |
| 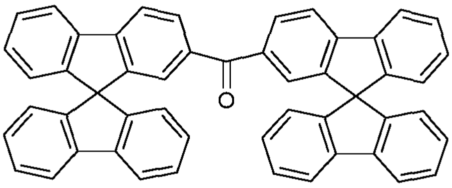 | 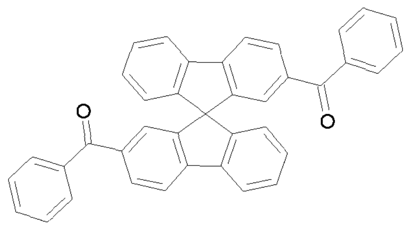 |
| 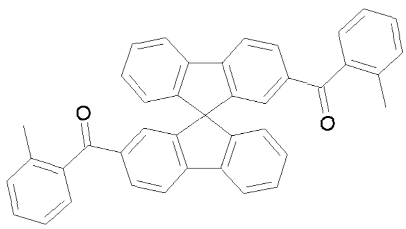 | 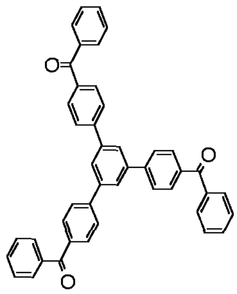 |

| | |
|---|---|
| 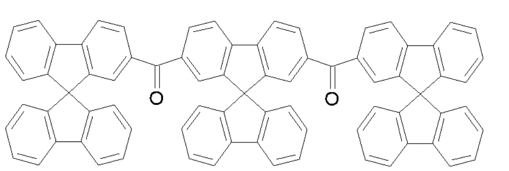 | 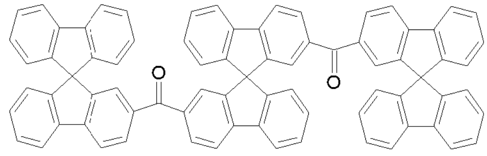 |
| 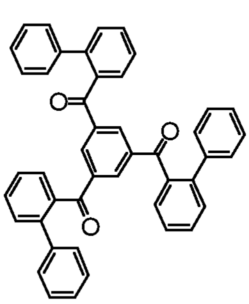 | 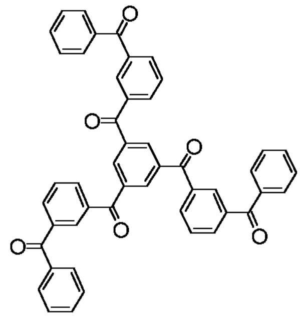 |
| 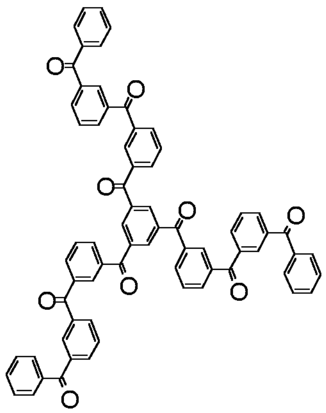 | |

Geeignete Metallkomplexe, die als Elektronentransportmaterial in der erfindungsgemäßen Elektronentransportschicht eingesetzt werden können, sind Be-, Zn- bzw. Al-Komplexe, sofern das LUMO dieser Verbindungen ≤ -2.55 eV beträgt.

Beispiele für geeignete Metallkomplexe sind die in der folgenden Tabelle abgebildeten Verbindungen.

| | | |
|---|---|---|
| 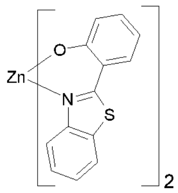 | 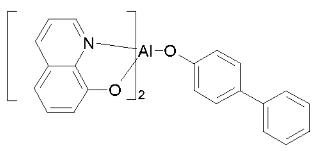 | 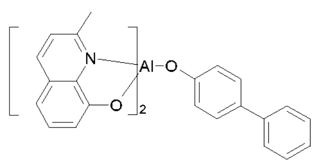 |

| | | |
|---|---|---|
| 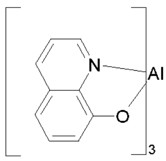 | 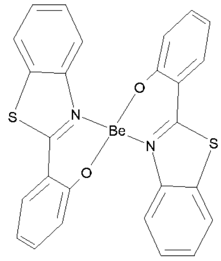 | 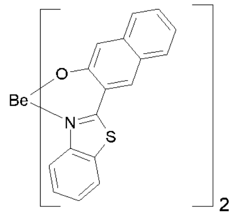 |
| 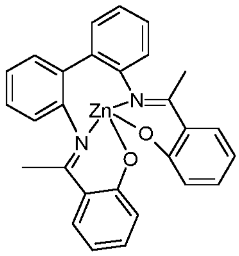 | 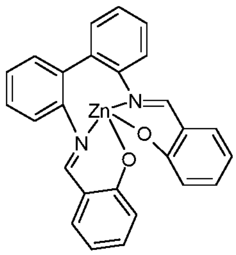 | 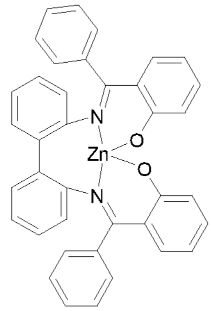 |
| 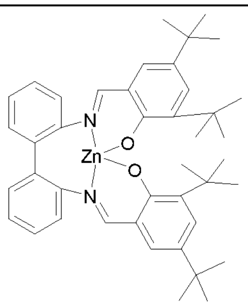 | | |

In einer bevorzugten Ausführungsform der Erfindung handelt es sich bei den Elektronentransportmaterialien mit einem LUMO ≤ -2.55 eV in der erfindungsgemäßen Elektronentransportschichten jedoch um rein organische Materialien, also um Materialien, die kein Metall enthalten.

Geeignete Azaphosphole, die als elektronenleitendes Matrixmaterial in der erfindungsgemäßen organischen Elektrolumineszenzvorrichtung eingesetzt werden können, sind solche Verbindungen, wie sie in WO 2010/054730 offenbart sind, sofern das LUMO dieser Verbindungen ≤ -2.55 eV beträgt. Diese Anmeldung ist via Zitat Bestandteil der vorliegenden Erfindung.

Geeignete Azaborole, die als elektronenleitendes Matrixmaterial in der erfindungsgemäßen organischen Elektrolumineszenzvorrichtung eingesetzt werden können, sind Azaborolderivate, welche mit mindestens einem elektronenleitenden Substituenten substituiert sind, sofern das LUMO dieser Verbindungen ≤ -2.55 eV beträgt. Solche Verbindungen sind in der noch nicht offen gelegten Anmeldung EP 11010103.7 offenbart. Diese Anmeldung ist via Zitat Bestandteil der vorliegenden Erfindung.

Weiterhin geeignet sind Benzimidazolderivate. Damit diese ein LUMO ≤ -2.55 eV aufweisen, ist es bevorzugt, dass an das Benzimidazol direkt oder über eine gegebenenfalls substituierte bivalente aromatische oder heteroaromatische Gruppe eine kondensierte Arylgruppe gebunden ist, insbesondere ein Anthacen, Benzanthracen oder Pyren. Dabei kann sowohl das Benzimidazol wie auch die kondensierte Arylgruppe optional substituiert sein. Geeignete Substituenten sind für die Benzimidazolderivate die oben beschriebenen Reste R.

Im Folgenden wird die organische Elektrolumineszenzvorrichtung näher beschrieben.

Die organische Elektrolumineszenzvorrichtung enthält Kathode, Anode, emittierende Schicht und auf Kathodenseite daran angrenzend mindestens eine Elektronentransportschicht. Außer diesen Schichten kann sie noch weitere Schichten enthalten, beispielsweise jeweils eine oder mehrere Lochinjektionsschichten, Lochtransportschichten, weitere Elektronentransportschichten, Elektroneninjektionsschichten, Exzitonenblockierschichten, Elektronenblockierschichten und/oder Ladungserzeugungsschichten (Charge-Generation Layers). Es sei aber darauf hingewiesen, dass nicht notwendigerweise jede dieser Schichten vorhanden sein muss.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Dabein können

die Lochtransportschichten auch p-dotiert bzw. die Elektronentransportschichten auch n-dotiert sein. Dabei wird unter einer p-dotierten Schicht eine Schicht verstanden, in der freie Löcher erzeugt wurden und deren Leitfähigkeit dadurch erhöht ist. Eine umfassende Diskussion von dotierten Transportschichten in OLEDs findet sich in Chem. Rev. 2007, 107, 1233. Besonders bevorzugt ist der p-Dotand in der Lage, das Lochtransportmaterial in der Lochtransportschicht zu oxidieren, hat also ein ausreichend hohes Redoxpotential, insbesondere ein höheres Redoxpotential als das Lochtransportmaterial. Als Dotanden sind prinzipiell alle Verbindungen geeignet, welche Elektronenakzeptorverbindungen darstellen und die Leitfähigkeit der organischen Schicht durch Oxidation des Hosts erhöhen können. Der Fachmann kann im Rahmen seines allgemeinen Fachwissens ohne größeren Aufwand geeignete Verbindungen identifizieren. Insbesondere geeignet als Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709 und US 2010/0096600 offenbarten Verbindungen.

Der Fachmann kann daher ohne erfinderisches Zutun alle für organische Elektrolumineszenzvorrichtungen bekannten Materialien in Kombination mit der erfindungsgemäßen emittierenden Schicht einsetzen.

Insbesondere kann es bevorzugt sein, wenn zwischen der erfindungsgemäßen Elektronentransportschicht und der Kathode weitere Elektronentransportschichten und/oder Elektroneninjektionsschichten vorliegen. In einer bevorzugten Ausführungsform der Erfindung enthält die weitere Elektronentransportschicht und/oder Elektroneninjektionsschicht eine Lithiumverbindung, beispielsweise LiQ (Lithiumchinolinat). Weitere geeignete Lithiumverbindungen können der WO 2010/072300 entnommen werden.

Weiterhin kann es bevorzugt sein, wenn die Elektronentransportschicht, die an die Kathode oder, falls vorhanden, an die Elektroneninjektionsschicht angrenzt, eine Mischung enthält aus einem Elektronentransportmaterial mit einem LUMO $\leq$ -2.55 eV und einer Lithiumverbindung, insbesondere Lithiumchinolinat oder einem Lithiumchinolinatderivat.

Als Kathode der erfindungsgemäßen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Ebenso bevorzugt sind Metalllegierungen, insbesondere Legierungen aus einem Alkalimetall oder Erdalkalimetall und Silber, besonders bevorzugt eine Legierung aus Mg und Ag. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, CsF, $Cs_2CO_3$, $BaF_2$, MgO, NaF, etc.). Ebenso kommen organische Alkali- oder Erdalkalikomplexe in Frage, wie z. B. Lithiumchinolinat (LiQ). Die Schichtdicke dieser Schicht, die als Elektroneninjektionsschicht anzusehen ist, beträgt bevorzugt zwischen 0.5 und 5 nm.

Als Anode der erfindungsgemäßen Elektrolumineszenzvorrichtung sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/$NiO_x$, Al/$PtO_x$) bevorzugt sein. Dabei muss mindestens eine der Elektroden transparent oder teiltransparent sein, um die Auskopplung von Licht zu ermöglichen. Bevorzugte transparente oder teiltransparente Anodenmaterialien sind leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise

durch geeignete Substitution erhalten werden. Diese Verfahren eignen sich insbesondere auch für Oligomere, Dendrimere und Polymere.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, dadurch gekennzeichnet, dass mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Die erfindungsgemäßen organischen Elektrolumineszenzvorrichtungen zeichnen sich durch einen oder mehrere der folgenden überraschenden Vorteile gegenüber dem Stand der Technik aus:

1. Die erfindungsgemäßen organischen Elektrolumineszenzvorrichtungen weisen eine sehr gute und gegenüber Vorrichtungen gemäß dem Stand der Technik, die ebenfalls TADF zeigen, eine verbesserte Effizienz auf.

2. Die erfindungsgemäßen organischen Elektrolumineszenzvorrichtungen weisen eine sehr geringe Spannung auf.

3. Die erfindungsgemäßen organischen Elektrolumineszenzvorrichtungen weisen eine sehr gute und gegenüber Vorrichtungen gemäß dem Stand der Technik, die ebenfalls TADF zeigen, eine verbesserte Lebensdauer auf.

4. Im Vergleich zu organischen Elektrolumineszenzvorrichtungen gemäß dem Stand der Technik, die Iridium- oder Platinkomplexe als emittierende Verbindungen enthalten, weisen die erfindungsgemäßen Elektrolumineszenzvorrichtungen eine verbesserte Lebensdauer bei erhöhter Temperatur auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

**Beispiele:**

**Bestimmung von HOMO, LUMO, Singulett- und Triplettniveau**

Die HOMO- und LUMO-Energieniveaus sowie die Energie des niedrigsten Triplettzustands $T_1$ bzw. des niedrigsten angeregten Singulettzustands $S_1$ der Materialien werden über quantenchemische Rechnungen bestimmt. Hierzu wird das Programmpaket "Gaussian09W" (Gaussian Inc.) verwendet. Zur Berechnung organischer Substanzen ohne Metalle (in Tabelle 4 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-SFC/DFT/Default Spin/B3PW91" mit dem Basissatz "6-31G(d)" verwendet (Charge 0, Spin Singlet). Für metallhaltige Verbindungen (in Tabelle 4 mit Methode "M-org." bezeichnet) wird die Geometrie über die Methode "Ground State/Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$HOMO(eV) = ((HEh*27.212)-0.9899)/1.1206$$

$$LUMO(eV) = ((LEh*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

In Tabelle 4 sind die HOMO- und LUMO-Energieniveaus sowie $S_1$ und $T_1$ der verschiedenen Materialien angegeben.

**Bestimmung der PL-Quanteneffizienz (PLQE)**

Von den in den verschiedenen OLEDs verwendeten Emissionsschichten wird ein 50 nm dicker Film auf ein geeignetes transparentes Substrat, vorzugsweise Quarz, aufgebracht, d. h. die Schicht enthält dieselben Materialien in derselben Konzentration wie in der OLED. Hierbei werden die gleichen Herstellungsbedingungen wie bei der Herstellung der Emissionsschicht für die OLEDs verwendet. Von diesem Film wird ein Absorptionsspektrum im Wellenlängenbereich von 350-500 nm gemessen. Hierzu wird das Reflexionsspektrum $R(\lambda)$ sowie das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-R(\lambda)-T(\lambda)$ definiert.

Gilt $A(\lambda) \leq 0.3$ im Bereich 350-500nm, so wird die zum Maximum des Absorptionsspektrums gehörige Wellenlänge im Bereich 350-500 nm als $\lambda_{exc}$ definiert. Gilt für irgendeine Wellenlänge $A(\lambda) > 0.3$, so wird als $\lambda_{exc}$ die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anregungslichts ist in etwa gaußförmig mit einer Halbwertsbreite < 10 nm und Peakwellenlänge $\lambda_{exc}$ wie oben definiert.

Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al., Nature 2012, Vol. 492, 234).

In Tabelle 2 ist die PLQE für die Emissionsschichten der OLEDs wie oben definiert zusammen mit der verwendeten Anregungswellenlänge angegeben.

**Bestimmung der Abklingzeit**

Zur Bestimmung der Abklingzeit wird eine Probe verwendet, die wie oben unter "Bestimmung der PL-Quanteneffizienz (PLQE)" beschrieben hergestellt wird. Die Probe wird bei einer Temperatur von 295 K durch einen Laserpuls angeregt (Wellenlänge 266 nm, Pulsdauer 1.5 ns, Pulsenergie 200 µJ, Strahldurchmesser 4 mm). Die Probe befindet sich hierbei im Vakuum ($<10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z.B. H. Uoyama et al., Nature, vol. 492, no. 7428, pp. 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$, zu dem die prompte Fluoreszenz deutlich unter die Intensität der verzögerten Fluoreszenz abgeklungen ist (<1%), so dass die folgende Bestimmung der Abklingzeit davon nicht beeinflusst wird. Diese Wahl kann von einem Fachmann durchgeführt werden. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

Tabelle 2 zeigt die Werte von $t_a$ und $t_d$, die für die Emissionsschichten der erfindungsgemäßen OLEDs ermittelt werden.

**Beispiele: Herstellung der OLEDs**

In den folgenden Beispielen V1 bis E16 (siehe Tabellen 1 und 2) werden die Daten verschiedener OLEDs vorgestellt.

Glasplättchen, die mit strukturiertem ITO (Indium Zinn Oxid) der Dicke 50 nm beschichtet sind, bilden die Substrate für die OLEDs. Die Substrate werden nass gereinigt (Spülmaschine, Reiniger Merck Extran), anschließend 15 min lang bei 250 °C ausgeheizt und vor der Beschichtung 130s lang mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt spätestens 10 min nach der Plasmabehandlung.

Die OLEDs haben prinzipiell folgenden Schichtaufbau: Substrat / optionale Lochinjektionsschicht (HIL) / optionale Lochtransportschicht (HTL) / optionale Zwischenschicht (IL) / Elektronenblockerschicht (EBL) / Emissionsschicht

(EML) / optionale Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt.

Alle Materialien werden in einer Vakuumkammer thermisch aufgedampft. Dabei besteht die Emissionsschicht immer aus einem Matrixmaterial (Hostmaterial, Wirtsmaterial) und der emittierenden TADF-Verbindung, also dem Material, das einen kleinen energetischen Abstand zwischen $S_1$ und $T_1$ zeigt. Dieses wird dem Matrixmaterial durch Coverdampfung in einem bestimmten Volumenanteil beigemischt. Eine Angabe wie IC1:D1 (95%:5%) bedeutet hierbei, dass das Material IC1 in einem Volumenanteil von 95% und D1 in einem Anteil von 5% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 2 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$.

Der Roll-off wird definiert als EQE bei 5000 cd/$m^2$ geteilt durch EQE bei 500 cd/$m^2$, d.h. ein hoher Wert entspricht einem geringen Abfall der Effizienz bei hohen Leuchtdichten, was vorteilhaft ist.

Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10mA/$cm^2$, L1 = 80% in Tabelle 2 bedeutet, dass die Leuchtdichte bei Betrieb mit 10 mA/$cm^2$ nach der Zeit LD auf 80% ihres Anfangswertes absinkt.

Als emittierender Dotand in der Emissionsschicht wird die Verbindung D1 eingesetzt, die einen energetischen Abstand zwischen $S_1$ und $T_1$ von 0.09 eV aufweist oder die Verbindung D2, für die Differenz zwischen $S_1$ und $T_1$ 0.06eV beträgt

Die Daten der verschiedenen OLEDs sind in Tabelle 2 zusammengefasst. Die Beispiele V1-V11 sind Vergleichsbeispiele gemäß dem Stand der Technik, die Beispiele E1-E16 zeigen Daten von erfindungsgemäßen OLEDs.

Wie sich der Tabelle entnehmen lässt, erhält man mit erfindungsgemäßen Elektronentransportschichten deutliche Verbesserungen bezüglich Spannung und Effizienz, was zu einer deutlichen Verbesserung der Leistungseffizienz führt. Weiterhin erhält man bessere Lebensdauer und in vielen Fällen zusätzlich eine Verbesserung des Roll-off Verhaltens. Diese Vorteile gelten sowohl, wenn nur eine Schicht zwischen EML und Kathode angeordnet ist (Beispiele V1, V2 und E7-E10), aber auch, wenn mehrere Schichten zwischen EML und Kathode angeordnet sind und alle Schichten ein solches niedriges LUMO aufweisen (Beispiele V3-V11, E1-E6, E11-E16).

Tabelle 1: Aufbau der OLEDs

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| | | | | | | | | |
| V1 | --- | --- | --- | NPB 90nm | CBP:D1 (95%:5%) 15nm | --- | BCP 50nm | LiQ 3nm |
| V2 | NPB:F4T (95%:5%) 10nm | --- | --- | NPB 80nm | CBP:D1 (95%:5%) 15nm | --- | BCP 50nm | LiQ 3nm |
| V3 | HAT 5nm | SpA1 70nm | HAT 5nm | SpMA1 20nm | BCP:D1 (95%:5%) 15nm | BCP 10nm | ST2 40nm | LiQ 3nm |
| V4 | HAT 5nm | SpA1 70nm | HAT 5nm | SpMA1 20nm | BCP:D1 (95%:5%) 15nm | CBP 10nm | ST2 40nm | LiQ 3nm |
| V5 | SpMA1:F4T (95%:5%) 10nm | --- | | SpMA1 80nm | IC1:D1 (95%:5%) 15nm | BCP 10nm | ST2 40nm | LiQ 3nm |

(fortgesetzt)

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| V6 | SpMA1:F4T (95%:5%) 10nm | --- | | SpMA1 80nm | IC1:D1 (95%:5%) 15nm | CBP 10nm | ST2 40nm | LiQ 3nm |
| V7 | HAT 5nm | SpA1 70nm | HAT 5nm | SpMA1 20nm | IC1:D1 (95%:5%) 15nm | BCP 10nm | ST2 40nm | LiQ 3nm |
| V8 | --- | --- | --- | SpMA1 90nm | CBP:D2 (95%:5%) 15nm | IC1 10nm | TPBI 45nm | LiQ 3nm |
| V9 | --- | --- | --- | SpMA1 90nm | IC1:D2 (95%:5%) 15nm | IC1 10nm | TPBI 45nm | LiQ 3nm |
| V10 | --- | --- | --- | SpMA1 90nm | IC6:D2 (95%:5%) 15nm | IC1 10nm | TPBI 45nm | LiQ 3nm |
| V11 | --- | --- | --- | SpMA1 90nm | L1:D2 (95%: 5%) 15nm | IC1 10nm | TPBI 45nm | LiQ 3nm |
| E1 | HAT 5nm | SpA1 70nm | HAT 5nm | SpMA1 20nm | IC1:D1 (95%:5%) 15nm | IC1 10nm | ST2:LiQ (50%:50%) 40nm | --- |
| E2 | HAT 5nm | SpA1 70nm | HAT 5nm | SpMA1 20nm | IC5:D1 (95%:5%) 15nm | IC1 10nm | ST2:LiQ (50%:50%) 40nm | --- |
| E3 | HAT 5nm | SpA1 70nm | HAT 5nm | SpMA1 20nm | IC1:D1 (95%:5%) 15nm | IC1 10nm | ST2 40nm | LiQ 3nm |
| E4 | HAT 5nm | SpA1 70nm | HAT 5nm | SpMA1 20nm | IC1:D1 (95%:5%) 15nm | IC5 10nm | ST2 40nm | LiQ 3nm |
| E5 | SpMA1:F4T (95%:5%) 10nm | SpMA1 80nm | --- | IC2 10nm | IC1:D1 (95%:5%) 15nm | IC1 10nm | ST2:LiQ (50%:50%) 40nm | --- |
| E6 | HAT 5nm | SpA1 70nm | HAT 5nm | SpMA1 20nm | IC3:D1 (95%:5%) 15nm | IC1 10nm | ST2:LiQ (50%:50%) 40nm | --- |
| E7 | --- | --- | --- | NPB 90nm | CBP:D1 (95%:5%) 15nm | --- | ST2 50nm | LiQ 3nm |
| E8 | NPB:F4T (95%:5%) 10nm | --- | --- | NPB 90nm | CBP:D1 (95%:5%) 15nm | --- | ST2 50nm | LiQ 3nm |
| E9 | --- | --- | --- | NPB 90nm | CBP:D1 (95%:5%) 15nm | --- | IC1 50nm | LiQ 3nm |

(fortgesetzt)

| Bsp | HIL Dicke | HTL Dicke | IL Dicke | EBL Dicke | EML Dicke | HBL Dicke | ETL Dicke | EIL Dicke |
|---|---|---|---|---|---|---|---|---|
| E10 | NPB:F4T (95%:5%) 10nm | --- | --- | NPB 80nm | CBP:D1 (95%:5%) 15nm | --- | IC1 50nm | LiQ 3nm |
| E11 | HAT 5nm | SpA1 70nm | HAT 5nm | SpMA1 20nm | BCP:D1 (95%:5%) 15nm | IC1 10nm | ST2 40nm | LiQ 3nm |
| E12 | SpMA1:F4T (95%:5%) 10nm | --- | | SpMA1 80nm | IC1:D1 (95%:5%) 15nm | IC1 10nm | ST2 40nm | LiQ 3nm |
| E13 | SpMA1:F4T (95%:5%) 10nm | --- | | SpMA1 80nm | IC1:D1 (95%:5%) 15nm | IC5 10nm | ST2 40nm | LiQ 3nm |
| E14 | HAT 5nm | SpA1 70nm | HAT 5nm | SpMA1 20nm | CBP:D1 (95%:5%) 15nm | IC1 10nm | ST2:LiQ (50%:50%) 40nm | --- |
| E15 | HAT 5nm | SpA1 70nm | HAT 5nm | SpMA1 20nm | CBP:D1 (95%:5%) 30nm | IC1 10nm | ST2 40nm | LiQ 3nm |
| E16 | SpMA1:F4T (95%:5%) 10nm | SpMA1 80nm | --- | IC2 10nm | CBP:D1 (95%:5%) 15nm | IC1 10nm | ST2:LiQ (50%:50%) 40nm | --- |
| E17 | --- | --- | --- | SpMA1 90nm | CBP:D2 (95%:5%) 15nm | IC1 10nm | ST2 45nm | LiQ 3nm |
| E18 | --- | --- | --- | SpMA1 90nm | IC1:D2 (95%:5%) 15nm | IC1 10nm | ST2 45nm | LiQ 3nm |
| E19 | --- | --- | --- | SpMA1 90nm | IC6:D2 (95%:5%) 15nm | IC1 10nm | ST2 45nm | LiQ 3nm |
| E20 | --- | --- | --- | SpMA1 90nm | L1:D2 (95%: 5%) 15nm | IC1 10nm | ST2 45nm | LiQ 3nm |

Tabelle 2: Daten der OLEDs

| Bsp | U1000 (V) | SE1000 (cd/A) | LE1000 (lm/W) | EQE 1000 | CIE x/y bei 1000 cd/m$^2$ | Roll-Off | L0;j0 | L1 % | LD (h) | PLQE % | $\lambda_{exc}$ nm | $t_d$ µs | $t_a$ µs |
|---|---|---|---|---|---|---|---|---|---|---|---|---|---|
| V1 | 6.0 | 30 | 16 | 9.3% | 0.28/0.59 | 0.68 | 10mA/cm$^2$ | 80 | 2 | 100 | 350 | 7 | 4.5 |
| V2 | 5.6 | 31 | 18 | 9.7% | 0.27/0.59 | 0.70 | 10mA/cm$^2$ | 80 | 3 | 100 | 350 | 7 | 4.5 |
| V3 | 7.8 | 4.2 | 1.7 | 1.4% | 0.27/0.55 | 0.63 | 10mA/cm$^2$ | 80 | 1 | 59 | 350 | 6 | 5.9 |
| V4 | 10.8 | 1.5 | 0.4 | 0.5% | 0.28/0.54 | 0.73 | 10mA/cm$^2$ | 80 | 1 | 59 | 350 | 6 | 5.9 |
| V5 | 4.1 | 16.6 | 12.8 | 5.2% | 0.26/0.58 | 0.60 | 10mA/cm$^2$ | 80 | 8 | 92 | 350 | 7 | 5.4 |
| V6 | 4.2 | 11.0 | 8.2 | 3.6% | 0.25/0.55 | 0.46 | 10mA/cm$^2$ | 80 | 4 | 92 | 350 | 7 | 5.4 |
| V7 | 4.1 | 17.2 | 13.2 | 5.4% | 0.26/0.58 | 0.69 | 10mA/cm$^2$ | 80 | 12 | 92 | 350 | 7 | 5.4 |
| V8 | 9.2 | 12.5 | 4.3 | 4.7% | 0.49/0.47 | 0.72 | 10mA/cm$^2$ | 80 | 5 | 43 | 350 | 6 | 5.1 |
| V9 | 7.0 | 15.0 | 6.7 | 5.6% | 0.50/0.48 | 0.84 | 10mA/cm$^2$ | 80 | 15 | 41 | 350 | 7 | 4.6 |
| V10 | 9.2 | 10.5 | 3.6 | 4.3% | 0.51/0.46 | 0.81 | 10mA/cm$^2$ | 80 | 26 | 37 | 350 | 6 | 5.3 |
| V11 | 7.1 | 15.5 | 6.9 | 6.1% | 0.51/0.47 | 0.79 | 10mA/cm$^2$ | 80 | 31 | 46 | 368 | 7 | 4.3 |
| E1 | 3.6 | 65 | 56 | 20.8% | 0.25/0.58 | 0.72 | 10mA/cm$^2$ | 80 | 44 | 92 | 350 | 7 | 5.4 |
| E2 | 3.5 | 43 | 39 | 13.3% | 0.32/0.58 | 0.66 | 10mA/cm$^2$ | 80 | 63 | 57 | 350 | 4 | 4.0 |
| E3 | 3.3 | 67 | 64 | 21.0% | 0.26/0.58 | 0.79 | 10mA/cm$^2$ | 80 | 28 | 92 | 350 | 7 | 5.4 |
| E4 | 3.2 | 56 | 56 | 17.6% | 0.27/0.58 | 0.75 | 10mA/cm$^2$ | 80 | 22 | 92 | 350 | 7 | 5.4 |
| E5 | 3.6 | 68 | 59 | 21.5% | 0.26/0.58 | 0.73 | 10mA/cm$^2$ | 80 | 52 | 92 | 350 | 7 | 5.4 |
| E6 | 3.2 | 52 | 52 | 15.7% | 0.31/0.60 | 0.71 | 10mA/cm$^2$ | 80 | 88 | 77 | 350 | 7 | 7.0 |
| E7 | 4.3 | 36 | 27 | 11.3% | 0.28/0.59 | 0.65 | 10mA/cm$^2$ | 80 | 59 | 100 | 350 | 7 | 4.5 |
| E8 | 3.7 | 55 | 38 | 13.7% | 0.27/0.59 | 0.66 | 10mA/cm$^2$ | 80 | 84 | 100 | 350 | 7 | 4.5 |
| E9 | 4.7 | 34 | 23 | 10.6% | 0.27/0.58 | 0.58 | 10mA/cm$^2$ | 80 | 8 | 100 | 350 | 7 | 4.5 |
| E10 | 4.3 | 37 | 27 | 11.8% | 0.26/0.58 | 0.61 | 10mA/cm$^2$ | 80 | 9 | 100 | 350 | 7 | 4.5 |
| E11 | 6.7 | 4.9 | 2.3 | 1.6% | 0.26/0.56 | 0.65 | 10mA/cm$^2$ | 80 | 1 | 59 | 350 | 6 | 5.9 |
| E12 | 3.2 | 64 | 62 | 20.1% | 0.26/0.58 | 0.74 | 10mA/cm$^2$ | 80 | 30 | 92 | 350 | 7 | 5.4 |
| E13 | 3.2 | 56 | 56 | 17.6% | 0.27/0.58 | 0.70 | 10mA/cm$^2$ | 80 | 24 | 92 | 350 | 7 | 5.4 |
| E14 | 4.2 | 44 | 33 | 14.1% | 0.25/0.58 | 0.60 | 10mA/cm$^2$ | 80 | 23 | 100 | 350 | 7 | 4.5 |

(fortgesetzt)

| Bsp | U1000 (V) | SE1000 (cd/A) | LE1000 (lm/W) | EQE 1000 | CIE x/y bei 1000 cd/m$^2$ | Roll-Off | L0;j0 | L1 % | LD (h) | PLQE % | $\lambda_{exc}$ nm | $t_d$ $\mu$s | $t_a$ $\mu$s |
|---|---|---|---|---|---|---|---|---|---|---|---|---|---|
| E15 | 5.1 | 44 | 27 | 13.6% | 0.27/0.58 | 0.73 | 10mA/cm$^2$ | 80 | 21 | 100 | 350 | 7 | 4.5 |
| E16 | 4.1 | 49 | 38 | 15.4% | 0.27/0.58 | 0.63 | 10mA/cm$^2$ | 80 | 34 | 100 | 350 | 7 | 4.5 |
| E17 | 8.1 | 20 | 7.6 | 6.7% | 0.49/0.49 | 0.64 | 10mA/cm$^2$ | 80 | 14 | 43 | 350 | 6 | 5.1 |
| E18 | 5.3 | 27 | 16 | 9.6% | 0.51/0.48 | 0.80 | 10mA/cm$^2$ | 80 | 69 | 41 | 350 | 7 | 4.6 |
| E19 | 8.1 | 14.4 | 5.6 | 5.8% | 0.52/0.46 | 0.77 | 10mA/cm$^2$ | 80 | 68 | 37 | 350 | 6 | 5.3 |
| E20 | 5.8 | 20 | 10.8 | 7.8% | 0.52/0.47 | 0.76 | 10mA/cm$^2$ | 80 | 165 | 46 | 368 | 7 | 4.3 |

Tabelle 3: Strukturformeln der Materialien für die OLEDs

| | |
|---|---|
| 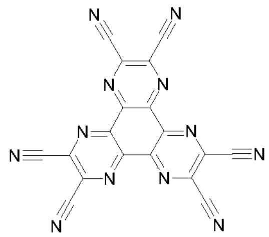 | 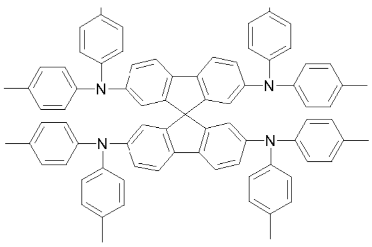 |
| HAT | SpA1 |
| 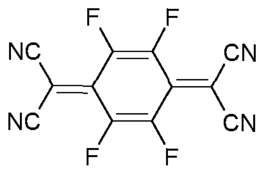 | 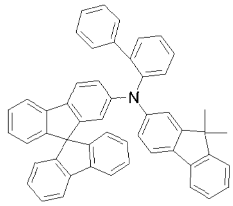 |
| F4T | SpMA1 |
| 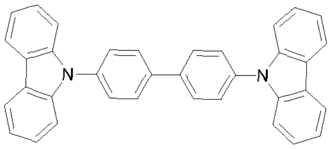 | 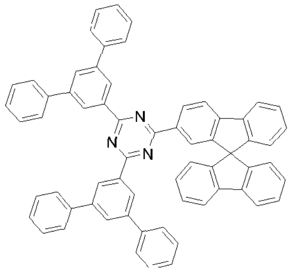 |
| CBP | ST2 |
| 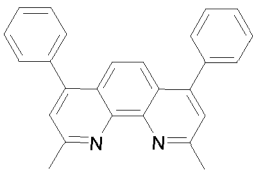 | 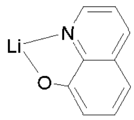 |
| BCP | LiQ |
| 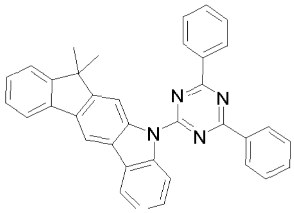 | 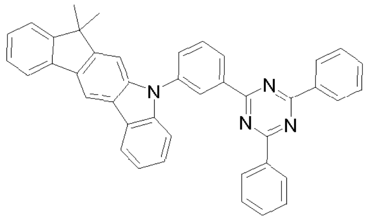 |
| IC1 | IC5 |
| 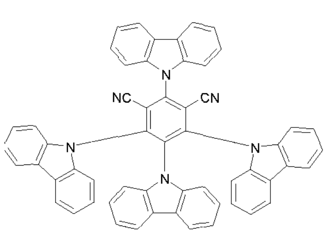 | 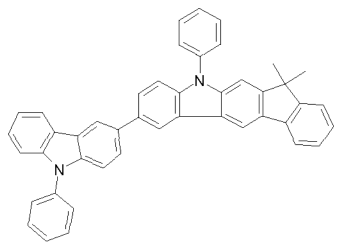 |

(fortgesetzt)

| D1 | IC2 |
|---|---|
| 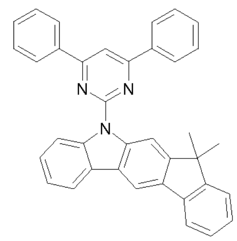 | 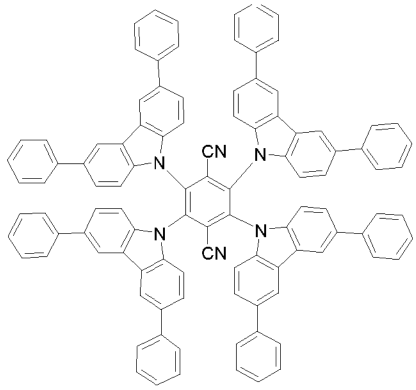 |
| IC3 | D2 |
| 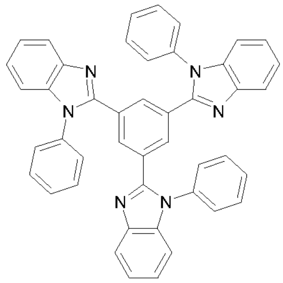 | 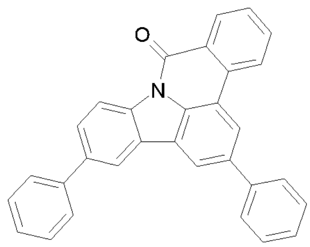 |
| TPBI | L1 |
| 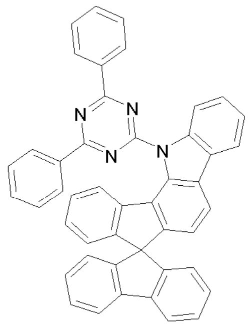 | |
| IC6 | |

Tabelle 4: HOMO, LUMO, $T_1$, $S_1$ der relevanten Materialien

| Material | Methode | HOMO (eV) | LUMO (eV) | $S_1$ (eV) | $T_1$ (eV) |
|---|---|---|---|---|---|
| D1 | org. | -6.11 | -3.40 | 2.50 | 2.41 |
| D2 | org. | -5.92 | -3.61 | 2.09 | 2.03 |
| CBP | org. | -5.67 | -2.38 | 3.59 | 3.11 |
| BCP | org. | -6.15 | -2.44 | 3.61 | 2.70 |
| IC1 | org. | -5.79 | -2.83 | 3.09 | 2.69 |
| IC5 | org. | -5.56 | -2.87 | 2.87 | 2.72 |
| IC3 | org. | -5.62 | -2.75 | 3.02 | 2.75 |
| SpA1 | org. | -4.87 | -2.14 | 2.94 | 2.34 |

(fortgesetzt)

| Material | Methode | HOMO (eV) | LUMO (eV) | $S_1$ (eV) | $T_1$ (eV) |
|---|---|---|---|---|---|
| SpMA1 | org. | -5.25 | -2.18 | 3.34 | 2.58 |
| IC2 | org. | -5.40 | -2.11 | 3.24 | 2.80 |
| HAT | org. | -8.86 | -4.93 | | |
| F4T | org. | -7.91 | -5.21 | | |
| ST2 | org. | -6.03 | -2.82 | 3.32 | 2.68 |
| LiQ | M-org. | -5.17 | -2.39 | 2.85 | 2.13 |
| TPBI | org. | -6.26 | -2.48 | 3.47 | 3.04 |
| L1 | org. | -6.09 | -2.80 | 2.70 | 3.46 |
| IC6 | org. | -5.87 | -2.85 | 2.72 | 3.14 |

## Patentansprüche

1. Organische Elektrolumineszenzvorrichtung, enthaltend Kathode, Anode und emittierende Schicht, die mindestens eine lumineszente organische Verbindung enthält, die eine aromatische Verbindung ist, die sowohl Donor- wie auch Akzeptorsubstituenten aufweist, wobei die Donorsubstituenten gewählt sind aus der Gruppe bestehend aus Diaryl- bzw. heteroarylaminogruppe, Carbazolgruppen und Carbazolderivaten, die jeweils auch substituiert sein können, und wobei die Akzeptorsubstituenten gewählt sind aus der Gruppe bestehend aus Cyanogruppen und elektronenarmen Heteroarylgruppen, die auch substituiert sein können, und die einen Abstand zwischen dem niedrigsten Triplettzustand $T_1$ und dem ersten angeregten Singulettzustand $S_1$ von $\leq$ 0.15 eV aufweist (TADF-Verbindung), **dadurch gekennzeichnet, dass** die Elektrolumineszenzvorrichtung kathodenseitig der emittierenden Schicht eine oder mehrere Elektronentransportschichten enthält, wobei alle Elektronentransportschichten, die zwischen der Kathode bzw., wenn vorhanden, der Elektroneninjektionsschicht und der emittierenden Schicht vorliegen, mindestens eine Verbindung mit einem LUMO $\leq$ -2.55 eV enthalten.

2. Organische Elektrolumineszenzvorrichtung nach Anspruch 1, **dadurch gekennzeichnet, dass** der Abstand zwischen $S_1$ und $T_1$ der TADF-Verbindung $\leq$ 0.10 eV, bevorzugt $\leq$ 0.08 eV und besonders bevorzugt $\leq$ 0.05 eV ist.

3. Organische Elektrolumineszenzvorrichtung nach Anspruch 1 oder 2,
**dadurch gekennzeichnet, dass** die TADF-Verbindung in einer Matrix vorliegt und für das LUMO der TADF-Verbindung LUMO(TADF) und das HOMO der Matrix HOMO(Matrix) gilt:

$$\text{LUMO(TADF)} - \text{HOMO(Matrix)} > S_1\text{(TADF)} - 0.4\ \text{eV},$$

wobei $S_1$(TADF) der erste angeregte Singulettzustand $S_1$ der TADF-Verbindung ist.

4. Organische Elektrolumineszenzvorrichtung nach einem oder mehreren der Ansprüche 1 bis 3, **dadurch gekennzeichnet, dass** das Elektronentransportmaterial in der Elektronentransportschicht ein LUMO $\leq$ -2.60 eV aufweist, bevorzugt $\leq$ -2.65 eV.

5. Organische Elektrolumineszenzvorrichtung nach einem oder mehreren der Ansprüche 1 bis 4, **dadurch gekennzeichnet, dass** eine, zwei oder drei Elektronentransportschichten vorliegen.

6. Organische Elektrolumineszenzvorrichtung nach einem oder mehreren der Ansprüche 1 bis 5, **dadurch gekennzeichnet, dass** die Schichtdicke der Elektronentransportschichten insgesamt zwischen 10 und 100 nm, bevorzugt zwischen 15 und 90 nm, besonders bevorzugt zwischen 20 und 70 nm liegt.

7. Organische Elektrolumineszenzvorrichtung nach einem oder mehreren der Ansprüche 1 bis 6, **dadurch gekennzeichnet, dass** die niedrigste Triplettenergie der direkt an die emittierende Schicht angrenzenden Elektronentransportschicht maximal 0.1 eV niedriger ist als die Triplettenergie der TADF-Verbindung.

**8.** Organische Elektrolumineszenzvorrichtung nach einem oder mehreren der Ansprüche 1 bis 7, **dadurch gekennzeichnet, dass** für das Elektronentransportmaterial der direkt an die emittierende Schicht angrenzenden Elektronentransportschicht gilt:

$$\text{HOMO(EML)} - \text{HOMO(ETL)} > 0.2 \text{ eV},$$

wobei HOMO(ETL) das HOMO des Materials der Elektronentransportschicht ist oder bei mehreren Materialien in der Schicht das am höchsten liegende HOMO dieser Materialien ist und HOMO(EML) das HOMO des Materials der emittierenden Schicht ist oder bei mehreren Materialien in der Schicht das am höchsten liegende HOMO dieser Materialien ist.

**9.** Organische Elektrolumineszenzvorrichtung nach einem oder mehreren der Ansprüche 1 bis 8, **dadurch gekennzeichnet, dass** zwischen der Elektronentransportschicht mit dem Elektronentransportmaterial mit einem LUMO ≤ -2.55 eV und der Kathode mindestens eine Elektroneninjektionsschicht vorliegt, welche bevorzugt ausgewählt ist aus Lithiumverbindungen und/oder Alkalimetall- oder Erdalkalimetallfluoriden, -oxiden oder -carbonaten.

**10.** Organische Elektrolumineszenzvorrichtung nach einem oder mehreren der Ansprüche 1 bis 9, **dadurch gekennzeichnet, dass** die Elektronentransportschicht, die an die Kathode oder, falls vorhanden, an die Elektroneninjektionsschicht angrenzt, eine Mischung enthält aus einem Elektronentransportmaterial mit einem LUMO ≤ -2.55 eV und einer Lithiumverbindung, insbesondere Lithiumchinolinat oder einem Lithiumchinolinatderivat.

**11.** Organische Elektrolumineszenzvorrichtung nach einem oder mehreren der Ansprüche 1 bis 10, **dadurch gekennzeichnet, dass** das Elektronentransportmaterial ausgewählt ist aus den Stoffklassen der Triazine, der Pyrimidine, der Lactame, der Metallkomplexe, insbesondere der Be-, Zn- bzw. Al-Komplexe, der aromatischen Ketone, der aromatischen Phosphinoxide, der Azaphosphole, der Azaborole, welche mit mindestens einem elektronenleitenden Substituenten substituiert sind, der Benzimidazole und der Chinoxaline.

**12.** Organische Elektrolumineszenzvorrichtung nach einem oder mehreren der Ansprüche 1 bis 11, **dadurch gekennzeichnet, dass** das Elektronentransportmaterial ausgewählt ist aus den Verbindungen der folgenden Formeln (1) bzw. (2),

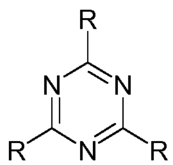

Formel (1)

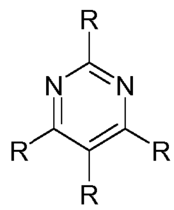

Formel (2)

wobei für die verwendeten Symbole gilt:

R ist bei jedem Auftreten gleich oder verschieden ausgewählt aus der Gruppe bestehend aus H, D, F, Cl, Br, I, CN, $NO_2$, $N(Ar)_2$, $N(R^1)_2$, C(=O)Ar, $C(=O)R^1$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^1$ substituiert sein kann, wobei eine oder mehrere nicht-benachbarte $CH_2$-Gruppen durch $R^1C=CR^1$, C≡C, $Si(R^1)_2$, C=O, C=S, $C=NR^1$, $P(=O)(R^1)$, SO, $SO_2$, $NR^1$, O, S oder $CONR^1$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 80, bevorzugt 5 bis 60, aromatischen Ringatomen, das jeweils mit einem oder mehreren Resten $R^1$ substituiert sein kann, einer Aryloxy- oder Heteroaryloxygruppe mit 5 bis 60 aromatischen Ringatomen, die mit einem oder mehreren Resten $R^1$ substituiert sein kann, oder einer Aralkyl- oder Heteroaralkylgruppe mit 5 bis 60 aromatischen Ringatomen, die mit einem oder mehreren Resten $R^1$ substituiert sein kann, wobei optional zwei oder mehr benachbarte Substituenten R ein monocyclisches oder polycyclisches, aliphatisches, aromatisches oder heteroaromatisches Ringsystem bilden können, das mit einem oder mehreren Resten $R^1$ substituiert sein kann;

$R^1$ ist bei jedem Auftreten gleich oder verschieden ausgewählt aus der Gruppe bestehend aus H, D, F, Cl, Br, I, CN, $NO_2$, $N(Ar)_2$, $N(R^2)_2$, C(=O)Ar, $C(=O)R^2$, $P(=O)(Ar)_2$, einer geradkettigen Alkyl-, Alkoxy- oder Thioalkylgruppe mit 1 bis 40 C-Atomen oder einer verzweigten oder cyclischen Alkyl-, Alkoxy- oder Thioalkylgruppe mit 3 bis 40 C-Atomen oder einer Alkenyl- oder Alkinylgruppe mit 2 bis 40 C-Atomen, die jeweils mit einem oder mehreren Resten $R^2$ substituiert sein kann, wobei eine oder mehrere nicht-benachbarte $CH_2$-Gruppen durch $R^2C=CR^2$, C≡C, $Si(R^2)_2$, C=O, C=S, $C=NR^2$, $P(=O)(R^2)$, SO, $SO_2$, $NR^2$, O, S oder $CONR^2$ ersetzt sein können und wobei ein oder mehrere H-Atome durch D, F, Cl, Br, I, CN oder $NO_2$ ersetzt sein können, einem aromatischen oder heteroaromatischen Ringsystem mit 5 bis 60 aromatischen Ringatomen, das jeweils mit einem oder mehreren Resten $R^2$ substituiert sein kann, einer Aryloxy- oder Heteroaryloxygruppe mit 5 bis 60 aromatischen Ringatomen, die mit einem oder mehreren Resten $R^2$ substituiert sein kann, oder eine Aralkyl- oder Heteroaralkylgruppe mit 5 bis 60 aromatischen Ringatomen, wobei optional zwei oder mehr benachbarte Substituenten $R^1$ ein monocyclisches oder polycyclisches, aliphatisches, aromatisches oder heteroaromatisches Ringsystem bilden können, das mit einem oder mehreren Resten $R^2$ substituiert sein kann;

Ar ist bei jedem Auftreten gleich oder verschieden ein aromatisches oder heteroaromatisches Ringsystem mit 5-30 aromatischen Ringatomen, das mit einem oder mehreren nicht-aromatischen Resten $R^2$ substituiert sein kann; dabei können zwei Reste Ar, welche an dasselbe N-Atom oder P-Atom binden, auch durch eine Einfachbindung oder eine Brücke, ausgewählt aus $N(R^2)$, $C(R^2)_2$, O oder S, miteinander verbrückt sein;

$R^2$ ist ausgewählt aus der Gruppe bestehend aus H, D, F, CN, einem aliphatischem Kohlenwasserstoffrest mit 1 bis 20 C-Atomen, einem aromatischem oder heteroaromatischem Ringsystem mit 5 bis 30 aromatischen Ringatomen, in dem ein oder mehrere H-Atome durch D, F, Cl, Br, I oder CN ersetzt sein können, wobei zwei oder mehr benachbarte Substituenten $R^2$ miteinander ein mono- oder polycyclisches, aliphatisches, aromatisches oder heteroaromatisches Ringsystem bilden können.

13. Organische Elektrolumineszenzvorrichtung nach Anspruch 12, **dadurch gekennzeichnet, dass** mindestens ein Rest R gleich oder verschieden bei jedem Auftreten ausgewählt ist aus der Gruppe bestehend aus Benzol, ortho-, meta- oder para-Biphenyl, ortho-, meta-, para- oder verzweigtem Terphenyl, ortho-, meta-, para- oder verzweigtem Quaterphenyl, 1-, 2-, 3- oder 4-Fluorenyl, 1-, 2-, 3- oder 4-Spirobifluorenyl, 1- oder 2-Naphthyl, Pyrrol, Furan, Thiophen, Indol, Benzofuran, Benzothiophen, 1-, 2- oder 3-Carbazol, 1-, 2- oder 3-Dibenzofuran, 1-, 2- oder 3-Dibenzothiophen, Indenocarbazol, Indolocarbazol, 2-, 3- oder 4-Pyridin, 2-, 4- oder 5-Pyrimidin, Pyrazin, Pyridazin, Triazin, Anthracen, Phenanthren, Triphenylen, Pyren, Benzanthracen oder Kombinationen aus zwei oder drei dieser Gruppen, welche jeweils mit einem oder mehreren Resten $R^1$ substituiert sein können, oder aus den Strukturen der folgenden Formeln (3) bis (44),

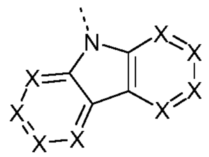
Formel (3)

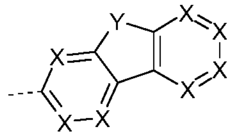
Formel (4)

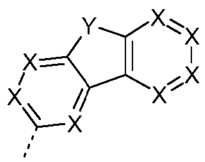
Formel (5)

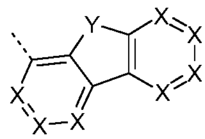
Formel (6)

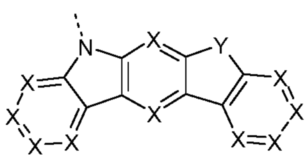
Formel (7)

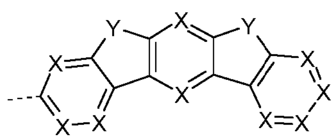
Formel (8)

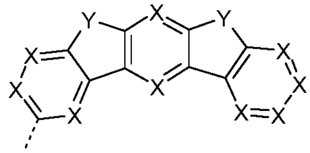
Formel (9)

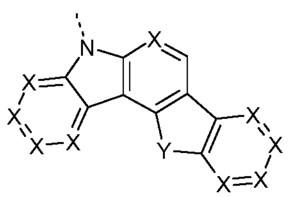
Formel (10)

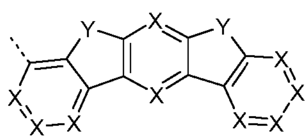
Formel (11)

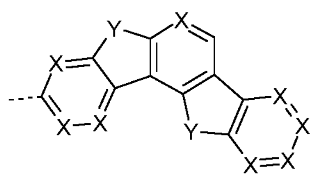
Formel (12)

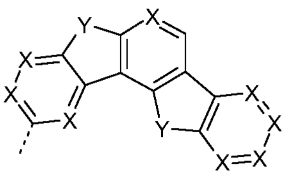
Formel (13)

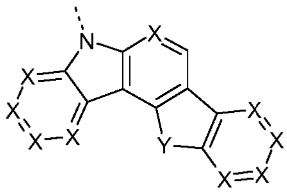
Formel (14)

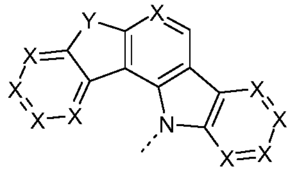
Formel (15)

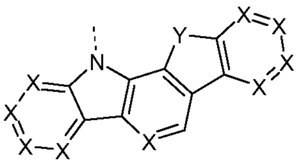
Formel (16)

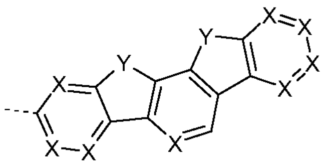
Formel (17)

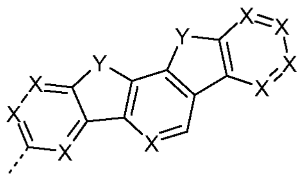
Formel (18)

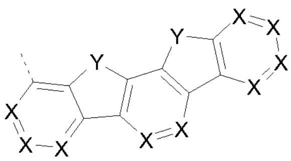
Formel (19)

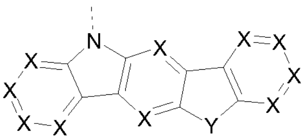
Formel (20)

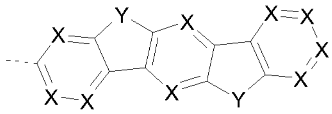
Formel (21)

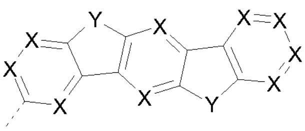
Formel (22)

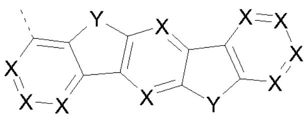
Formel (23)

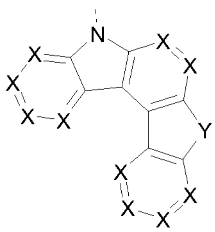
Formel (24)

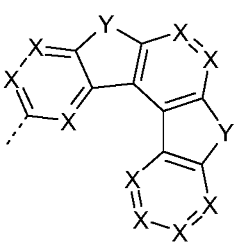
Formel (25)

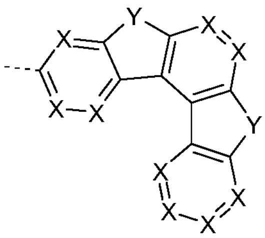
Formel (26)

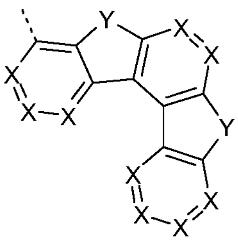
Formel (27)

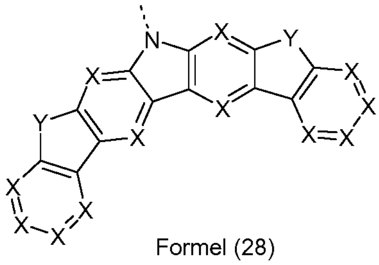
Formel (28)

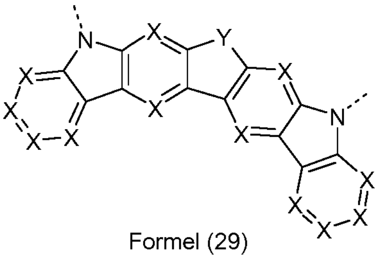
Formel (29)

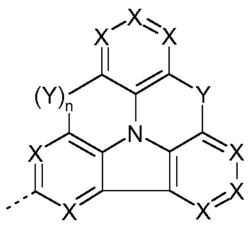

Formel (30)

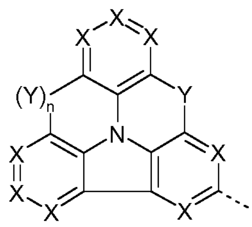

Formel (31)

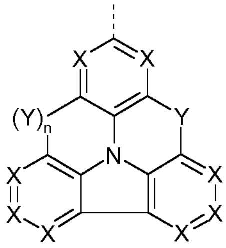

Formel (32)

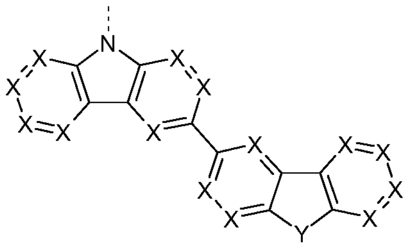

Formel (33)

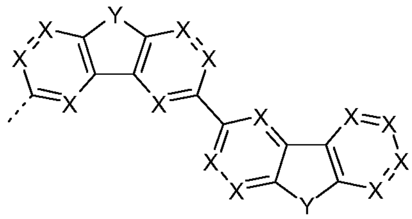

Formel (34)

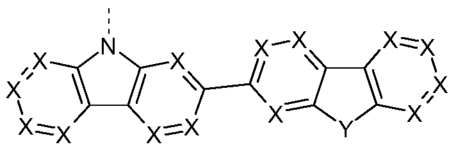

Formel (35)

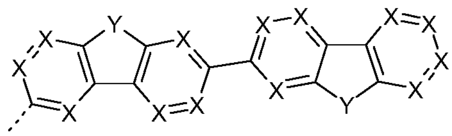

Formel (36)

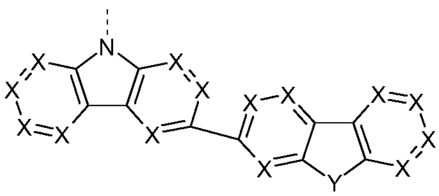

Formel (37)

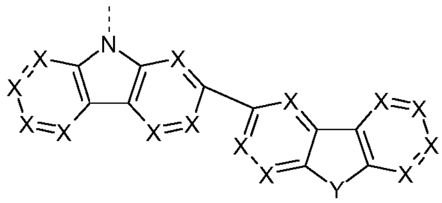

Formel (38)

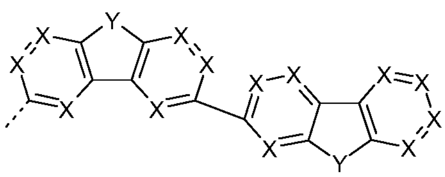

Formel (39)

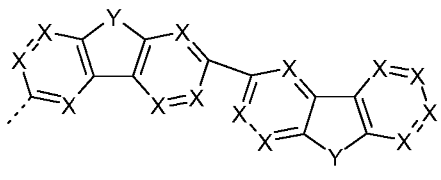

Formel (40)

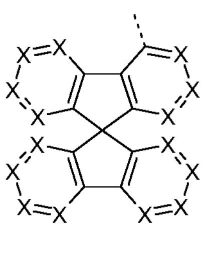

Formel (41)

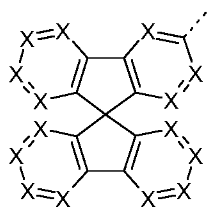

Formel (42)

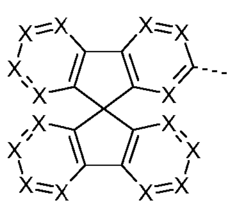

Formel (43)

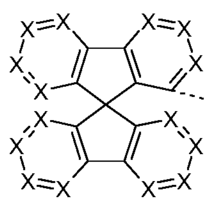

Formel (44)

wobei $R^1$ und $R^2$ die in Anspruch 9 genannten Bedeutungen aufweisen, die gestrichelte Bindung die Bindung an die Gruppe der Formel (1) bzw. (2) darstellt und weiterhin gilt:

X ist bei jedem Auftreten gleich oder verschieden $CR^1$ oder N, wobei bevorzugt maximal 2 Symbole X pro Cyclus für N stehen;
Y ist bei jedem Auftreten gleich oder verschieden $C(R^1)_2$, $NR^1$, O oder S;
n ist 0 oder 1, wobei n gleich 0 bedeutet, dass an dieser Position keine Gruppe Y gebunden ist und an den entsprechenden Kohlenstoffatomen statt dessen Reste $R^1$ gebunden sind.

**14.** Organische Elektrolumineszenzvorrichtung nach Anspruch 11, **dadurch gekennzeichnet, dass** das Elektronentransportmaterial ausgewählt ist aus den Verbindungen der Formeln (45) oder (46),

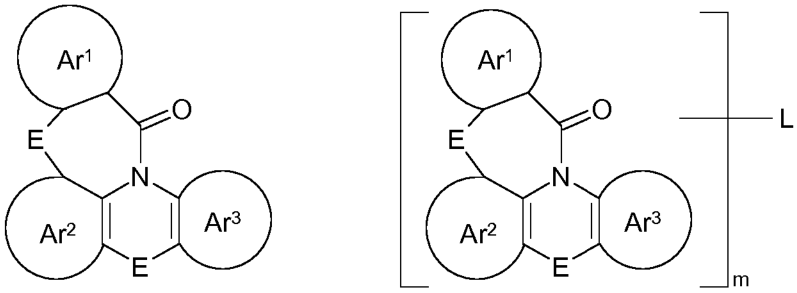

Formel (45) Formel (46)

wobei R, $R^1$, $R^2$ und Ar die in Anspruch 14 genannten Bedeutungen aufweisen und für die weiteren verwendeten Symbole und Indizes gilt:

E ist gleich oder verschieden bei jedem Auftreten eine Einfachbindung, NR, $CR_2$, O oder S;
$Ar^1$ ist zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;
$Ar^2$, $Ar^3$ ist gleich oder verschieden bei jedem Auftreten zusammen mit den explizit dargestellten Kohlenstoffatomen ein aromatisches oder heteroaromatisches Ringsystem mit 5 bis 30 aromatischen Ringatomen, welches durch einen oder mehrere Reste R substituiert sein kann;
L ist für m = 2 eine Einfachbindung oder eine bivalente Gruppe, bzw. für m = 3 eine trivalente Gruppe bzw. für m = 4 eine tetravalente Gruppe, welche jeweils an eine beliebige Position an $Ar^1$, $Ar^2$ oder $Ar^3$ oder statt einem Rest R an E gebunden ist;
m ist 2, 3 oder 4.

**15.** Organische Elektrolumineszenzvorrichtung nach Anspruch 14, **dadurch gekennzeichnet, dass** die Gruppe $Ar^1$ für eine Gruppe der folgenden Formel (47), (48), (49) oder (50) steht,

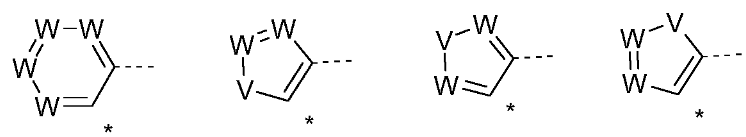

Formel (47) Formel (48) Formel (49) Formel (50)

wobei die gestrichelte Bindung die Verknüpfung mit der Carbonylgruppe andeutet, * die Position der Verknüpfung mit E bzw. $Ar^2$ andeutet und weiterhin gilt:

W ist gleich oder verschieden bei jedem Auftreten CR oder N; oder zwei benachbarte Gruppen W stehen für eine Gruppe der Formel (51) oder (52),

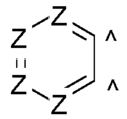 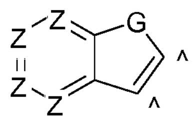

Formel (51) Formel (52)

wobei G für $CR_2$, NR, O oder S steht, Z gleich oder verschieden bei jedem Auftreten für CR oder N steht und ^ die entsprechenden benachbarten Gruppen W in der Formel (47) bis (50) andeuten;

V ist NR, O oder S;

und/oder dass die Gruppe $Ar^2$ für eine Gruppe gemäß einer der Formeln (53), (54) oder (55) steht,

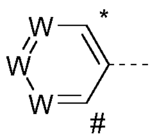 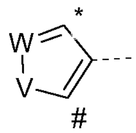 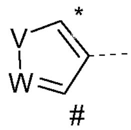

Formel (53) Formel (54) Formel (55)

wobei die gestrichelte Bindung die Verknüpfung mit N andeutet, # die Position der Verknüpfung mit E bzw. $Ar^3$ andeutet, * die Verknüpfung mit E bzw. $Ar^1$ andeutet und W und V die oben genannten Bedeutungen aufweisen; und/oder dass die Gruppe $Ar^3$ für eine Gruppe gemäß einer der Formeln (56), (57), (58) oder (59) steht,

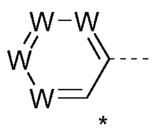 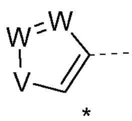 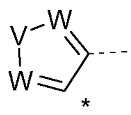 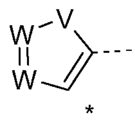

Formel (56) Formel (57) Formel (58) Formel (59)

wobei die gestrichelte Bindung die Verknüpfung mit N andeutet, * die Verknüpfung mit E bzw. $Ar^2$ andeutet und W und V die oben genannten Bedeutungen aufweisen.

**16.** Organische Elektrolumineszenzvorrichtung nach Anspruch 11, **dadurch gekennzeichnet, dass** das Elektronentransportmaterial ausgewählt ist aus den Verbindungen der Formeln (70) bzw. (71),

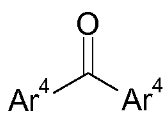 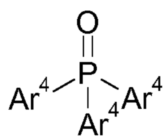

Formel (70) Formel (71)

wobei R, $R^1$, $R^2$ und Ar die in Anspruch 9 aufgeführten Bedeutungen hat und für die weiteren verwendeten Symbole gilt:

$Ar^4$ ist bei jedem Auftreten gleich oder verschieden ein aromatisches oder heteroaromatisches Ringsystem mit 5 bis 80 aromatischen Ringatomen, bevorzugt bis 60 aromatischen Ringatomen, welches jeweils mit einer oder mehreren Gruppen R substituiert sein kann.

**17.** Verfahren zur Herstellung einer organischen Elektrolumineszenzvorrichtung nach einem oder mehreren der Ansprüche 1 bis 16, **dadurch gekennzeichnet, dass** mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

## Claims

1. Organic electroluminescent device, comprising cathode, anode and emitting layer, which comprises at least one luminescent organic compound which is an aromatic compound that has both donor and also acceptor substituents, where the donor substituents are selected from the group consisting of diaryl- or diheteroarylamino groups, carbazole groups and carbazole derivatives, which may in each case also be substituted, and where the acceptor substituents are selected from the group consisting of cyano groups and electron-deficient heteroaryl groups, which may also be substituted, and which has a separation between the lowest triplet state $T_1$ and the first excited singlet state $S_1$ of ≤ 0.15 eV (TADF compound),
**characterised in that** the electroluminescent device comprises one or more electron-transport layers on the cathode side of the emitting layer, where all electron-transport layers that are present between the cathode or, if present, the electron-injection layer and the emitting layer comprise at least one compound having an LUMO ≤ -2.55 eV

2. Organic electroluminescent device according to Claim 1, **characterised in that** the separation between $S_1$ and $T_1$ of the TADF compound is ≤ 0.10 eV, preferably ≤ 0.08 eV and particularly preferably ≤ 0.05 eV.

3. Organic electroluminescent device according to Claim 1 or 2, **characterised in that** the TADF compound is present in a matrix, and the following applies to the LUMO of the TADF compound LUMO(TADF) and the HOMO of the matrix HOMO(matrix):

$$\text{LUMO(TADF)} - \text{HOMO(matrix)} > S_1\text{(TADF)} - 0.4\ \text{eV},$$

where $S_1$(TADF) is the first excited singlet state $S_1$ of the TADF compound.

4. Organic electroluminescent device according to one or more of Claims 1 to 3, **characterised in that** the electron-transport material in the electron-transport layer has an LUMO ≤ -2.60 eV, preferably ≤ -2.65 eV.

5. Organic electroluminescent device according to one or more of Claims 1 to 4, **characterised in that** one, two or three electron-transport layers are present.

6. Organic electroluminescent device according to one or more of Claims 1 to 5, **characterised in that** the layer thickness of the electron-transport layers is in total between 10 and 100 nm, preferably between 15 and 90 nm, particularly preferably between 20 and 70 nm.

7. Organic electroluminescent device according to one or more of Claims 1 to 6, **characterised in that** the lowest triplet energy of the electron-transport layer directly adjacent to the emitting layer is a maximum of 0.1 eV lower than the triplet energy of the TADF compound.

8. Organic electroluminescent device according to one or more of Claims 1 to 7, **characterised in that** the following applies to the electron-transport material of the electron-transport layer directly adjacent to the emitting layer:

$$\text{HOMO(EML)} - \text{HOMO(ETL)} > 0.2\ \text{eV},$$

where HOMO(ETL) is the HOMO of the material of the electron-transport layer or, in the case of a plurality of materials in the layer, the highest HOMO of these materials, and HOMO(EML) is the HOMO of the material of the emitting layer or, in the case of a plurality of materials in the layer, the highest HOMO of these materials.

9. Organic electroluminescent device according to one or more of Claims 1 to 8, **characterised in that** at least one electron-injection layer, which is preferably selected from lithium compounds and/or alkali-metal or alkaline-earth metal fluorides, oxides or carbonates, is present between the electron-transport layer comprising the electron-transport material having an LUMO ≤ -2.55 eV and the cathode.

**10.** Organic electroluminescent device according to one or more of Claims 1 to 9, **characterised in that** the electron-transport layer that is adjacent to the cathode or, if present, to the electron-injection layer comprises a mixture of an electron-transport material having an LUMO ≤ -2.55 eV and a lithium compound, in particular lithium quinolinate or a lithium quinolinate derivative.

**11.** Organic electroluminescent device according to one or more of Claims 1 to 10, **characterised in that** the electron-transport material is selected from the substance classes of the triazines, the pyrimidines, the lactams, the metal complexes, in particular the Be, Zn and Al complexes, the aromatic ketones, the aromatic phosphine oxides, the azaphospholes, the azaboroles, which are substituted by at least one electron-conducting substituent, the benzimidazoles and the quinoxalines.

**12.** Organic electroluminescent device according to one or more of Claims 1 to 11, **characterised in that** the electron-transport material is selected from the compounds of the following formulae (1) and (2),

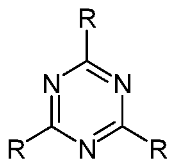

formula (1)

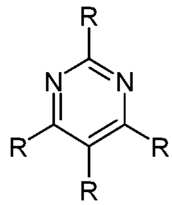

formula (2)

where the following applies to the symbols used:

R is selected on each occurrence, identically or differently, from the group consisting of H, D, F, Cl, Br, I, CN, $NO_2$, $N(Ar)_2$, $N(R^1)_2$, C(=O)Ar, $C(=O)R^1$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^1$, where one or more non-adjacent $CH_2$ groups may be replaced by $R^1C=CR^1$, C≡C, $Si(R^1)_2$, C=O, C=S, $C=NR^1$, $P(=O)(R^1)$, SO, $SO_2$, $NR^1$, O, S or $CONR^1$ and where one or more H atoms may be replaced by D, F, Cl, Br, I, CN or $NO_2$, an aromatic or heteroaromatic ring system having 5 to 80, preferably 5 to 60, aromatic ring atoms, which may in each case be substituted by one or more radicals $R^1$, an aryloxy or heteroaryloxy group having 5 to 60 aromatic ring atoms, which may be substituted by one or more radicals $R^1$, or an aralkyl or heteroaralkyl group having 5 to 60 aromatic ring atoms, which may be substituted by one or more radicals $R^1$, where two or more adjacent substituents R may optionally form a monocyclic or poly-cyclic, aliphatic, aromatic or heteroaromatic ring system, which may be substituted by one or more radicals $R^1$;

$R^1$ is selected on each occurrence, identically or differently, from the group consisting of H, D, F, Cl, Br, I, CN, $NO_2$, $N(Ar)_2$, $N(R^2)_2$, C(=O)Ar, $C(=O)R^2$, $P(=O)(Ar)_2$, a straight-chain alkyl, alkoxy or thioalkyl group having 1 to 40 C atoms or a branched or cyclic alkyl, alkoxy or thioalkyl group having 3 to 40 C atoms or an alkenyl or alkynyl group having 2 to 40 C atoms, which may in each case be substituted by one or more radicals $R^2$, where one or more non-adjacent $CH_2$ groups may be replaced by $R^2C=CR^2$, C≡C, $Si(R^2)_2$, C=O, C=S, $C=NR^2$, $P(=O)(R^2)$, SO, $SO_2$, $NR^2$, O, S or $CONR^2$ and where one or more H atoms may be replaced by D, F, Cl, Br, I, CN or $NO_2$, an aromatic or heteroaromatic ring system having 5 to 60 aromatic ring atoms, which may in each case be substituted by one or more radicals $R^2$, an aryloxy or heteroaryloxy group having 5 to 60 aromatic ring atoms, which may be substituted by one or more radicals $R^2$, or an aralkyl or heteroaralkyl group having 5 to 60 aromatic ring atoms, where two or more adjacent substituents $R^1$ may optionally form a monocyclic or polycyclic, aliphatic, aromatic or heteroaromatic ring system, which may be substituted by one or more radicals $R^2$;

Ar is on each occurrence, identically or differently, an aromatic or heteroaromatic ring system having 5-30 aromatic ring atoms, which may be substituted by one or more non-aromatic radicals $R^2$; two radicals Ar that are bonded to the same N atom or P atom may also be bridged to one another by a single bond or a bridge selected from $N(R^2)$, $C(R^2)_2$, O or S;

$R^2$ is selected from the group consisting of H, D, F, CN, an aliphatic hydrocarbon radical having 1 to 20 C atoms, an aromatic or heteroaromatic ring system having 5 to 30 aromatic ring atoms, in which one or more H atoms may be replaced by D, F, Cl, Br, I or CN, where two or more adjacent substituents $R^2$ may form a mono- or polycyclic, aliphatic, aromatic or heteroaromatic ring system with one another.

**13.** Organic electroluminescent device according to Claim 12, **characterised in that** at least one radical R is selected, identically or differently on each occurrence, from the group consisting of benzene, ortho-, meta- or para-biphenyl, ortho-, meta-, para- or branched terphenyl, ortho-, meta-, para- or branched quaterphenyl, 1-, 2-, 3- or 4-fluorenyl, 1-, 2-, 3- or 4-spirobifluorenyl, 1- or 2-naphthyl, pyrrole, furan, thiophene, indole, benzofuran, benzothiophene, 1-, 2- or 3-carbazole, 1-, 2- or 3-dibenzofuran, 1-, 2- or 3-dibenzothiophene, indenocarbazole, indolocarbazole, 2-, 3- or 4-pyridine, 2-, 4- or 5-pyrimidine, pyrazine, pyridazine, triazine, anthracene, phenanthrene, triphenylene, pyrene, benzanthracene or combinations of two or three of these groups, which may in each case be substituted by one or more radicals $R^1$, or from the structures of the following formulae (3) to (44),

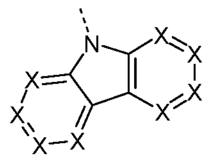
formula (3)

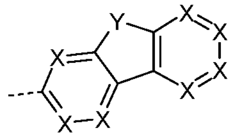
formula (4)

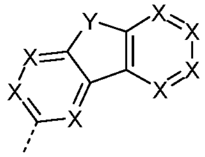
formula (5)

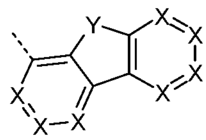
formula (6)

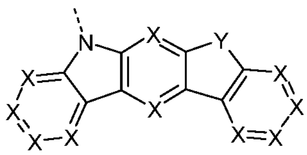
formula (7)

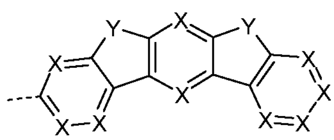
formula (8)

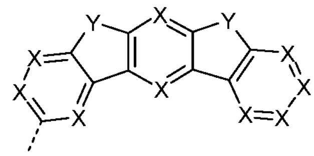
formula (9)

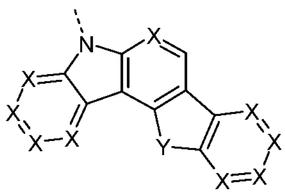
formula (10)

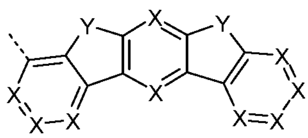
formula (11)

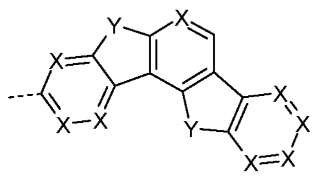
formula (12)

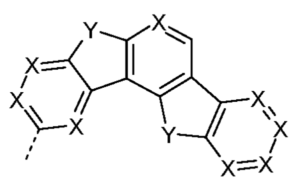
formula (13)

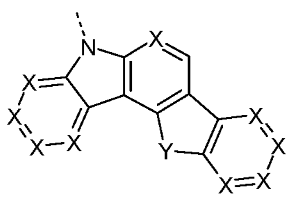
formula (14)

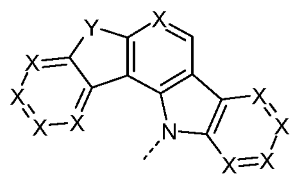
formula (15)

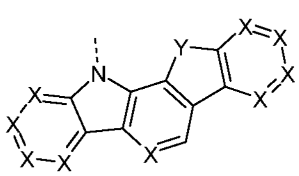
formula (16)

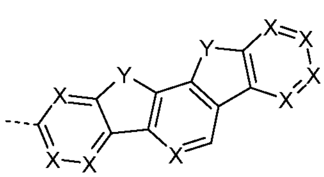
formula (17)

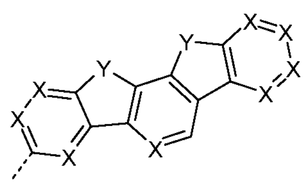
formula (18)

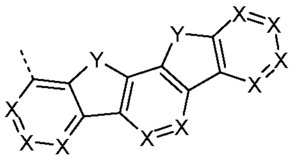

formula (19)

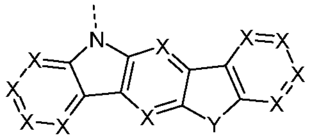

formula (20)

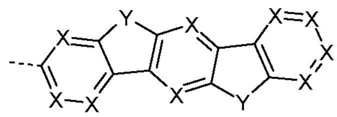

formula (21)

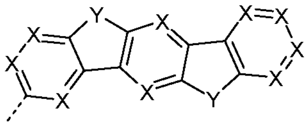

formula (22)

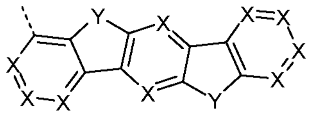

formula (23)

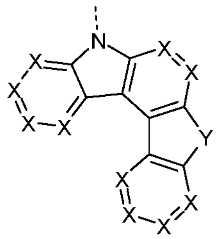

formula (24)

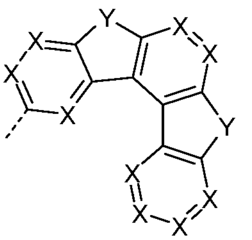

formula (25)

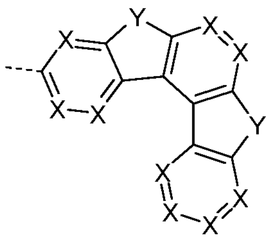

formula (26)

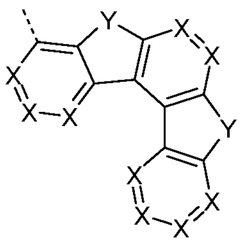

formula (27)

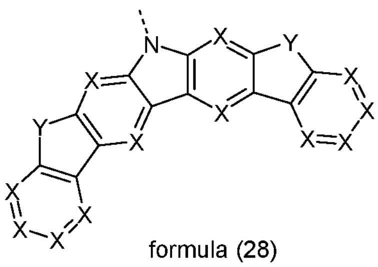

formula (28)

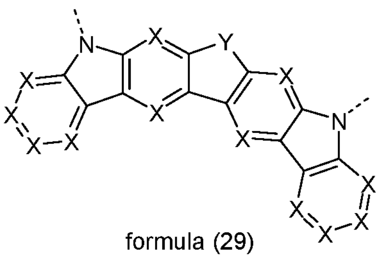

formula (29)

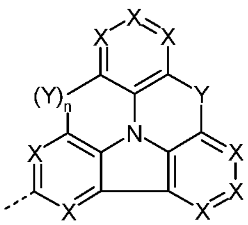

formula (30)

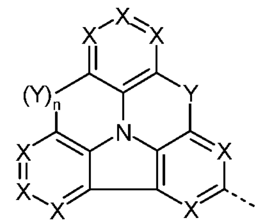

formula (31)

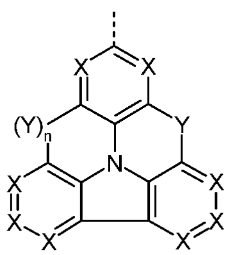

formula (32)

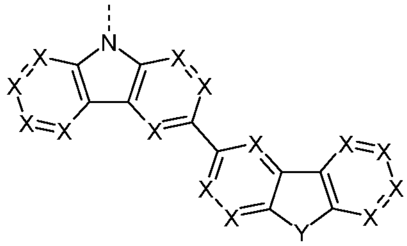

formula (33)

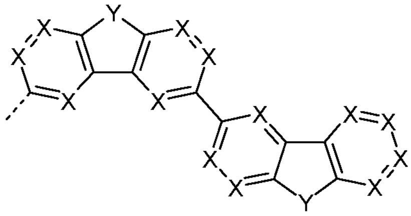

formula (34)

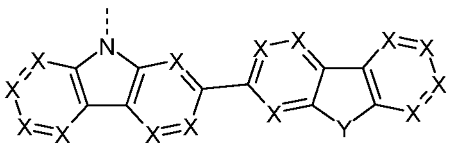

formula (35)

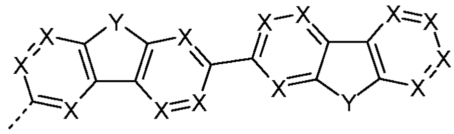

formula (36)

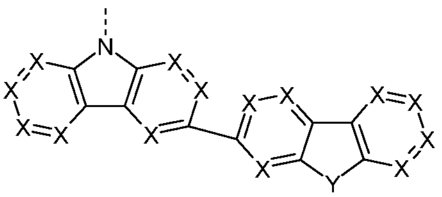

formula (37)

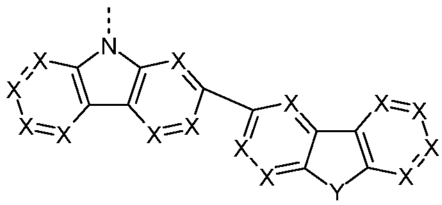

formula (38)

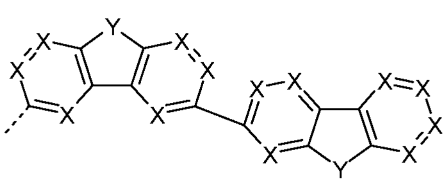

formula (39)

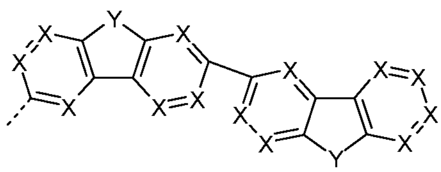

formula (40)

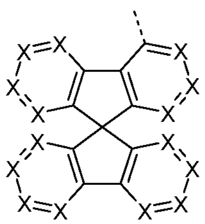

formula (41)

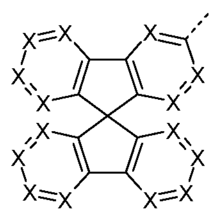

formula (42)

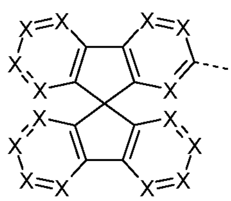

formula (43)

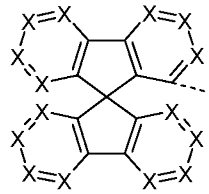

formula (44)

where $R^1$ and $R^2$ have the meanings given in Claim 12, the dashed bond represents the bond to the group of the formula (1) or (2), and furthermore:

X is on each occurrence, identically or differently, $CR^1$ or N, where preferably a maximum of 2 symbols X per ring stand for N;
Y is on each occurrence, identically or differently, $C(R^1)_2$, $NR^1$, O or S;
n is 0 or 1, where n equals 0 means that no group Y is bonded at this position and instead radicals $R^1$ are bonded to the corresponding carbon atoms.

**14.** Organic electroluminescent device according to Claim 11, **characterised in that** the electron-transport material is

selected from the compounds of the formulae (45) or (46),

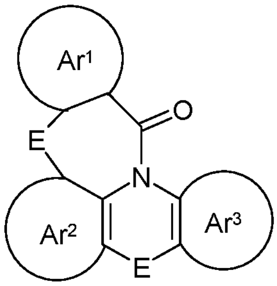

formula (45)

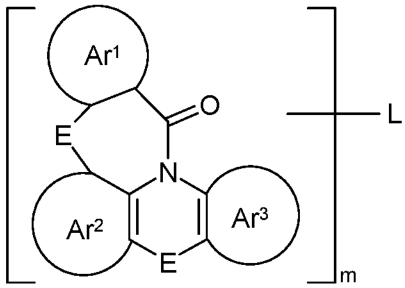

formula (46)

where R, $R^1$, $R^2$ and Ar have the meanings given in Claim 12, and the following applies to the other symbols and indices used:

E is, identically or differently on each occurrence, a single bond, NR, $CR_2$, O or S;
$Ar^1$ is, together with the carbon atoms explicitly depicted, an aromatic or heteroaromatic ring system having 5 to 30 aromatic ring atoms, which may be substituted by one or more radicals R;
$Ar^2$, $Ar^3$ are, identically or differently on each occurrence, together with the carbon atoms explicitly depicted, an aromatic or hetero-aromatic ring system having 5 to 30 aromatic ring atoms, which may be substituted by one or more radicals R;
L is for m = 2 a single bond or a divalent group, or for m = 3 a trivalent group or for m = 4 a tetravalent group, which is in each case bonded to $Ar^1$, $Ar^2$ or $Ar^3$ at any desired position or is bonded to E instead of a radical R;
m is 2, 3 or 4.

**15.** Organic electroluminescent device according to Claim 14, **characterised in that** the group $Ar^1$ stands for a group of the following formula (47), (48), (49) or (50),

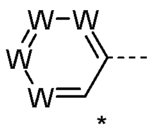

formula (47)

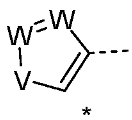

formula (48)

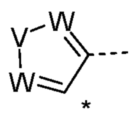

formula (49)

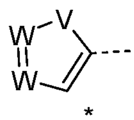

formula (50)

where the dashed bond indicates the link to the carbonyl group, * indicates the position of the link to E or $Ar^2$, and furthermore:

W is, identically or differently on each occurrence, CR or N; or two adjacent groups W stand for a group of the formula (51) or (52),

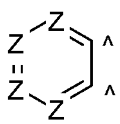

formula (51)

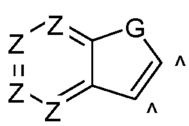

formula (52)

where G stands for $CR_2$, NR, O or S, Z stands, identically or differently on each occurrence, for CR or N, and ^ indicates the corresponding adjacent groups W in the formulae (47) to (50);

V is NR, O or S;

and/or **in that** the group $Ar^2$ stands for a group of one of the formulae (53), (54) or (55),

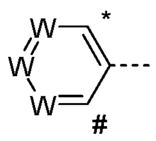
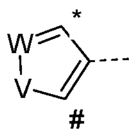
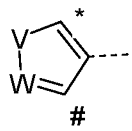

formula (53) formula (54) formula (55)

where the dashed bond indicates the link to N, # indicates the position of the link to E or $Ar^3$, * indicates the link to E or $Ar^1$, and W and V have the meanings given above; and/or **in that** the group $Ar^3$ stands for a group of one of the formulae (56), (57), (58) or (59),

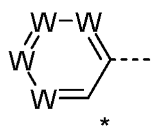
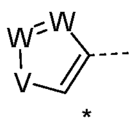
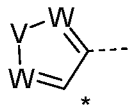
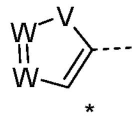

formula (56) formula (57) formula (58) formula (59)

where the dashed bond indicates the link to N, * indicates the link to E or $Ar^2$, and W and V have the meanings given above.

**16.** Organic electroluminescent device according to Claim 11, **characterised in that** the electron-transport material is selected from the compounds of the formulae (70) and (71),

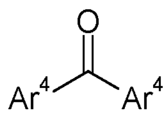
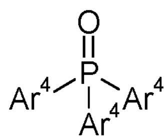

formula (70) formula (71)

where R, $R^1$, $R^2$ and Ar have the meanings indicated in Claim 12, and the following applies to the other symbols used:

$Ar^4$ is on each occurrence, identically or differently, an aromatic or heteroaromatic ring system having 5 to 80 aromatic ring atoms, preferably up to 60 aromatic ring atoms, which may in each case be substituted by one or more groups R.

**17.** Process for the production of an organic electroluminescent device according to one or more of Claims 1 to 16, **characterised in that** at least one layer is applied by means of a sublimation process and/or **in that** at least one layer is applied by means of an OVPD (organic vapour phase deposition) process or with the aid of carrier-gas sublimation and/or **in that** at least one layer is applied from solution, by spin coating or by means of a printing process.

## Revendications

**1.** Dispositif électroluminescent organique, comprenant une cathode, une anode et une couche d'émission, laquelle couche d'émission comprend au moins un composé organique luminescent qui est un composé aromatique qui comporte à la fois des substituants donneurs et également accepteurs, dans lequel les substituants donneurs sont sélectionnés parmi le groupe qui est constitué par des groupes diaryl-hétéroarylamino ou dihétéroarylamino, des groupes carbazole et des dérivés de carbazole, lesquels groupes et/ou dérivés peuvent dans chaque cas également être substitués, et dans lequel les substituants accepteurs sont sélectionnés parmi le groupe qui est constitué par des groupes cyano et des groupes hétéroaryle déficients en électrons, lesquels groupes peuvent également être substitués, et qui présente une séparation entre l'état triplet le plus bas $T_1$ et le premier état singulet excité $S_1 \leq$ 0,15 eV (composé TADF),
**caractérisé en ce que** le dispositif électroluminescent comprend une ou plusieurs couche(s) de transport d'électrons

sur le côté de cathode de la couche d'émission, où toutes les couches de transport d'électrons qui sont présentes entre la cathode ou, si elle est présente, la couche d'injection d'électrons, et la couche d'émission comprennent au moins un composé qui présente un LUMO ≤ -2,55 eV.

2. Dispositif électroluminescent organique selon la revendication 1, **caractérisé en ce que** la séparation entre $S_1$ et $T_1$ du composé TADF est ≤ 0,10 eV, de préférence ≤ 0,08 eV et de façon particulièrement préférable ≤ 0,05 eV.

3. Dispositif électroluminescent organique selon la revendication 1 ou 2, **caractérisé en ce que** le composé TADF est présent selon/dans une matrice, et ce qui suit s'applique au LUMO du composé TADF LUMO(TADF) et à l'HOMO de la matrice HOMO(matrice) :

$$\text{LUMO(TADF)} - \text{HOMO(matrice)} > S_1\text{(TADF)} - 0{,}4\ \text{eV},$$

où $S_1$(TADF) est le premier état singulet excité $S_1$ du composé TADF.

4. Dispositif électroluminescent organique selon une ou plusieurs des revendications 1 à 3, **caractérisé en ce que** le matériau de transport d'électrons dans la couche de transport d'électrons présente un LUMO ≤ -2,60 eV, de préférence ≤ -2,65 eV.

5. Dispositif électroluminescent organique selon une ou plusieurs des revendications 1 à 4, **caractérisé en ce qu'**une, deux ou trois couche(s) de transport d'électrons est/sont présente(s).

6. Dispositif électroluminescent organique selon une ou plusieurs des revendications 1 à 5, **caractérisé en ce que** l'épaisseur de couche des couches de transport d'électrons est au total entre 10 et 100 nm, de préférence entre 15 et 90 nm, de façon particulièrement préférable entre 20 et 70 nm.

7. Dispositif électroluminescent organique selon une ou plusieurs des revendications 1 à 6, **caractérisé en ce que** l'énergie du triplet le plus bas de la couche de transport d'électrons qui est directement adjacente à la couche d'émission est au maximum de 0,1 eV inférieure à l'énergie du triplet du composé TADF.

8. Dispositif électroluminescent organique selon une ou plusieurs des revendications 1 à 7, **caractérisé en ce que** ce qui suit s'applique au matériau de transport d'électrons de la couche de transport d'électrons qui est directement adjacente à la couche d'émission :

$$\text{HOMO(EML)} - \text{HOMO(ETL)} > 0{,}2\ \text{eV},$$

où HOMO(ETL) est l'HOMO du matériau de la couche de transport d'électrons ou, dans le cas d'une pluralité de matériaux dans la couche, l'HOMO le plus élevé de ces matériaux, et l'HOMO(EML) est l'HOMO du matériau de la couche d'émission ou, dans le cas d'une pluralité de matériaux dans la couche, l'HOMO le plus élevé de ces matériaux.

9. Dispositif électroluminescent organique selon une ou plusieurs des revendications 1 à 8, **caractérisé en ce qu'**au moins une couche d'injection d'électrons, laquelle est de préférence sélectionnée parmi des composés de lithium et/ou des fluorures de métaux alcalins ou de métaux alcalino-terreux, des oxydes ou des carbonates, est présente entre la couche de transport d'électrons qui comprend le matériau de transport d'électrons qui présente un LUMO ≤ -2,55 eV et la cathode.

10. Dispositif électroluminescent organique selon une ou plusieurs des revendications 1 à 9, **caractérisé en ce que** la couche de transport d'électrons qui est adjacente à la cathode ou, si elle est présente, à la couche d'injection d'électrons, comprend un mélange d'un matériau de transport d'électrons qui présente un LUMO ≤ -2,55 eV et d'un composé de lithium, en particulier du quinolinate de lithium ou un dérivé de quinolinate de lithium.

11. Dispositif électroluminescent organique selon une ou plusieurs des revendications 1 à 10, **caractérisé en ce que** le matériau de transport d'électrons est sélectionné parmi les classes de substances qui sont constituées par les triazines, les pyrimidines, les lactames, les complexes de métaux, en particulier les complexes de Be, de Zn et d'Al, les cétones aromatiques, les oxydes de phosphine aromatiques, les azaphospholes, les azaboroles, lesquels sont

substitués par au moins un substituant de conduction d'électrons, les benzimidazoles et les quinoxalines.

**12.** Dispositif électroluminescent organique selon une ou plusieurs des revendications 1 à 11, **caractérisé en ce que** le matériau de transport d'électrons est sélectionné parmi les composés des formules (1) et (2) qui suivent :

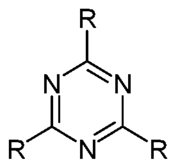

formule (1)

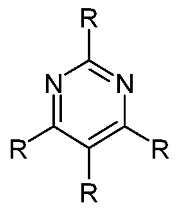

formule (2)

formules dans lesquelles ce qui suit s'applique aux symboles qui sont utilisés :

R est sélectionné pour chaque occurrence, de manière identique ou différente, parmi le groupe qui est constitué par H, D, F, Cl, Br, I, CN, $NO_2$, $N(Ar)_2$, $N(R^1)_2$, C(=O)Ar, $C(=O)R^1$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel groupe peut dans chaque cas être substitué par un radical ou par plusieurs radicaux $R^1$, où un ou plusieurs groupe(s) $CH_2$ non adjacents peut/peuvent être remplacé(s) par $R^1C=CR^1$, C≡C, $Si(R^1)_2$, C=O, C=S, $C=NR^1$, $P(=O)(R^1)$, SO, $SO_2$, $NR^1$, O, S ou $CONR^1$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 80, de préférence de 5 à 60, atomes de cycle aromatique, lequel système de cycle peut dans chaque cas être substitué par un radical ou par plusieurs radicaux $R^1$, un groupe aryloxy ou hétéroaryloxy qui comporte de 5 à 60 atomes de cycle aromatique, lequel groupe peut être substitué par un radical ou par plusieurs radicaux $R^1$, ou un groupe aralkyle ou hétéroaralkyle qui comporte de 5 à 60 atomes de cycle aromatique, lequel groupe peut être substitué par un radical ou par plusieurs radicaux $R^1$, où deux substituants R adjacents ou plus peuvent en option former un système de cycle aliphatique, aromatique ou hétéroaromatique monocyclique ou polycyclique, lequel système de cycle peut être substitué par un radical ou par plusieurs radicaux $R^1$ ;

$R^1$ est sélectionné pour chaque occurrence, de manière identique ou différente, parmi le groupe qui est constitué par H, D, F, Cl, Br, I, CN, $NO_2$, $N(Ar)_2$, $N(R^2)_2$, C(=O)Ar, $C(=O)R^2$, $P(=O)(Ar)_2$, un groupe alkyle, alcoxy ou thioalkyle en chaîne droite qui comporte de 1 à 40 atome(s) de C ou un groupe alkyle, alcoxy ou thioalkyle ramifié ou cyclique qui comporte de 3 à 40 atomes de C ou un groupe alkényle ou alkynyle qui comporte de 2 à 40 atomes de C, lequel groupe peut dans chaque cas être substitué par un radical ou par plusieurs radicaux $R^2$, où un ou plusieurs groupe(s) $CH_2$ non adjacents peut/peuvent être remplacé(s) par $R^2C=CR^2$, C≡C, $Si(R^2)_2$, C=O, C=S, $C=NR^2$, $P(=O)(R^2)$, SO, $SO_2$, $NR^2$, O, S ou $CONR^2$ et où un ou plusieurs atome(s) de H peut/peuvent être remplacé(s) par D, F, Cl, Br, I, CN ou $NO_2$, un système de cycle aromatique ou hétéroaromatique qui comporte de 5 à 60 atomes de cycle aromatique, lequel système de cycle peut dans chaque cas être substitué par un radical ou par plusieurs radicaux $R^2$, un groupe aryloxy ou hétéroaryloxy qui comporte de 5 à 60 atomes de cycle aromatique, lequel groupe peut être substitué par un radical ou par plusieurs radicaux $R^2$, ou un groupe aralkyle ou hétéroaralkyle qui comporte de 5 à 60 atomes de cycle aromatique, où deux substituants $R^1$ adjacents ou plus peuvent en option former un système de cycle aliphatique, aromatique ou hétéroaromatique monocyclique ou polycyclique, lequel système de cycle peut être substitué par un radical ou par plusieurs radicaux $R^2$ ;

Ar est pour chaque occurrence, de manière identique ou différente, un système de cycle aromatique ou hétéroaromatique qui comporte de 5 à 30 atomes de cycle aromatique, lequel système de cycle peut être substitué par un radical ou par plusieurs radicaux non aromatique(s) $R^2$ ; deux radicaux Ar qui sont liés au même atome de N ou au même atome de P peuvent également être pontés l'un à l'autre au moyen d'une liaison simple ou au moyen d'un pont qui est sélectionné parmi $N(R^2)$, $C(R^2)_2$, O ou S ;

$R^2$ est sélectionné parmi le groupe qui est constitué par H, D, F, CN, un radical hydrocarbone aliphatique qui comporte de 1 à 20 atome(s) de C, un système de cycle aromatique ou hétéroaromatique qui comporte de 5 à 30 atomes de cycle aromatique, système de cycle dans lequel un ou plusieurs atome(s) de H peut/peuvent être remplacé(s) par D, F, Cl, Br, I ou CN, où deux substituants $R^2$ adjacents ou plus peuvent former un système de cycle aliphatique, aromatique ou hétéroaromatique monocyclique ou polycyclique l'un avec l'autre ou les uns avec les autres.

**13.** Dispositif électroluminescent organique selon la revendication 12, **caractérisé en ce qu'**au moins un radical R est sélectionné, de manière identique ou différente pour chaque occurrence, parmi le groupe qui est constitué par benzène, ortho-biphényle, méta-biphényle ou para-biphényle, ortho-terphényle, méta-terphényle, para-terphényle ou terphényle ramifié, ortho-quaterphényle, méta-quaterphényle, para-quaterphényle ou quaterphényle ramifié, 1-fluorényle, 2-fluorényle, 3-fluorényle ou 4-fluorényle, 1-spirobifluorényle, 2-spirobifluorényle, 3-spirobifluorényle ou 4-spirobifluorényle, 1-naphtyle ou 2-naphtyle, pyrrole, furane, thiophène, indole, benzofurane, benzothiophène, 1-carbazole, 2-carbazole ou 3-carbazole, 1-dibenzofurane, 2-dibenzofurane ou 3-dibenzofurane, 1-dibenzothiophène, 2-dibenzothiophène ou 3-dibenzothiophène, indénocarbazole, indolocarbazole, 2-pyridine, 3-pyridine ou 4-pyridine, 2-pyrilidine, 4-pyrimidine ou 5-pyrimidine, pyrazine, pyridazine, triazine, anthracène, phénanthrène, triphénylène, pyrène, benzanthracène ou des combinaisons de deux ou trois de ces groupes, lesquels groupes peuvent dans chaque cas être substitués par un radical ou par plusieurs radicaux $R^1$, ou parmi les structures des formules (3) à (44) qui suivent :

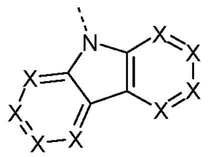
formule (3)

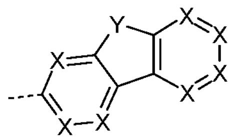
formule (4)

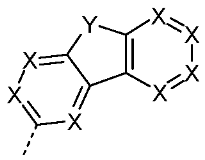
formule (5)

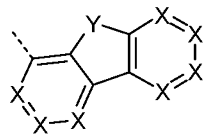
formule (6)

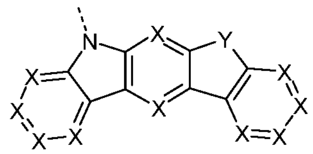
formule (7)

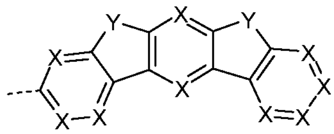
formule (8)

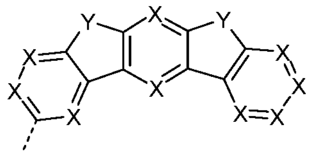
formule (9)

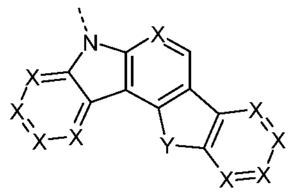
formule (10)

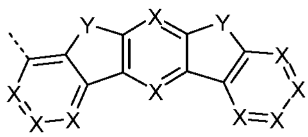
formule (11)

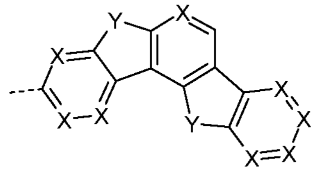
formule (12)

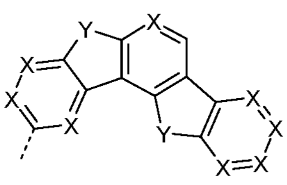
formule (13)

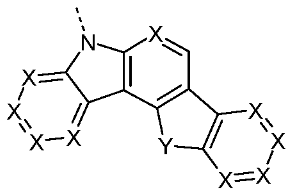
formule (14)

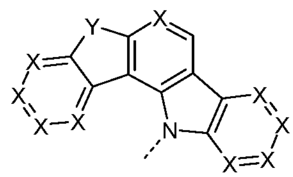
formule (15)

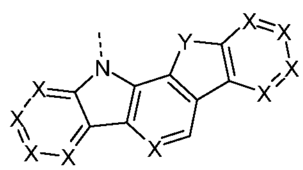
formule (16)

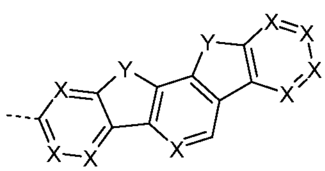
formule (17)

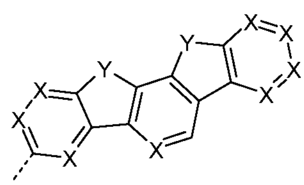
formule (18)

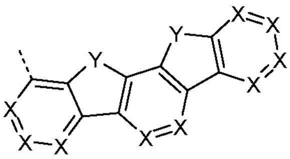

formule (19)

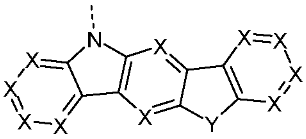

formule (20)

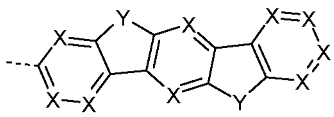

formule (21)

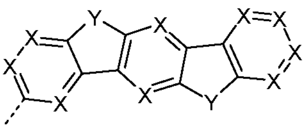

formule (22)

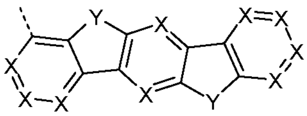

formule (23)

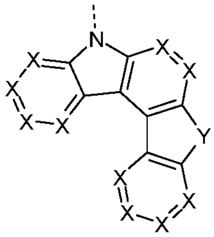

formule (24)

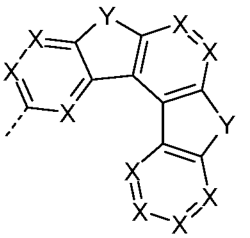

formule (25)

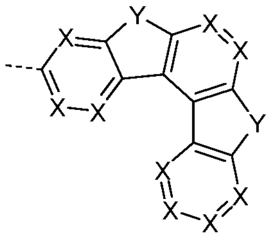

formule (26)

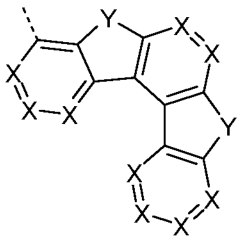

formule (27)

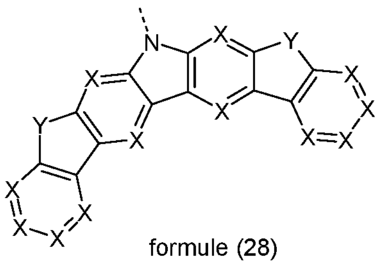

formule (28)

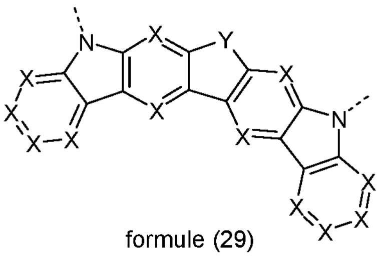

formule (29)

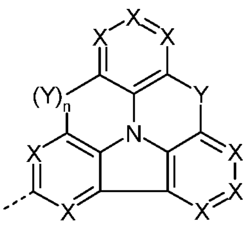

formule (30)

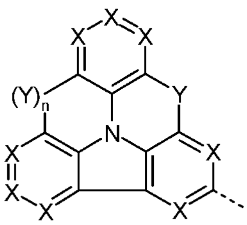

formule (31)

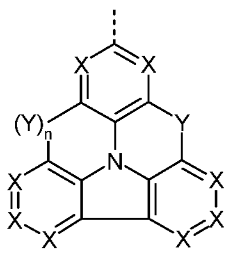

formule (32)

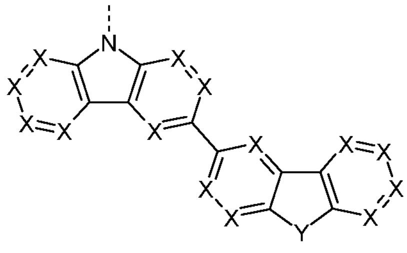
formule (33)

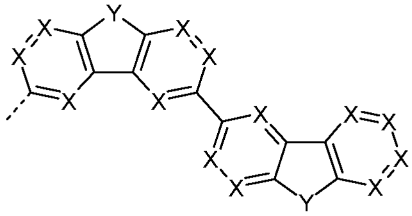
formule (34)

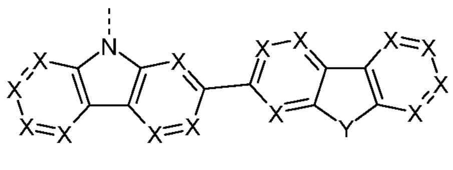
formule (35)

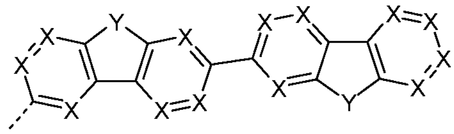
formule (36)

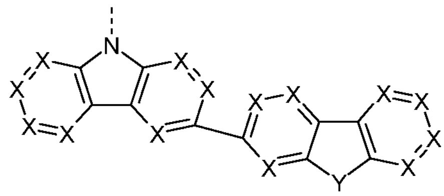
formule (37)

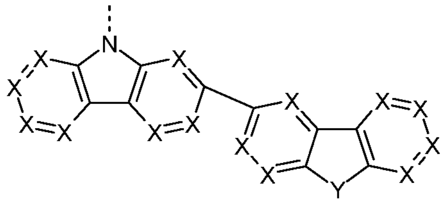
formule (38)

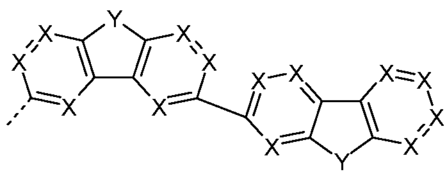
formule (39)

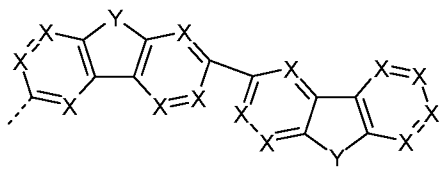
formule (40)

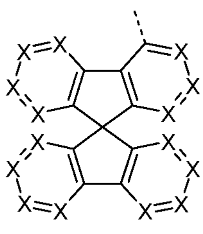
formule (41)

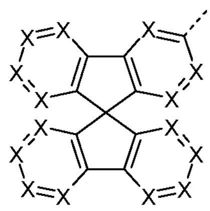
formule (42)

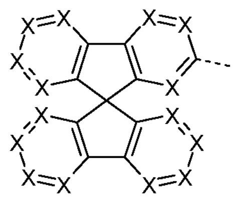
formule (43)

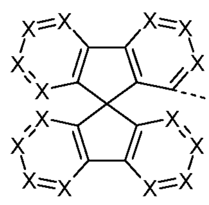
formule (44)

formules dans lesquelles $R^1$ et $R^2$ présentent les significations qui ont été données selon la revendication 12, la liaison en pointillés représente la liaison sur le groupe de la formule (1) ou (2), et en outre :

X est pour chaque occurrence, de manière identique ou différente, $CR^1$ ou N, où de préférence, un maximum de 2 symboles X par cycle représentent N ;
Y est pour chaque occurrence, de manière identique ou différente, $C(R^1)_2$, $NR^1$, O ou S ;
n est 0 ou 1, où n égal à 0 signifie qu'aucun groupe Y n'est lié au niveau de cette position et qu'en lieu et place, des radicaux $R^1$ sont liés aux atomes de carbone correspondants.

**14.** Dispositif électroluminescent organique selon la revendication 11, **caractérisé en ce que** le matériau de transport

d'électrons est sélectionné parmi les composés de la formule (45) ou (46) :

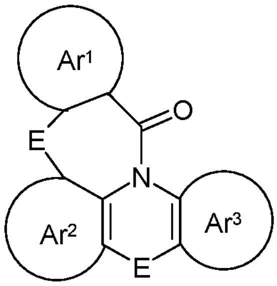

formule (45)

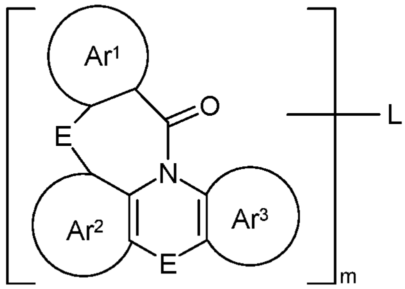

formule (46)

formules dans lesquelles R, $R^1$, $R^2$ et Ar présentent les significations qui ont été données selon la revendication 12, et ce qui suit s'applique aux autres symboles et indices qui sont utilisés :

E est, de manière identique ou différente pour chaque occurrence, une liaison simple, NR, $CR_2$, O ou S ;
$Ar^1$ est, en association avec les atomes de carbone qui sont représentés de façon explicite, un système de cycle aromatique ou hétéroaromatique qui comporte de 5 à 30 atomes de cycle aromatique, lequel système de cycle peut être substitué par un radical ou par plusieurs radicaux R ;
$Ar^2$, $Ar^3$ sont, de manière identique ou différente pour chaque occurrence, en association avec les atomes de carbone qui sont représentés de façon explicite, un système de cycle aromatique ou hétéroaromatique qui comporte de 5 à 30 atomes de cycle aromatique, lequel système de cycle peut être substitué par un radical ou par plusieurs radicaux R ;
L est, pour m = 2, une liaison simple ou un groupe divalent, ou, pour m = 3, un groupe trivalent ou, pour m = 4, un groupe tétravalent, lequel groupe est dans chaque cas lié à $Ar^1$, $Ar^2$ ou $Ar^3$ au niveau de n'importe quelle position souhaitée ou est lié à E en lieu et place d'un radical R ;
m est 2, 3 ou 4.

**15.** Dispositif électroluminescent organique selon la revendication 14, **caractérisé en ce que** le groupe $Ar^1$ représente un groupe de la formule (47), (48), (49) ou (50), soit les formules qui suivent :

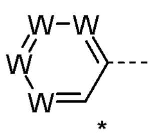

formule (47)

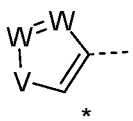

formule (48)

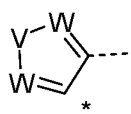

formule (49)

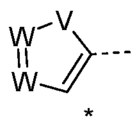

formule (50)

formules dans lesquelles la liaison en pointillés indique le lien sur le groupe carbonyle, * indique la position du lien sur E ou sur $Ar^2$, et en outre :

W est, de manière identique ou différente pour chaque occurrence, CR ou N ; ou deux groupes adjacents W représentent un groupe de la formule (51) ou (52) :

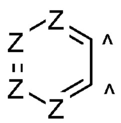

formule (51)

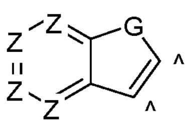

formule (52)

formules dans lesquelles G représente $CR_2$, NR, O ou S, Z représente, de manière identique ou différente pour chaque occurrence, CR ou N, et ^ indique les groupes adjacents correspondants W dans les formules (47) à (50) ;

V est NR, O ou S ;

et/ou **en ce que** le groupe $Ar^2$ représente un groupe de l'une des formules (53), (54) et (55) :

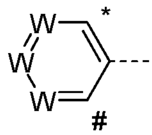

formule (53)

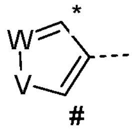

formule (54)

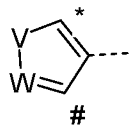

formule (55)

formules dans lesquelles la liaison en pointillés indique le lien sur N, # indique la position du lien sur E ou sur $Ar^3$, * indique le lien sur E ou sur $Ar^1$, et W et V présentent les significations qui ont été données ci-avant ;
et/ou **en ce que** le groupe $Ar^3$ représente un groupe de l'une des formules (56), (57), (58) et (59) :

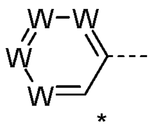

formule (56)

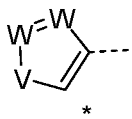

formule (57)

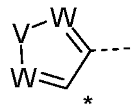

formule (58)

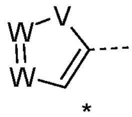

formule (59)

formules dans lesquelles la liaison en pointillés indique le lien sur N, * indique le lien sur E ou sur $Ar^2$, et W et V présentent les significations qui ont été données ci-avant.

**16.** Dispositif électroluminescent organique selon la revendication 11, **caractérisé en ce que** le matériau de transport d'électrons est sélectionné parmi les composés des formules (70) et (71) :

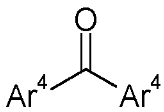

formule (70)

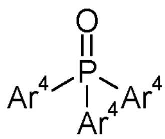

formule (71)

formules dans lesquelles R, $R^1$, $R^2$ et Ar présentent les significations qui ont été indiquées selon la revendication 12, et ce qui suit s'applique aux autres symboles qui sont utilisés :

$Ar^4$ est pour chaque occurrence, de manière identique ou différente, un système de cycle aromatique ou hétéroaromatique qui comporte de 5 à 80 atomes de cycle aromatique, de préférence jusqu'à 60 atomes de cycle aromatique, lequel système de cycle peut dans chaque cas être substitué par un ou par plusieurs groupe(s) R.

**17.** Procédé pour la production d'un dispositif électroluminescent organique selon une ou plusieurs des revendications 1 à 16, **caractérisé en ce qu'**au moins une couche est appliquée au moyen d'un procédé de sublimation et/ou **en ce qu'**au moins une couche est appliquée au moyen d'un procédé OVPD (dépôt organique en phase vapeur) ou à l'aide d'une sublimation à gaz porteur et/ou **en ce qu'**au moins une couche est appliquée à partir d'une solution, au moyen d'un dépôt/ revêtement à la tournette/par centrifugation ou au moyen d'un procédé d'impression.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- WO 2013011954 A1
- EP 2733762 A1
- WO 2013011954 A
- WO 2011070963 A
- WO 2004013080 A
- WO 2004093207 A
- WO 2006005627 A
- WO 2010006680 A
- WO 2005039246 A
- US 20050069729 A
- JP 2004288381 A
- EP 1205527 A
- WO 2008086851 A
- US 20090134784 A
- WO 2007063754 A
- WO 2008056746 A
- WO 2010136109 A
- WO 2011000455 A
- EP 1617710 A
- EP 1617711 A
- EP 1731584 A
- JP 2005347160 A
- WO 2007137725 A
- WO 2005111172 A
- WO 2006117052 A
- WO 2010054729 A
- WO 2010054730 A
- WO 2010015306 A
- EP 652273 A
- WO 2009062578 A
- US 20090136779 A
- WO 2010050778 A
- WO 2011042107 A
- WO 2011088877 A
- WO 2011116865 A
- WO 2011137951 A
- WO 2005003253 A
- EP 11010103
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A
- WO 2010072300 A


### In der Beschreibung aufgeführte Nicht-Patentliteratur


- **M. A. BALDO et al.** *Appl. Phys. Lett.,* 1999, vol. 75, 4-6
- **H. UOYAMA et al.** *Nature,* vol. 492, 234
- **H. UOYAMA et al.** *Nature,* 2012, vol. 492, 234
- **MEHES et al.** *Angew. Chem. Int. Ed.,* 2012, vol. 51, 11311
- **ENDO et al.** *Appl. Phys. Lett.,* 2011, vol. 98, 083302, , 1
- **NAKAGAWA et al.** *Chem. Commun.,* 2012, vol. 48, 9580
- *Chem. Rev.,* 2007, vol. 107, 1233
- **M. S. ARNOLD et al.** *Appl. Phys. Lett.,* 2008, vol. 92, 053301
- **H. UOYAMA et al.** *Nature,* 2012, vol. 492 (7428), 234-238
- **K. MASUI et al.** *Organic Electronics,* 2013, vol. 14 (11), 2721-2726